# EUROPÄISCHE PATENTSCHRIFT

(11) **EP 3 241 250 B1**
(45) Veröffentlichungstag und Bekanntmachung des Hinweises auf die Patenterteilung: **05.01.2022**
(21) Anmeldenummer: 15808108.3
(22) Anmeldetag: 08.12.2015
(51) Int. Cl.: H01L 51/50, H01L 51/54

(54) **ZUSAMMENSETZUNGEN UMFASSEND MINDESTENS EIN POLYMER UND MINDESTENS EIN SALZ SOWIE ELEKTROLUMINESZENZVORRICHTUNGEN ENTHALTEND DIESE ZUSAMMENSETZUNGEN**
COMPOSITIONS COMPRISING AT LEAST ONE POLYMER AND AT LEAST ONE SALT, AND ELECTROLUMINESCENT DEVICES CONTAINING SAID COMPOSITIONS
COMPOSITIONS COMPRENANT AU MOINS UN POLYMÈRE ET AU MOINS UN SEL, ET DISPOSITIFS ÉLECTROLUMINESCENTS CONTENANT CES COMPOSITIONS

(30) Priorität: 30.12.2014 EP 14004449
(43) Veröffentlichungstag der Anmeldung: 08.11.2017
(73) Patentinhaber: Merck Patent GmbH, 64293 Darmstadt (DE)
(72) Erfinder: ECKES, Fabrice, 68300 Saint Louis (FR); STEGMAIER, Katja, 64287 Darmstadt (DE); HEIL, Holger, 60389 Frankfurt am Main (DE); SEIM, Henning, 64289 Darmstadt (DE)
(86) Internationale Anmeldenummer: PCT/EP2015/002476
(87) Internationale Veröffentlichungsnummer: WO 2016/107668

(56) Entgegenhaltungen:
- EP-A1- 1 725 079
- EP-A1- 2 439 804
- WO-A1-2013/154076
- US-A1- 2009 321 723

## Beschreibung

Die vorliegende Erfindung betrifft Zusammensetzungen umfassend mindestens ein Polymer und mindestens ein Salz, Verfahren zu deren Herstellung sowie deren Verwendung in elektronischen bzw. opto-elektronischen Vorrichtungen, insbesondere in organischen Elektrolumineszenzvorrichtungen, sogenannten OLEDs (OLED = Organic Light Emitting Diodes). Darüber hinaus betrifft die vorliegende Erfindung auch organische Elektrolumineszenzvorrichtungen enthaltend diese Zusammensetzungen.

In elektronischen bzw. opto-elektronischen Vorrichtungen, insbesondere in organischen Elektrolumineszenzvorrichtungen (OLED) werden Komponenten verschiedener Funktionalität benötigt. In OLEDs liegen die verschiedenen Funktionalitäten dabei normalerweise in verschiedenen Schichten vor. Man spricht in diesem Fall von mehrschichtigen OLED-Systemen. Diese mehrschichtigen OLED-Systeme weisen dabei unter anderem ladungsinjizierende Schichten, wie z.B. elektronen- und lochinjizierende Schichten, ladungstransportierende Schichten, wie z.B. elektronen- und lochleitende Schichten, sowie Schichten auf, die lichtemittierende Komponenten enthalten. Diese mehrschichtigen OLED-Systeme werden in der Regel durch das aufeinanderfolgende schichtweise Aufbringen hergestellt.

Werden dabei mehrere Schichten aus Lösung aufgebracht, ist darauf zu achten, dass eine bereits aufgebrachte Schicht nach deren Trocknung nicht durch das nachfolgende Aufbringen der Lösung zur Herstellung der nächsten Schicht zerstört wird. Dies kann beispielsweise dadurch erreicht werden, dass eine Schicht unlöslich gemacht wird, beispielsweise durch Vernetzung. Solche Verfahren werden z.B. in der EP 0 637 899 und der WO 96/20253 offenbart.

Darüber hinaus ist es aber auch notwendig, die Funktionalitäten der einzelnen Schichten von der Materialseite her so aufeinander abzustimmen, dass möglichst gute Ergebnisse, z.B. hinsichtlich Lebensdauer, Effizienz, etc. erreicht werden. So haben insbesondere die Schichten, die direkt an eine emittierende Schicht angrenzen, insbesondere die lochtransportierende Schicht (HTL = Hole Transport Layer), einen signifikanten Einfluss auf die Eigenschaften der angrenzenden emittierenden Schicht.

In der EP 2 439 804 A1 werden Zusammensetzungen offenbart, die ein Oligomer und ein Salz aus einem lodonium Kation und einem tetrakispentafluorophenylborat Anion enthalten, wobei das Oligomer in para-Position substituierte Triphenylamingruppen aufweist.

In der EP 1 725 079 A1, der US 2009/321723 A1 und der EP 2 838 129 A1 werden Zusammensetzungen offenbart, die jeweils ein Polymer und ein Diaryliodonium Borat Salz enthalten, wobei die jeweiligen Polymere Triphenylamingruppen aufweisen.

Bekannte elektronische Vorrichtungen sowie die Verfahren zur Herstellung derselben weisen ein brauchbares Eigenschaftsprofil auf. Allerdings besteht die dauerhafte Notwendigkeit, die Eigenschaften dieser Vorrichtungen und der Verfahren zur Herstellung dieser Vorrichtungen zu verbessern.

Zu diesen Eigenschaften der Vorrichtungen gehört insbesondere die Energieeffizienz, mit der eine elektronische Vorrichtung die vorgegebene Aufgabe löst. Bei organischen Leuchtdioden sollte insbesondere die Lichtausbeute hoch sein, so dass zum Erreichen eines bestimmten Lichtflusses möglichst wenig elektrische Leistung aufgebracht werden muss. Weiterhin sollte auch zum Erzielen einer vorgegebenen Leuchtdichte eine möglichst geringe Spannung notwendig sein. Ein weiteres Problem stellt insbesondere die Lebensdauer der elektronischen Vorrichtungen dar.

Eine der Aufgaben der vorliegenden Erfindung lag deshalb in der Bereitstellung von Zusammensetzungen, die einerseits als Lösung verarbeitet werden können und die andererseits bei der Verwendung in elektronischen bzw. opto-elektronischen Vorrichtungen, vorzugsweise in OLEDs, und hier insbesondere in deren Lochinjektions- und/oder Lochtransportschicht, zu einer Verbesserung der Eigenschaften der Vorrichtung, d.h. insbesondere der OLED, führen.

Überraschenderweise wurde gefunden, dass Zusammensetzungen, welche Polymere mit Triarylamin-Wiederholungseinheiten und Salze aufweisen, insbesondere bei Verwendung zur Herstellung der lochinjizierenden und/oder lochtransportierenden Schicht von OLEDs zu einer deutlichen Absenkung der Spannung zum Erzielen einer vorgegebenen Leuchtdichte, zu einer Verringerung der zum Erreichen eines bestimmten Lichtflusses notwendigen elektrische Leistung und zu einer Erhöhung der Lebensdauer dieser OLEDs führen. Hierbei wurde überraschend festgestellt, dass die Komponenten der Zusammensetzung, d.h. die Polymere und die Salze in synergistischer Weise zusammenwirken, ohne dass andere Eigenschaften nachteilig beeinflusst werden. Besondere Vorteile können insbesondere dadurch erzielt werden, dass eine erfindungsgemäße Zusammensetzung in einer Lochinjektionsschicht eingesetzt wird.

Gegenstand der vorliegenden Anmeldung ist somit eine Zusammensetzung umfassend mindestens ein Polymer und mindestens ein Salz, wobei das Polymer mindestens eine Struktureinheit der folgenden Formel (I) aufweist: 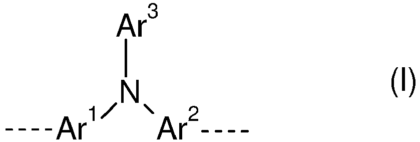 dabei ist
- Ar¹, Ar² und Ar³: bei jedem Auftreten, jeweils gleich oder verschieden, ein mono- oder polycyclisches, aromatisches oder heteroaromatisches Ringsystem ist, das mit einem oder mehreren Resten R substituiert sein kann;
- R: bei jedem Auftreten gleich oder verschieden H, D, F, Cl, Br, I, N(R¹)₂, CN, NO₂, Si(R¹)₃, B(OR¹)₂, C(=O)R¹, P(=O)(R¹)₂, S(=O)R¹, S(=O)₂R¹, OSO₂R¹, eine geradkettige Alkyl-, Alkoxy- oder Thioalkoxygruppe mit 1 bis 40 C-Atomen oder eine Alkenyl- oder Alkinylgruppe mit 2 bis 40 C-Atomen oder eine verzweigte oder cyclische Alkyl-, Alkoxy- oder Thioalkoxygruppe mit 3 bis 40 C-Atomen, die jeweils mit einem oder mehreren Resten R¹ substituiert sein kann, wobei eine oder mehrere nicht benachbarte CH₂-Gruppen durch R¹C=CR¹, C=C, Si(R¹)₂, C=O, C=S, C=NR¹, P(=O)(R¹), SO, SO₂, NR¹, O, S oder CONR¹ ersetzt sein können und wobei ein oder mehrere H-Atome durch D, F, Cl, Br, I oder CN ersetzt sein können, oder ein aromatisches oder heteroaromatisches Ringsystem mit 5 bis 60 aromatischen Ringatomen, das jeweils durch einen oder mehrere Reste R¹ substituiert sein kann, oder eine Aryloxy- oder Heteroaryloxygruppe mit 5 bis 60 aromatischen Ringatomen, die durch einen oder mehrere Reste R¹ substituiert sein kann, oder eine Aralkyl- oder Heteroaralkylgruppe mit 5 bis 60 aromatischen Ringatomen, die durch einen oder mehrere Reste R¹ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R¹ substituiert sein kann; ist; wobei zwei oder mehrere Reste R auch miteinander ein mono- oder polycyclisches, aliphatisches, aromatisches und/oder benzoannelliertes Ringsystem bilden können;
- R¹: bei jedem Auftreten gleich oder verschieden H, D, F oder ein aliphatischer Kohlenwasserstoffrest mit 1 bis 20 C-Atomen, ein aromatischer und/oder ein heteroaromatischer Kohlenwasserstoffrest mit 5 bis 20 C-Atomen ist, in dem auch ein oder mehrere H-Atome durch F ersetzt sein können; wobei zwei oder mehrere Substituenten R¹ auch miteinander ein mono- oder polycyclisches, aliphatisches oder aromatisches Ringsystem bilden können; und

die gestrichelten Linien Bindungen zu benachbarten Struktureinheiten im Polymer darstellen;
dadurch gekennzeichnet, dass die Struktureinheit der Formel (I) die Struktur der Formel (la) aufweist: 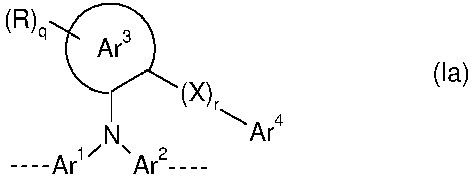
wobei Ar¹, Ar², Ar³ und R die oben in Bezug auf Formel (I) angegebenen Bedeutungen annehmen können,
wobei Ar⁴ ein mono- oder polycyclisches, aromatisches oder heteroaromatisches Ringsystem mit 5 bis 60 aromatischen Ringatomen ist, das mit einem oder mehreren Resten R substituiert sein kann, wobei R die oben in Bezug auf für Formel (I) angegebene Bedeutung annehmen kann q = 0, 1, 2, 3, 4, 5 oder 6, vorzugsweise 0, 1, 2, 3 oder 4, ist,
X = CR₂, NR, SiR₂, O, S, C=O oder P=O, vorzugsweise CR₂, NR, O oder S, ist, und
r = 0 oder 1, vorzugsweise 0, ist.
das Salz mindestens ein Kation der folgenden Formeln (K1), (K2) und/oder (K3) umfasst: 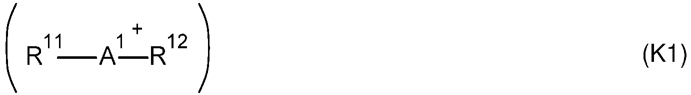 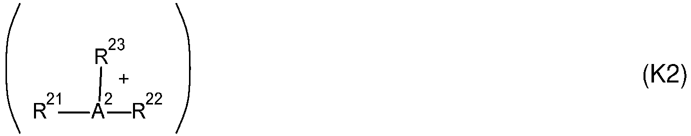 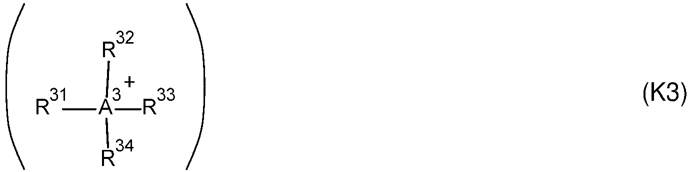 dabei bedeuten
   der Rest A¹, ein Element der 15 Gruppe des Periodensystems der Elemente; der Rest A², ein Element der 16 Gruppe des Periodensystems der Elemente; und A³, ein Element der 17 Gruppe des Periodensystems der Elemente;
   und die Reste R¹¹, R²¹, R³¹ einen beliebigen Rest, vorzugsweise eine Kohlenstoffatom-haltige Gruppe, die über ein Kohlenstoffatom jeweils an den Rest A¹, A² oder A³ bindet;
   die Reste R¹², R²², R²³, R³², R³³ und R³⁴ jeweils eine Kohlenstoffatom-haltige Gruppe, die über ein Kohlenstoffatom jeweils an den Rest A¹, A² oder A³ bindet, wobei ein oder mehrere der Reste R¹¹ bis R³⁴ auch miteinander ein mono- oder polycyclisches, aliphatisches, heteroaliphatisches, heteroaromatisches oder aromatisches Ringsystem bilden können;
   und mindestens ein Anion der folgenden Formel (A1) 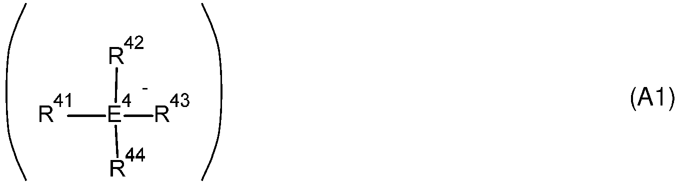 wobei der Rest E⁴ ein Element der 13 Gruppe des Periodensystems der Elemente darstellt;
   und die Reste R⁴¹, R⁴², R⁴³ und R⁴⁴ jeweils ein aromatisches oder heteroaromatisches Ringsystem mit 5 bis 60 aromatischen Ringatomen, das jeweils durch einen oder mehrere Reste R substituiert sein kann, wobei ein oder mehrere der Reste R⁴¹, R⁴², R⁴³ und R⁴⁴ auch miteinander ein mono- oder polycyclisches, aliphatisches, heteroaliphatisches, heteroaromatisches oder aromatisches Ringsystem bilden können.

Erfindungsgemäß ist der Rest Ar³ gemäß Formel (I) in mindestens einer, vorzugsweise in genau einer der beiden ortho-Positionen, bezogen auf die Position des in Formel (I) dargestellten Stickstoffatoms, mit Ar⁴ substituiert ist, wobei Ar⁴ ein mono- oder polycyclisches, aromatisches oder heteroaromatisches Ringsystem mit 5 bis 60 aromatischen Ringatomen ist, das mit einem oder mehreren Resten R substituiert sein kann, wobei R die zuvor für Formel (I) dargelegte Bedeutung annehmen kann.

Ar⁴ kann dabei entweder direkt, das heißt über eine Einfachbindung, mit Ar³ verknüpft sein oder aber über eine Verknüpfungsgruppe X.

In der vorliegenden Anmeldung sind unter dem Begriff Polymer sowohl polymere Verbindungen, oligomere Verbindungen sowie Dendrimere zu verstehen. Die erfindungsgemäßen polymeren Verbindungen weisen vorzugsweise 10 bis 10000, besonders bevorzugt 10 bis 5000 und ganz besonders bevorzugt 10 bis 2000 Struktureinheiten (d.h. Wiederholungseinheiten) auf. Die erfindungsgemäßen oligomeren Verbindungen weisen vorzugsweise 3 bis 9 Struktureinheiten auf. Der Verzweigungs-Faktor der Polymere liegt dabei zwischen 0 (lineares Polymer, ohne Verzweigungsstellen) und 1 (vollständig verzweigtes Dendrimer).

Die erfindungsgemäß einsetzbaren Polymere weisen vorzugsweise ein Molekulargewicht M_{w} im Bereich von 1.000 bis 2.000.000 g/mol, besonders bevorzugt ein Molekulargewicht M_{w} im Bereich von 10.000 bis 1.500.000 g/mol und ganz besonders bevorzugt ein Molekulargewicht M_{w} im Bereich von 50.000 bis 1.000.000 g/mol auf. Die Bestimmung des Molekulargewichts M_{w} erfolgt mittels GPC (= Gelpermeationschromatographie) gegen einen internen Polystyrolstandard.

Bei den erfindungsgemäßen Polymeren handelt es sich entweder um konjugierte, teilkonjugierte oder nicht-konjugierte Polymere. Bevorzugt sind konjugierte oder teilkonjugierte Polymere.

Die Struktureinheiten der Formel (la) können erfindungsgemäß in die Haupt- oder in die Seitenkette des Polymeren eingebaut werden. Vorzugsweise werden die Struktureinheiten der Formel (la) jedoch in die Hauptkette des Polymers eingebaut. Bei Einbau in die Seitenkette des Polymeren können die Struktureinheiten der Formel (la) entweder mono- oder bivalent sein, d.h. sie weisen entweder eine oder zwei Bindungen zu benachbarten Struktureinheiten im Polymer auf.

"Konjugierte Polymere" im Sinne der vorliegenden Anmeldung sind Polymere, die in der Hauptkette hauptsächlich sp²-hybridisierte (bzw. gegebenenfalls auch sp-hybridisierte) Kohlenstoffatome enthalten, die auch durch entsprechend hybridisierte Heteroatome ersetzt sein können. Dies bedeutet im einfachsten Fall abwechselndes Vorliegen von Doppel- und Einfachbindungen in der Hauptkette, aber auch Polymere mit Einheiten wie beispielsweise einem meta-verknüpften Phenylen sollen im Sinne dieser Anmeldung als konjugierte Polymere gelten. "Hauptsächlich" meint, dass natürlich (unwillkürlich) auftretende Defekte, die zu Konjugationsunterbrechungen führen, den Begriff "konjugiertes Polymer" nicht entwerten. Als konjugierte Polymere gelten ebenfalls Polymere mit einer konjugierten Hauptkette und nicht-konjugierten Seitenketten. Des Weiteren wird in der vorliegenden Anmeldung ebenfalls als konjugiert bezeichnet, wenn sich in der Hauptkette beispielsweise Arylamineinheiten, Arylphosphineinheiten, bestimmte Heterocyclen (d.h. Konjugation über N-, O- oder S-Atome) und/oder metallorganische Komplexe (d.h. Konjugation über das Metallatom) befinden. Analoges gilt für konjugierte Dendrimere. Hingegen werden Einheiten wie beispielsweise einfache Alkylbrücken, (Thio)Ether-, Ester-, Amid- oder Imidverknüpfungen eindeutig als nicht-konjugierte Segmente definiert.

Unter einem teilkonjugierten Polymer soll in der vorliegenden Anmeldung ein Polymer verstanden werden, das konjugierte Regionen enthält, die durch nicht-konjugierte Abschnitte, gezielte Konjugationsunterbrecher (z.B. Abstandsgruppen) oder Verzweigungen voneinander getrennt sind, z.B. in dem längere konjugierte Abschnitte in der Hauptkette durch nicht-konjugierte Abschnitte unterbrochen sind, bzw. das längere konjugierte Abschnitte in den Seitenketten eines in der Hauptkette nicht-konjugierten Polymers enthält. Konjugierte und teilkonjugierte Polymere können auch konjugierte, teilkonjugierte oder nicht-konjugierte Dendrimere enthalten.

Unter dem Begriff "Dendrimer" soll in der vorliegenden Anmeldung eine hochverzweigte Verbindung verstanden werden, die aus einem multifunktionellen Zentrum (core) aufgebaut ist, an das in einem regelmäßigen Aufbau verzweigte Monomere gebunden werden, so dass eine baumartige Struktur erhalten wird. Dabei können sowohl das Zentrum als auch die Monomere beliebige verzweigte Strukturen annehmen, die sowohl aus rein organischen Einheiten als auch Organometallverbindungen oder Koordinationsverbindungen bestehen. "Dendrimer" soll hier allgemein so verstanden werden, wie dies z.B. von M. Fischer und F. Vögtle (Angew. Chem., Int. Ed. 1999, 38, 885) beschrieben ist.

Unter dem Begriff "Struktureinheit" wird in der vorliegenden Anmeldung eine Einheit verstanden, die, ausgehend von einer Monomereinheit, die mindestens zwei, vorzugsweise zwei, reaktive Gruppen aufweist, durch Reaktion unter Verbindungsknüpfung als ein Teil des Polymergrundgerüstes in dieses eingebaut wird, und damit verknüpft im hergestellten Polymer als Wiederholungseinheit vorliegt.

Unter dem Begriff "mono- oder polycyclisches, aromatisches Ringsystem" wird in der vorliegenden Anmeldung ein aromatisches Ringsystem mit 6 bis 60, vorzugsweise 6 bis 30 und besonders bevorzugt 6 bis 24 aromatischen Ringatomen verstanden, das nicht notwendigerweise nur aromatische Gruppen enthält, sondern in dem auch mehrere aromatische Einheiten durch eine kurze nicht-aromatische Einheit (< 10 % der von H verschiedenen Atome, vorzugsweise < 5 % der von H verschiedenen Atome), wie beispielsweise ein sp³-hybridisiertes C-Atom bzw. O- oder N-Atom, eine CO-Gruppe etc., unterbrochen sein können. So sollen beispielsweise auch Systeme wie z.B. 9,9'-Spirobifluoren, 9,9-Diarylfluoren und 9,9-Dialkylfluoren, als aromatische Ringsysteme verstanden werden. Die aromatischen Ringsysteme können mono- oder polycyclisch sein, d.h. sie können einen Ring (z.B. Phenyl) oder mehrere Ringe aufweisen, welche auch kondensiert (z.B. Naphthyl) oder kovalent verknüpft sein können (z.B. Biphenyl), oder eine Kombination von kondensierten und verknüpften Ringen enthalten.

Bevorzugte aromatische Ringsysteme sind z.B. Phenyl, Biphenyl, Terphenyl, [1,1':3',1"]Terphenyl-2'-yl, Quarterphenyl, Naphthyl, Anthracen, Binaphthyl, Phenanthren, Dihydrophenanthren, Pyren, Dihydropyren, Chrysen, Perylen, Tetracen, Pentacen, Benzpyren, Fluoren, Inden, Indenofluoren und Spirobifluoren.

Unter dem Begriff "mono- oder polycyclisches, heteroaromatisches Ringsystem" wird in der vorliegenden Anmeldung ein aromatisches Ringsystem mit 5 bis 60, vorzugsweise 5 bis 30 und besonders bevorzugt 5 bis 24 aromatischen Ringatomen verstanden, wobei ein oder mehrere dieser Atome ein Heteroatom ist/sind. Das "mono- oder polycyclische, heteroaromatische Ringsystem" enthält nicht notwendigerweise nur aromatische Gruppen, sondern kann auch durch eine kurze nicht-aromatische Einheit (< 10 % der von H verschiedenen Atome, vorzugsweise < 5 % der von H verschiedenen Atome), wie beispielsweise ein sp³-hybridisiertes C-Atom bzw. O- oder N-Atom, eine CO-Gruppe etc., unterbrochen sein.

Die heteroaromatischen Ringsysteme können mono- oder polycyclisch sein, d.h. sie können einen Ring oder mehrere Ringe aufweisen, welche auch kondensiert oder kovalent verknüpft sein können (z.B. Pyridylphenyl), oder eine Kombination von kondensierten und verknüpften Ringen enthalten. Bevorzugt sind vollständig konjugierte Heteroarylgruppen.

Bevorzugte heteroaromatische Ringsysteme sind z.B. 5-gliedrige Ringe wie Pyrrol, Pyrazol, Imidazol, 1,2,3-Triazol, 1,2,4-Triazol, Tetrazol, Furan, Thiophen, Selenophen, Oxazol, Isoxazol, 1,2-Thiazol, 1,3-Thiazol, 1,2,3-Oxadiazol, 1,2,4-Oxadiazol, 1,2,5-Oxadiazol, 1,3,4-Oxadiazol, 1,2,3-Thiadiazol, 1,2,4-Thiadiazol, 1,2,5-Thiadiazol, 1,3,4-Thiadiazol, 6-gliedrige Ringe wie Pyridin, Pyridazin, Pyrimidin, Pyrazin, 1,3,5-Triazin, 1,2,4-Triazin, 1,2,3-Triazin, 1,2,4,5-Tetrazin, 1,2,3,4-Tetrazin, 1,2,3,5-Tetrazin, oder Gruppen mit mehreren Ringen, wie Carbazol, Indenocarbazol, Indol, Isoindol, Indolizin, Indazol, Benzimidazol, Benzotriazol, Purin, Naphthimidazol, Phenanthrimidazol, Pyridimidazol, Pyrazinimidazol, Chinoxalinimidazol, Benzoxazol, Naphthoxazol, Anthroxazol, Phenanthroxazol, Isoxazol, Benzothiazol, Benzofuran, Isobenzofuran, Dibenzofuran, Chinolin, Isochinolin, Pteridin, Benzo-5,6-chinolin, Benzo-6,7-chinolin, Benzo-7,8-chinolin, Benzoisochinolin, Acridin, Phenothiazin, Phenoxazin, Benzopyridazin, Benzopyrimidin, Chinoxalin, Phenazin, Naphthyridin, Azacarbazol, Benzocarbolin, Phenanthridin, Phenanthrolin, Thieno[2,3b]thiophen, Thieno[3,2b]thiophen, Dithienothiophen, Isobenzothiophen, Dibenzothiophen, Benzothiadiazothiophen oder Kombinationen dieser Gruppen.

Das mono- oder polycyclische, aromatische oder heteroaromatische Ringsystem kann unsubstituiert oder substituiert sein. Substituiert heißt in der vorliegenden Anmeldung, dass das mono- oder polycyclische, aromatische oder heteroaromatische Ringsystem einen oder mehrere Substituenten R aufweist.

R ist bei jedem Auftreten vorzugsweise gleich oder verschieden H, D, F, Cl, Br, I, N(R¹)₂, CN, NO₂, Si(R¹)₃, B(OR¹)₂, C(=O)R¹, P(=O)(R¹)₂, S(=O)R¹, S(=O)₂R¹, OSO₂R¹, eine geradkettige Alkyl-, Alkoxy- oder Thioalkoxygruppe mit 1 bis 40 C-Atomen oder eine Alkenyl- oder Alkinylgruppe mit 2 bis 40 C-Atomen oder eine verzweigte oder cyclische Alkyl-, Alkoxy- oder Thioalkoxygruppe mit 3 bis 40 C-Atomen, die jeweils mit einem oder mehreren Resten R¹ substituiert sein kann, wobei eine oder mehrere nicht benachbarte CH₂-Gruppen durch R¹C=CR¹, C=C, Si(R¹)₂, C=O, C=S, C=NR¹, P(=O)(R¹), SO, SO₂, NR¹, O, S oder CONR¹ ersetzt sein können und wobei ein oder mehrere H-Atome durch D, F, Cl, Br, I oder CN ersetzt sein können, oder ein aromatisches oder heteroaromatisches Ringsystem mit 5 bis 60 aromatischen Ringatomen, das jeweils durch einen oder mehrere Reste R¹ substituiert sein kann, oder eine Aryloxy- oder Heteroaryloxygruppe mit 5 bis 60 aromatischen Ringatomen, die durch einen oder mehrere Reste R¹ substituiert sein kann, oder eine Aralkyl- oder Heteroaralkylgruppe mit 5 bis 60 aromatischen Ringatomen, die durch einen oder mehrere Reste R¹ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R¹ substituiert sein kann; dabei können zwei oder mehrere Reste R auch miteinander ein mono- oder polycyclisches, aliphatisches, aromatisches und/oder benzoannelliertes Ringsystem bilden.

R ist bei jedem Auftreten besonders bevorzugt gleich oder verschieden H, D, F, Cl, Br, I, N(R¹)₂, Si(R¹)₃, B(OR¹)₂, C(=O)R¹, P(=O)(R¹)2, eine geradkettige Alkyl- oder Alkoxygruppe mit 1 bis 20 C-Atomen oder eine Alkenyl- oder Alkinylgruppe mit 2 bis 20 C-Atomen oder eine verzweigte oder cyclische Alkyl- oder Alkoxygruppe mit 3 bis 20 C-Atomen, die jeweils mit einem oder mehreren Resten R¹ substituiert sein kann, wobei eine oder mehrere nicht benachbarte CH₂-Gruppen durch R¹C=CR¹, C=C, Si(R¹)₂, C=O, C=NR¹, P(=O)(R¹), NR¹, O oder CONR¹ ersetzt sein können und wobei ein oder mehrere H-Atome durch F, Cl, Br oder I ersetzt sein können, oder ein aromatisches oder heteroaromatisches Ringsystem mit 5 bis 30 aromatischen Ringatomen, das jeweils durch einen oder mehrere Reste R¹ substituiert sein kann, oder eine Aryloxy- oder Heteroaryloxygruppe mit 5 bis 30 aromatischen Ringatomen, die durch einen oder mehrere Reste R¹ substituiert sein kann, oder eine Aralkyl- oder Heteroaralkylgruppe mit 5 bis 30 aromatischen Ringatomen, die durch einen oder mehrere Reste R¹ substituiert sein kann, oder eine Diarylaminogruppe, Diheteroarylaminogruppe oder Arylheteroarylaminogruppe mit 10 bis 20 aromatischen Ringatomen, welche durch einen oder mehrere Reste R¹ substituiert sein kann; dabei können zwei oder mehrere Reste R auch miteinander ein mono- oder polycyclisches, aliphatisches, aromatisches und/oder benzoannelliertes Ringsystem bilden.

R ist bei jedem Auftreten ganz besonders bevorzugt gleich oder verschieden H, eine geradkettige Alkyl- oder Alkoxygruppe mit 1 bis 10 C-Atomen oder eine Alkenyl- oder Alkinylgruppe mit 2 bis 10 C-Atomen oder eine verzweigte oder cyclische Alkyl- oder Alkoxygruppe mit 3 bis 10 C-Atomen, die jeweils mit einem oder mehreren Resten R¹ substituiert sein kann, wobei eine oder mehrere nicht benachbarte CH₂-Gruppen durch R¹C=CR¹, C=C, C=O, C=NR¹, NR¹, O oder CONR¹ ersetzt sein können, oder ein aromatisches oder heteroaromatisches Ringsystem mit 5 bis 20 aromatischen Ringatomen, das jeweils durch einen oder mehrere Reste R¹ substituiert sein kann, oder eine Aryloxy- oder Heteroaryloxygruppe mit 5 bis 20 aromatischen Ringatomen, die durch einen oder mehrere Reste R¹ substituiert sein kann, oder eine Aralkyl- oder Heteroaralkylgruppe mit 5 bis 20 aromatischen Ringatomen, die durch einen oder mehrere Reste R¹ substituiert sein kann, oder eine Diarylaminogruppe, Diheteroarylaminogruppe oder Arylheteroarylaminogruppe mit 10 bis 20 aromatischen Ringatomen, welche durch einen oder mehrere Reste R¹ substituiert sein kann; dabei können zwei oder mehrere Reste R auch miteinander ein mono- oder polycyclisches, aliphatisches, aromatisches und/oder benzoannelliertes Ringsystem bilden.

Bevorzugte Alkylgruppen mit 1 bis 10 C-Atomen sind in der folgenden Tabelle abgebildet:

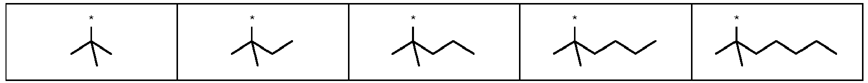

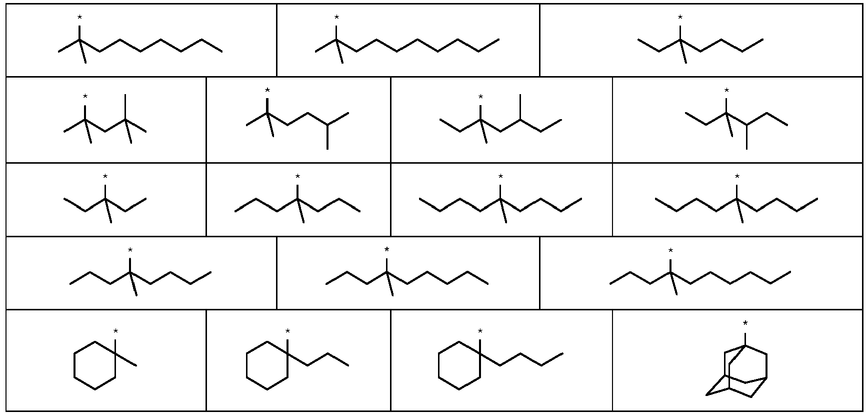

R¹ ist bei jedem Auftreten vorzugsweise gleich oder verschieden H, D, F oder ein aliphatischer Kohlenwasserstoffrest mit 1 bis 20 C-Atomen, ein aromatischer und/oder ein heteroaromatischer Kohlenwasserstoffrest mit 5 bis 20 C-Atomen, in dem auch ein oder mehrere H-Atome durch F ersetzt sein können; dabei können zwei oder mehrere Substituenten R¹ auch miteinander ein mono- oder polycyclisches, aliphatisches oder aromatisches Ringsystem bilden.

R¹ ist bei jedem Auftreten besonders bevorzugt gleich oder verschieden H, D oder ein aliphatischer Kohlenwasserstoffrest mit 1 bis 20 C-Atomen, ein aromatischer und/oder ein heteroaromatischer Kohlenwasserstoffrest mit 5 bis 20 C-Atomen; dabei können zwei oder mehrere Substituenten R¹ auch miteinander ein mono- oder polycyclisches, aliphatisches oder aromatisches Ringsystem bilden.

R¹ ist bei jedem Auftreten ganz besonders bevorzugt gleich oder verschieden H oder ein aliphatischer Kohlenwasserstoffrest mit 1 bis 10 C-Atomen, ein aromatischer und/oder ein heteroaromatischer Kohlenwasserstoffrest mit 5 bis 10 C-Atomen.

In einer weiteren Ausführungsform der vorliegenden Erfindung ist die mindestens eine Struktureinheit der Formel (la) des erfindungsgemäßen Polymeren dadurch gekennzeichnet, dass Ar³ in einer der beiden ortho-Positionen mit Ar⁴ substituiert ist, und Ar³ mit Ar⁴ zusätzlich noch in der zur substituierten ortho-Position benachbarten meta-Position verknüpft ist.

Ferner kann vorgesehen sein, dass die Summe der Ringatome des Rests Ar⁴ zusammen mit den Ringatomen der an diesen Rest gebundenen Gruppe Ar³ gemäß Formeln (la) und/oder (Ib) mindestens 10, vorzugsweise mindestens 12, beträgt. Vorzugsweise bildet der Rest Ar⁴ zusammen mit den Ringatomen der an diesen Rest gebundenen Gruppe Ar³ gemäß Formeln (la) und/oder (Ib) kein kondensiertes Ringsystem. Weiterhin sind als Rest Ar⁴ Gruppen bevorzugt, die einen geringen Kondensationsgrad aufweisen, so dass monocyclische, aromatische oder heteroaromatische Ringsysteme bevorzugt sind oder polycyclische, aromatische oder heteroaromatische Ringsysteme, deren aromatische oder heteroaromatische Ringe über Gruppen verbunden sind, die eine Konjugation der Ringe minimieren oder aufheben.

Die Struktureinheit der Formel (la) kann somit vorzugsweise die Struktur der folgenden Formel (Ib) aufweisen: 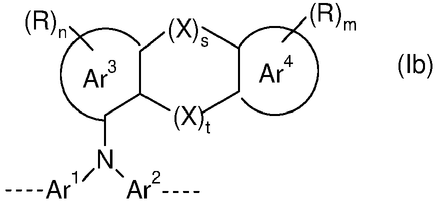
wobei Ar¹, Ar², Ar³, Ar⁴ und R die oben angegebenen Bedeutungen annehmen können,
m = 0, 1, 2, 3 oder 4 ist,
n = 0, 1, 2 oder 3 ist,
X = CR₂, NR, SiR₂, O, S, C=O oder P=O, vorzugsweise CR₂, NR, O oder S, ist, und
s und t jeweils 0 oder 1 sind, wobei die Summe (s + t) = 1 oder 2, vorzugsweise 1 ist.

In einer bevorzugten Ausführungsform ist die mindestens eine Struktureinheit der Formel (la) ausgewählt aus den Struktureinheiten der folgenden Formeln (II), (III) und (IV): 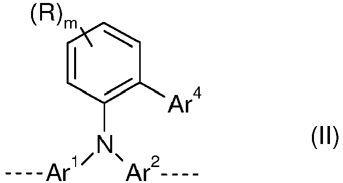 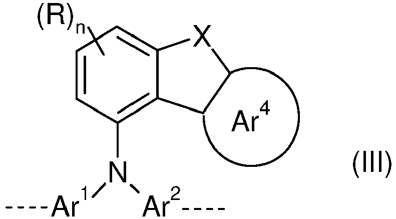 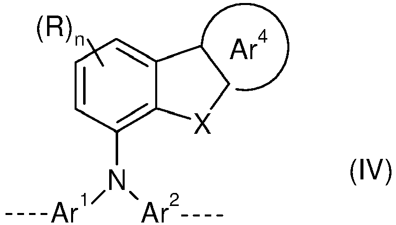
wobei Ar¹, Ar², Ar⁴ und R die oben angegebenen Bedeutungen annehmen können,
m = 0, 1, 2, 3 oder 4 ist,
n = 0, 1, 2 oder 3 ist, und
X = CR₂, NR, SiR₂, O, S, C=O oder P=O, vorzugsweise CR₂, NR, O oder S, ist.

In einer besonders bevorzugten Ausführungsform ist die mindestens eine Struktureinheit der Formel (II) ausgewählt aus der Struktureinheit der folgenden Formel (V): 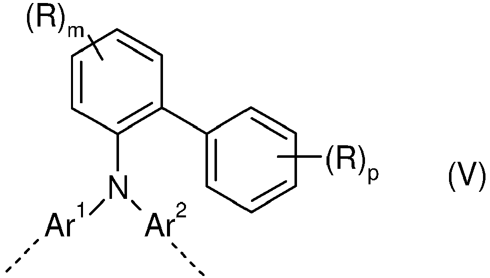 wobei Ar¹, Ar², R, m und die gestrichelten Linien die oben für Formeln (I) und/oder (Ib) angegebenen Bedeutungen annehmen können, und p = 0, 1, 2, 3, 4 oder 5 ist.

Beispiele für bevorzugte Struktureinheiten der Formel (V) sind in der folgenden Tabelle abgebildet:

| | | |
|---|---|---|
| 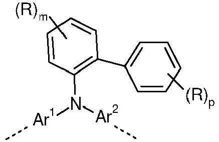 | 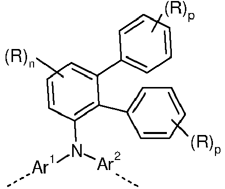 | 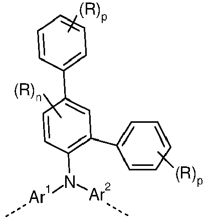 |
| (Va) | (Vb) | (Vc) |
| 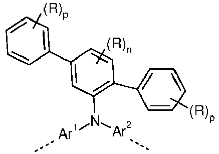 | 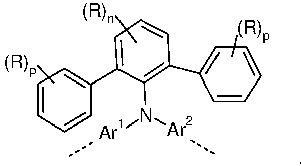 | 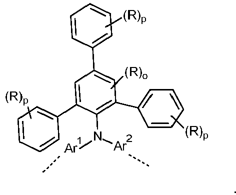 |
| (Vd) | (Ve) | (Vf) |
| 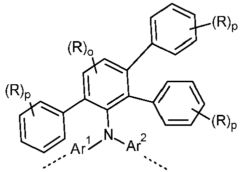 | 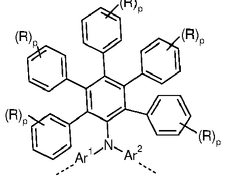 | |
| (Vg) | (Vh) | |

wobei Ar¹, Ar², R, m, n, p und die gestrichelten Linien die oben für Formeln (I), (Ib) und/oder (V) angegebenen Bedeutungen annehmen können, und o = 0, 1 oder 2 ist.

In einer weiteren besonders bevorzugten Ausführungsform ist die mindestens eine Struktureinheit der Formel (III) ausgewählt aus der Struktureinheit der folgenden Formel (VI): 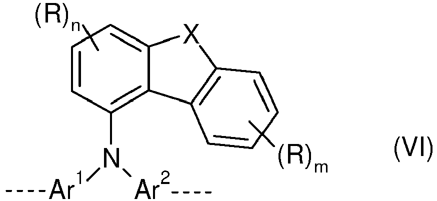 wobei Ar¹, Ar², R, X, m, n und die gestrichelten Linien die oben für Formeln (I) und/oder (Ib) angegebenen Bedeutungen annehmen können.

Beispiele für bevorzugte Struktureinheiten der Formel (VI) sind in der folgenden Tabelle abgebildet:

| | | |
|---|---|---|
| 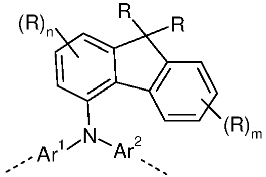 | 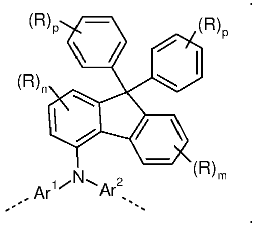 | 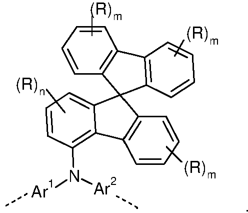 |
| (VIa) | (VIb) | (Vlc) |
| 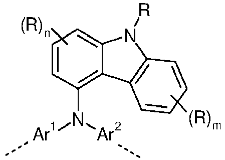 | 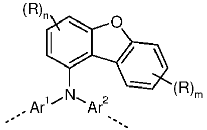 | 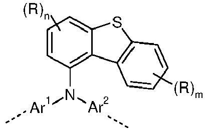 |
| (VId) | (VIe) | (VIf) |

wobei Ar¹, Ar², R, X, m, n und p die oben für Formeln (I), (Ib) und/oder (V) angegebenen Bedeutungen annehmen können.

In noch einer weiteren besonders bevorzugten Ausführungsform ist die mindestens eine Struktureinheit der Formel (IV) ausgewählt aus der Struktureinheit der folgenden Formel (VII): 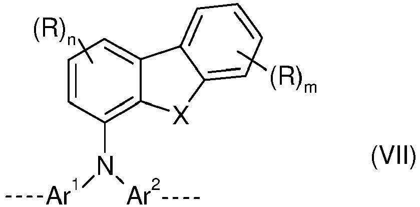 wobei Ar¹, Ar², R, m, n und die gestrichelten Linien die oben für Formeln (I) und/oder (Ib) angegebenen Bedeutungen annehmen können.

Beispiele für bevorzugte Struktureinheiten der Formel (VII) sind in der folgenden Tabelle abgebildet:

| | | |
|---|---|---|
| 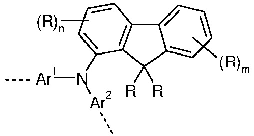 | 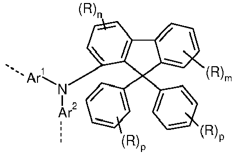 | 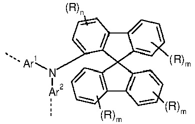 |
| (VIIa) | (VIIb) | (VIIc) |
| 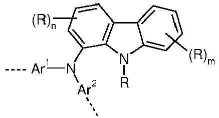 | 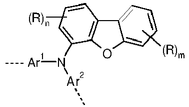 | 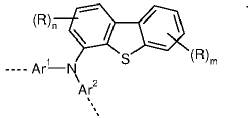 |
| (VIId) | (Vlle) | (Vllf) |

wobei Ar¹, Ar², R, m, n, p und die gestrichelten Linien die oben für Formeln (I), (Ib) und/oder (V) angegebenen Bedeutungen annehmen können.

In einer ganz besonders bevorzugten Ausführungsform ist die mindestens eine Struktureinheit der Formel (V) ausgewählt aus der Struktureinheit der folgenden Formel (Vj): 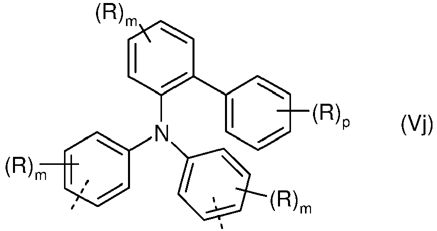 wobei R, m, p und die gestrichelten Linien die oben für Formel (V) angegebenen Bedeutungen annehmen können.

Beispiele für bevorzugte Struktureinheiten der Formel (Vg) sind in der folgenden Tabelle abgebildet:

| | |
|---|---|
| 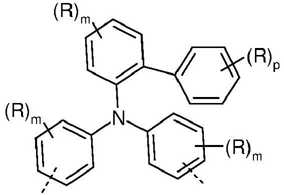 | 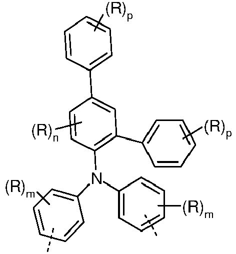 |
| (Vj-1) | (Vj-2) |
| 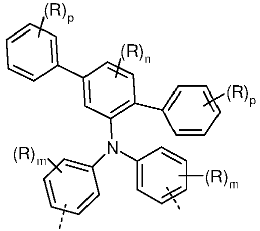 | 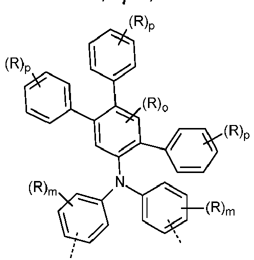 |
| (Vj-3) | (Vj-4) |
| 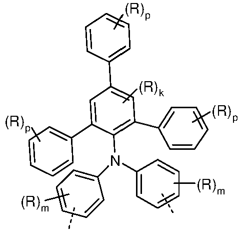 | 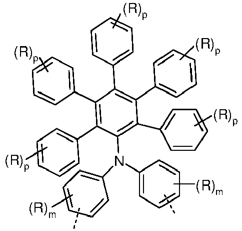 |
| (Vj-5) | (Vj-6) |
| 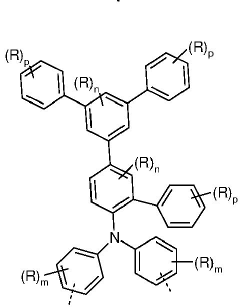 | 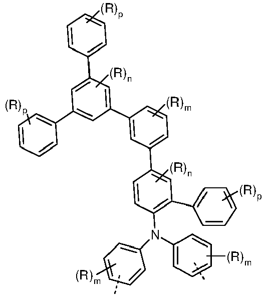 |
| (Vj-7) | (Vj-8) |

wobei R, m, n, p und die gestrichelten Linien die für Formel (V) angegebenen Bedeutungen annehmen können und o 0, 1 oder 2 ist.

In einer weiteren ganz besonders bevorzugten Ausführungsform ist die mindestens eine Struktureinheit der Formel (VI) ausgewählt aus der Struktureinheit der folgenden Formel (VIg): 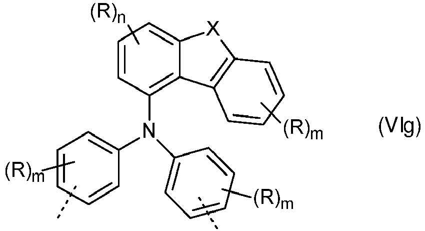 wobei R, X, m, n und die gestrichelten Linien die oben für Formel (VI) angegebenen Bedeutungen annehmen können.

Beispiele für bevorzugte Struktureinheiten der Formel (VIg) sind in der folgenden Tabelle abgebildet:

| | | |
|---|---|---|
| 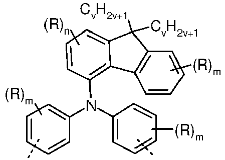 | 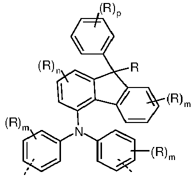 | |
| (VIg-1) | (VIg-2) | |
| 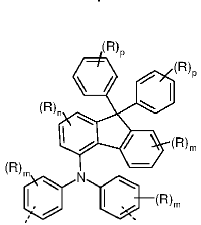 | 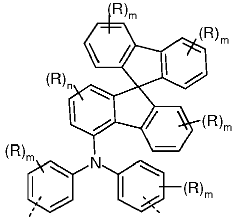 | |
| (VIg-3) | (VIg-4) | |
| 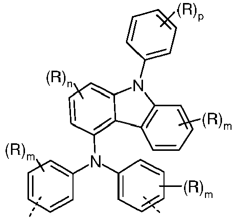 | 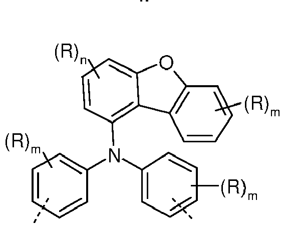 | 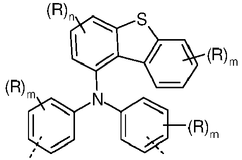 |
| (VIg-5) | (VIg-6) | (VIg-7) |

wobei R, m, n, p und die gestrichelten Linien die oben für Formeln (V) und/oder (VI) angegebenen Bedeutungen annehmen können, und
v = 1 bis 20, vorzugsweise 1 bis 10, ist.

In noch einer weiteren ganz besonders bevorzugten Ausführungsform ist die mindestens eine Struktureinheit der Formel (VII) ausgewählt aus der Struktureinheit der folgenden Formel (VIIg): 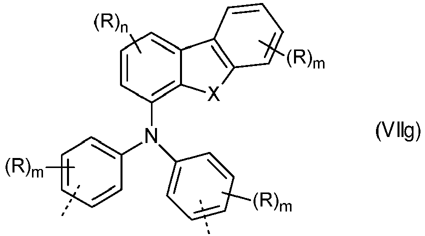 wobei R, X, m, n und die gestrichelten Linien die oben für Formel (VII) angegebenen Bedeutungen annehmen können.

Beispiele für bevorzugte Struktureinheiten der Formel (VIIg) sind in der folgenden Tabelle abgebildet:

| | | |
|---|---|---|
| 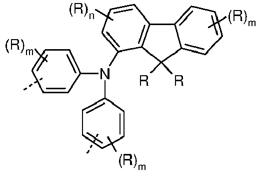 | 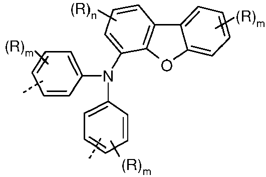 | 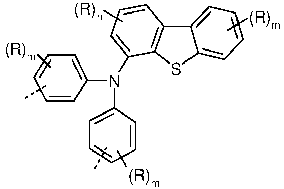 |
| (VIIg-1) | (VIIg-2) | (VIIg-3) |

wobei R, m und n die oben für Formeln (I) und/oder (Ib) angegebenen Bedeutungen annehmen können.

In den Formeln (Vj), (VIg) und (VIIg), sowie deren bevorzugten Ausführungsformen der Formeln (Vj-1) bis (Vj-8), (VIg-1) bis (VIg-7) und (Vllg-1) bis (VIIg-3), stellen die gestrichelten Linien die Bindungen zu den benachbarten Struktureinheiten im Polymer dar. Sie können dabei unabhängig voneinander, gleich oder verschieden, in ortho-, meta- oder para-Position angeordnet sein, vorzugsweise gleich in ortho-, meta- oder para-Position, besonders bevorzugt in meta- oder para-Position und ganz besonders bevorzugt in para-Position.

Erfindungsgemäß umfasst das Polymer mindestens eine Struktureinheit der Formel (I), die ausgewählt ist aus der Struktureinheit der folgenden Formel (VIIIa): 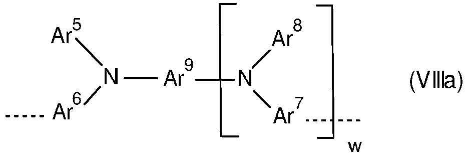 oder der Struktureinheit der folgenden Formel (Vlllb): 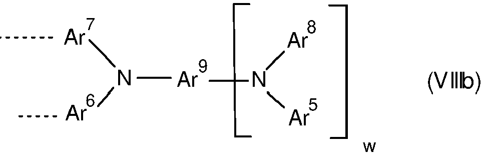
wobei w = 1, 2 oder 3 ist, Ar⁵ bis Ar⁹ bei jedem Auftreten, jeweils gleich oder verschieden, ein mono- oder polycyclisches, aromatisches oder heteroaromatisches Ringsystem ist, das mit einem oder mehreren Resten R substituiert sein kann, wobei R die zuvor, insbesondere für Formel (I) dargelegte Bedeutung annehmen kann; die gestrichelten Linien Bindungen zu benachbarten Struktureinheiten im Polymer darstellen,
dadurch gekennzeichnet, mindestens einer der Rest Ar⁵ und/oder Ar⁸ gemäß Formeln (VIIIa) und/oder (Vlllb) in mindestens einer, vorzugsweise in genau einer der beiden ortho-Positionen, bezogen auf die Position des in Formel (VIIIa) und/oder (Vlllb) dargestellten Stickstoffatoms, mit Ar⁴ substituiert ist, wobei Ar⁴ ein mono- oder polycyclisches, aromatisches oder heteroaromatisches Ringsystem mit 5 bis 60 aromatischen Ringatomen ist, das mit einem oder mehreren Resten R substituiert sein kann, wobei R die zuvor, insbesondere für Formel (I) dargelegte Bedeutung annehmen kann.

Ferner kann vorgesehen sein, dass die Summe der Ringatome des Rests Ar⁴ zusammen mit den Ringatomen der an diesen Rest gebundenen Gruppe Ar⁵, oder Ar⁸ gemäß Formeln (VIIIa) und/oder (Vlllb) mindestens 12 beträgt. Vorzugsweise bildet der Rest Ar⁴ zusammen mit den Ringatomen der an diesen Rest gebundenen Gruppe Ar⁵, oder Ar⁸ gemäß Formeln (VIIIa) und/oder (VIIIb) kein kondensiertes Ringsystem. Weiterhin sind als Rest Ar⁴ Gruppen bevorzugt, die einen geringen Kondensationsgrad aufweisen, so dass monocyclische, aromatische oder heteroaromatische Ringsysteme bevorzugt sind oder polycyclische, aromatische oder heteroaromatische Ringsysteme, deren aromatische oder heteroaromatische Ringe über Gruppen verbunden sind, die eine Konjugation der Ringe minimieren oder aufheben.

Ar⁴ kann dabei entweder direkt, das heißt über eine Einfachbindung, mit mindestens einer der Rest Ar⁵ und/oder Ar⁸ gemäß Formeln (VIIIa) und/oder (Vlllb) verknüpft sein oder aber über eine Verknüpfungsgruppe X.

Die Struktureinheit der Formel (VIIIa) und/oder (Vlllb) kann somit vorzugsweise die Struktur der folgenden Formeln (VIIIa-1a), (VIIIa-1b), (VIIIa-1c) und/oder (VIIIa-1d) aufweisen: 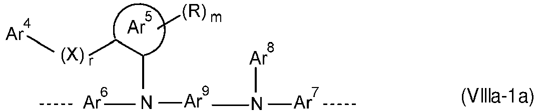 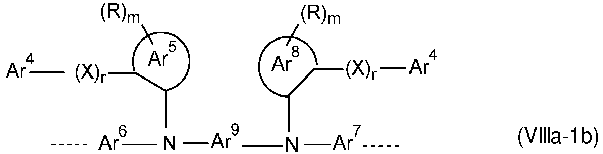 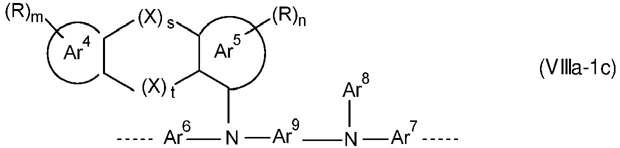 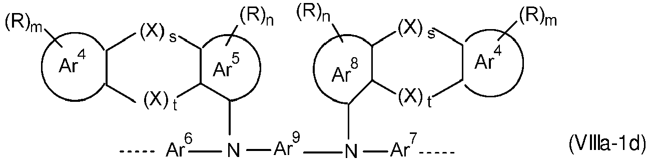 wobei Ar⁴, Ar⁵, Ar⁶, Ar⁷, Ar⁸, Ar⁹, X, m, n, r, s, t und R die zuvor, insbesondere für die Formeln (I), (la), (Ib), (VIIIa) und/oder (Vlllb) angegebenen Bedeutungen annehmen können.

Weiterhin kann die Struktureinheit der Formel (VIIIa) und/oder (Vlllb) somit die Struktur der folgenden Formeln (Vlllb-a), (Vlllb-b), (Vlllb-c) und/oder (Vlllb-d) aufweisen: 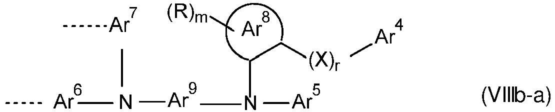 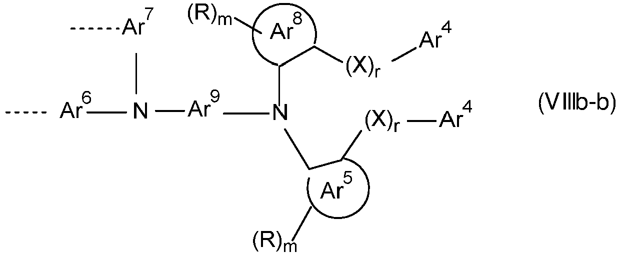 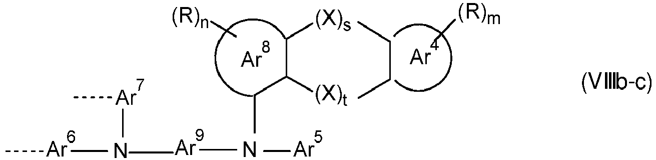 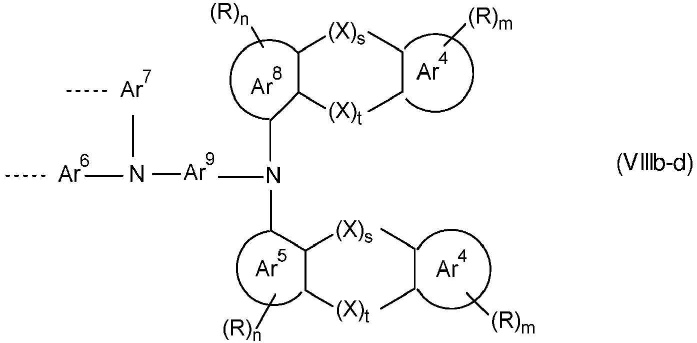 wobei Ar⁴, Ar⁵, Ar⁶, Ar⁷, Ar⁸, Ar⁹, X, m, n, s, t und R die zuvor, insbesondere für die Formeln (I), (la), (Ib), (VIIIa) und/oder (Vlllb) angegebenen Bedeutungen annehmen können.

In einer bevorzugten Ausführungsform ist die mindestens eine Struktureinheit der Formel (VIIIa) ausgewählt aus den Struktureinheiten der folgenden Formeln (IX), (X), (XI), (XII), (XIII), (XIV), (XV) und (XVI): 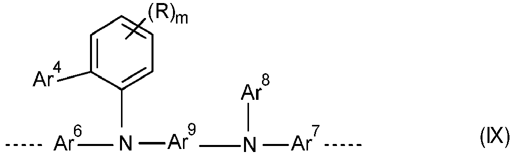 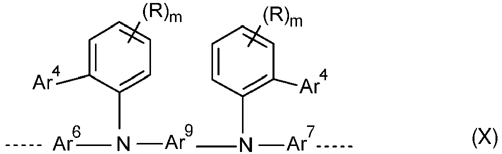 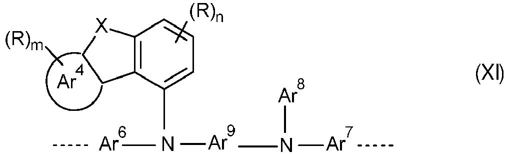 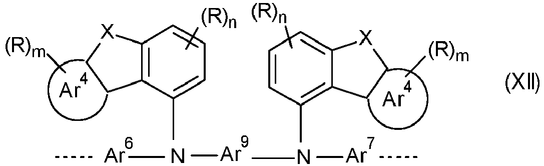 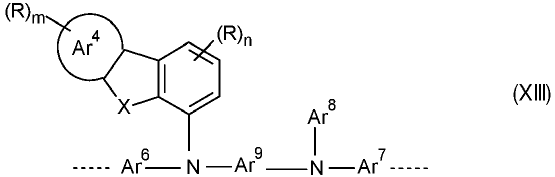 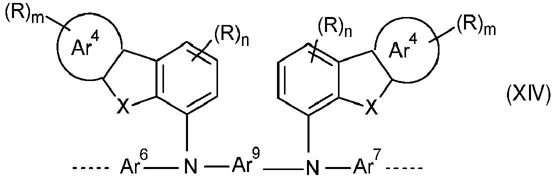 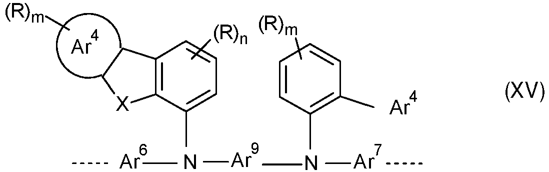 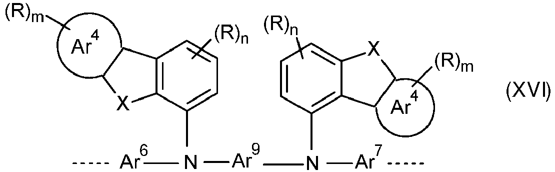 wobei Ar⁴, Ar⁵, Ar⁶, Ar⁷, Ar⁸, Ar⁹, X, m, n, R und die gestrichelten Linien die zuvor, insbesondere für die Formeln (I), (la), (Ib), (VIIIa) und/oder (Vlllb) angegebenen Bedeutungen annehmen können.

In einer besonders bevorzugten Ausführungsform sind die Struktureinheiten der Formeln (IX) und (X) ausgewählt aus den Struktureinheiten der folgenden Formeln (IXa) und (Xa): 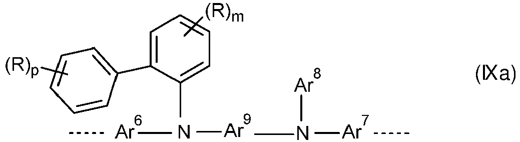 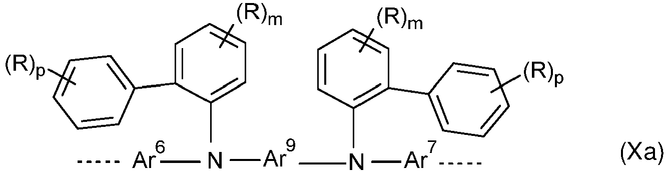 wobei Ar⁶, Ar⁷, Ar⁸, Ar⁹, R, m, p und die gestrichelten Linien die zuvor, insbesondere für die Formeln (I), (la), (Ib), (VIIIa) und/oder (Vlllb) angegebenen Bedeutungen annehmen können.

Beispiele für bevorzugte Struktureinheiten der Formeln (IXa) und (Xa) sind in der folgenden Tabelle abgebildet:

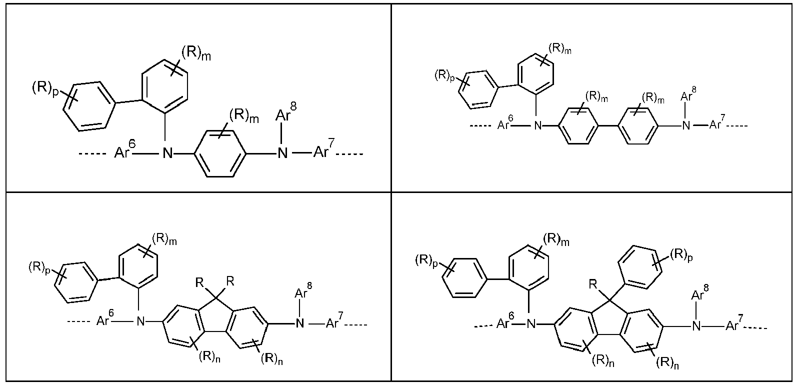

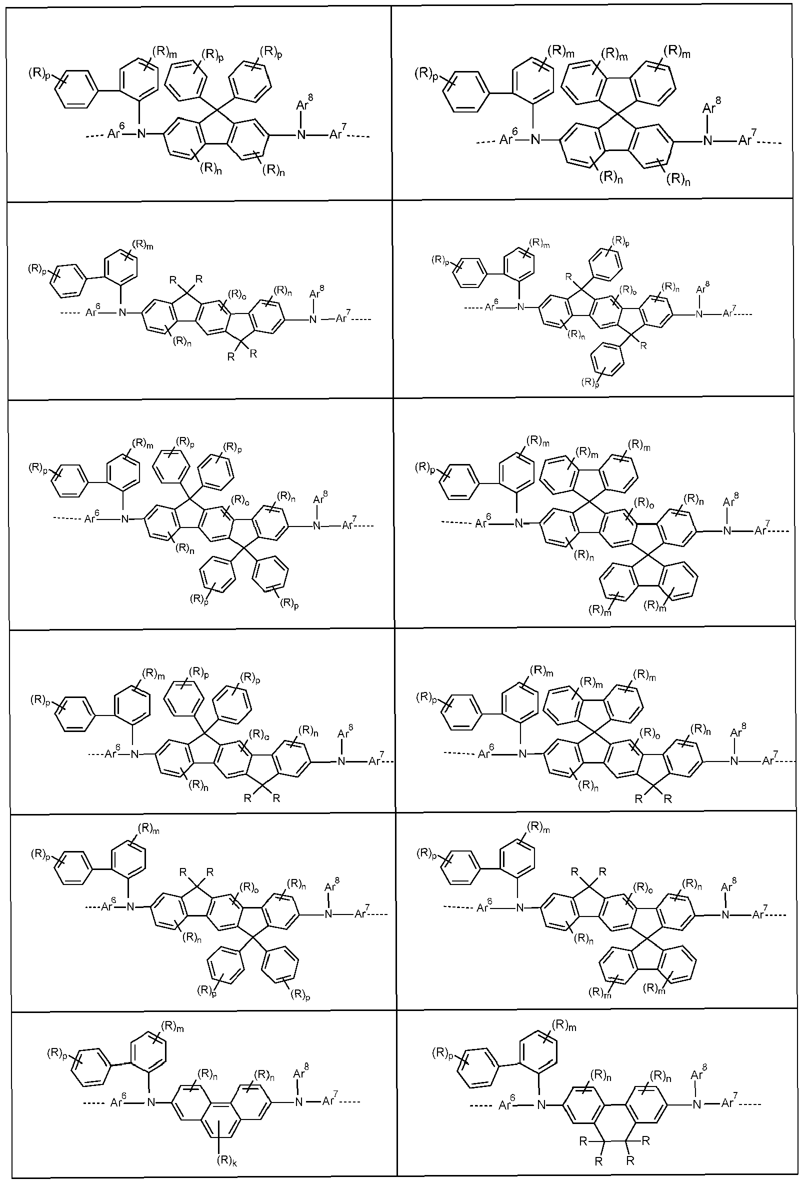

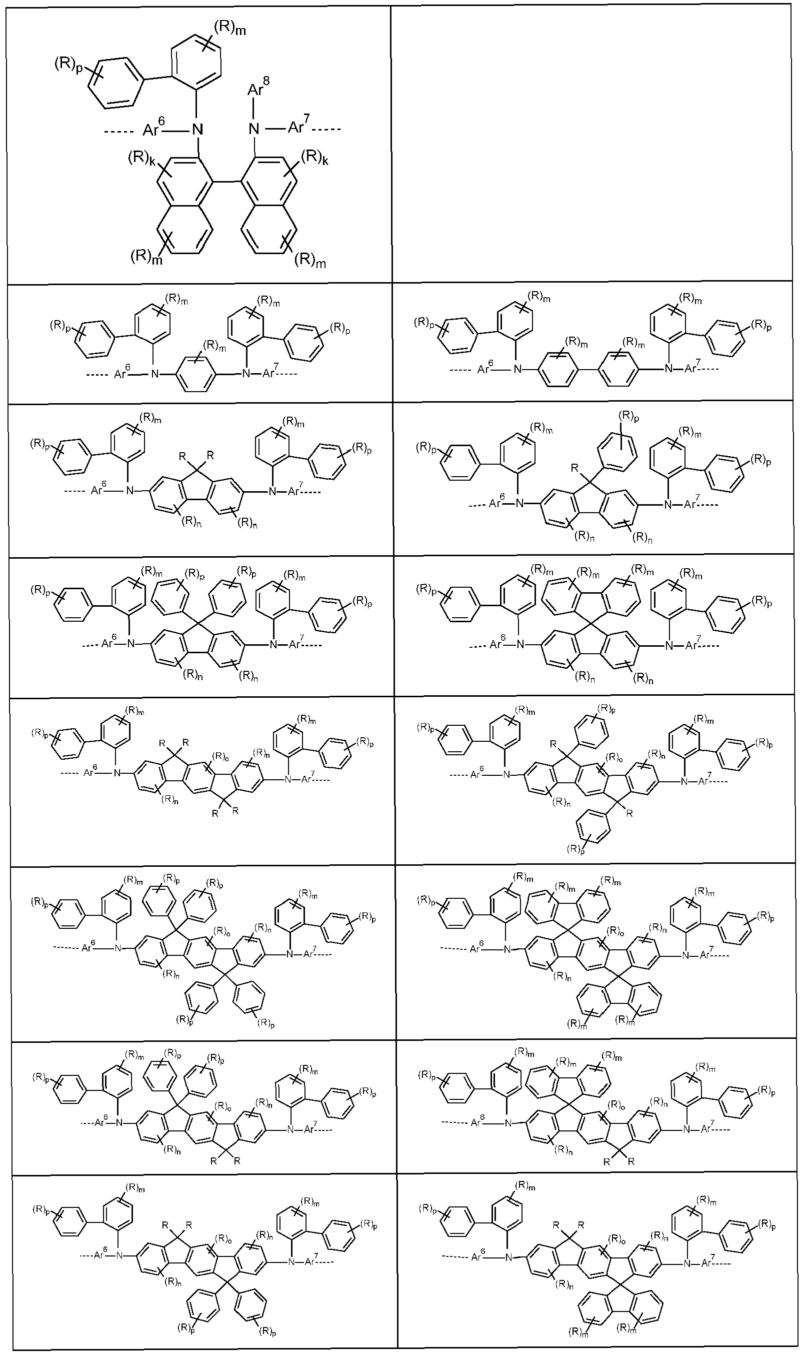

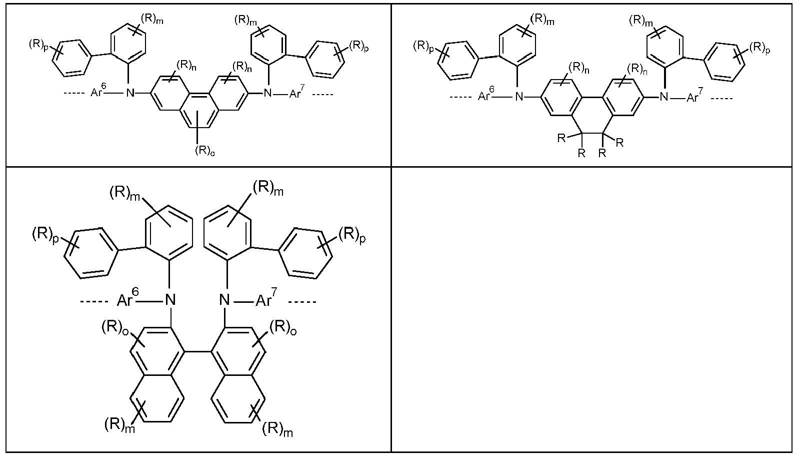

wobei Ar⁶, Ar⁷, Ar⁸, R, m, n, p und die gestrichelten Linien die zuvor, insbesondere für die Formeln (I), (la), (Ib), (VIIIa) und/oder (Vlllb) angegebenen Bedeutungen annehmen können, und o = 0, 1 oder 2 ist.

In einer weiteren besonders bevorzugten Ausführungsform sind die Struktureinheiten der Formeln (XI) und (XII) ausgewählt aus den Struktureinheiten der folgenden Formeln (XIa) und (XIIa): 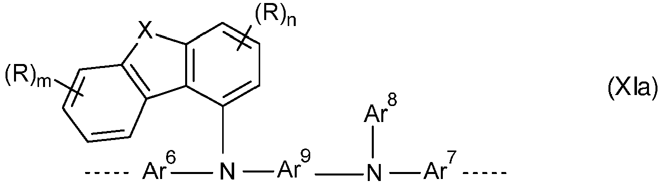 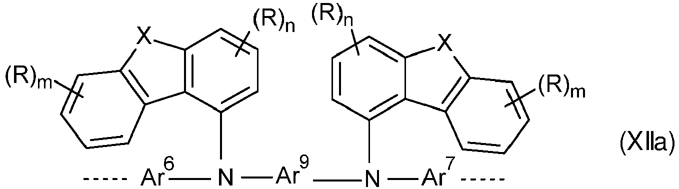 wobei Ar⁶, Ar⁷, Ar⁸, Ar⁹, R, m, n und X die zuvor, insbesondere für die Formeln (I), (la), (Ib), (VIIIa) und/oder (Vlllb) angegebenen Bedeutungen annehmen können.

Beispiele für bevorzugte Struktureinheiten der Formeln (XIa) und (XIIa) sind in der folgenden Tabelle abgebildet:

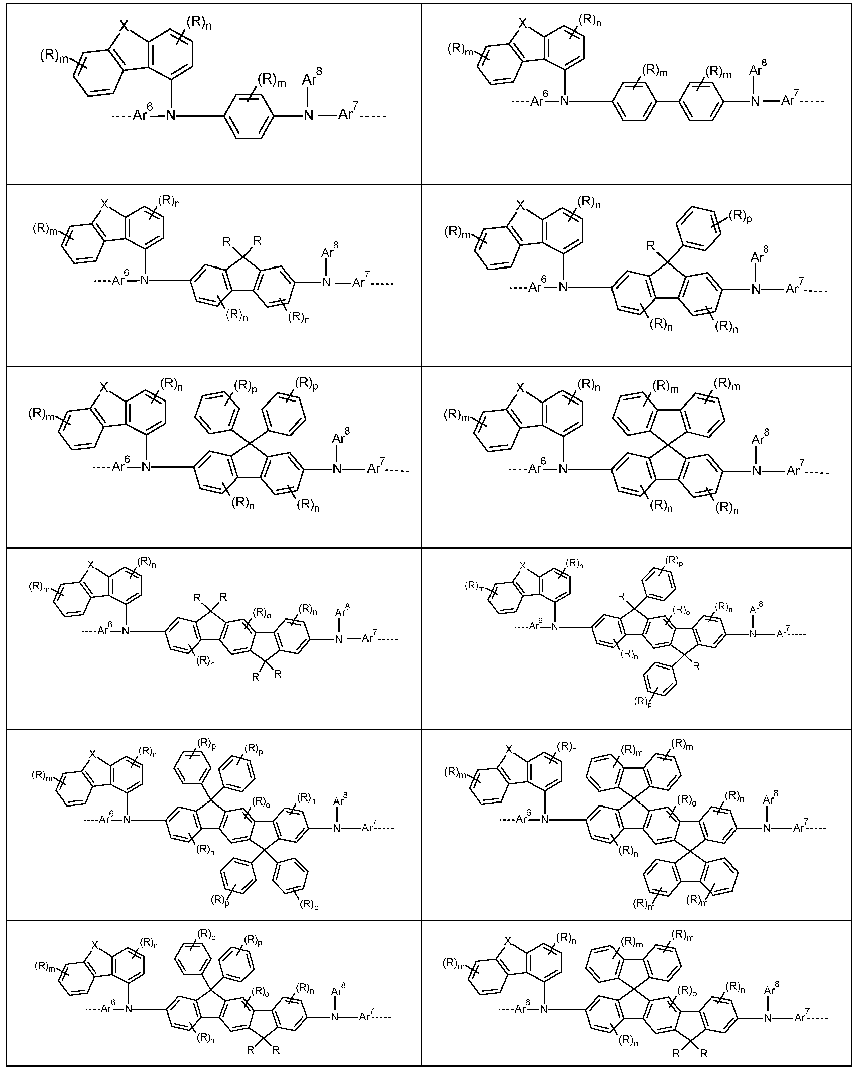

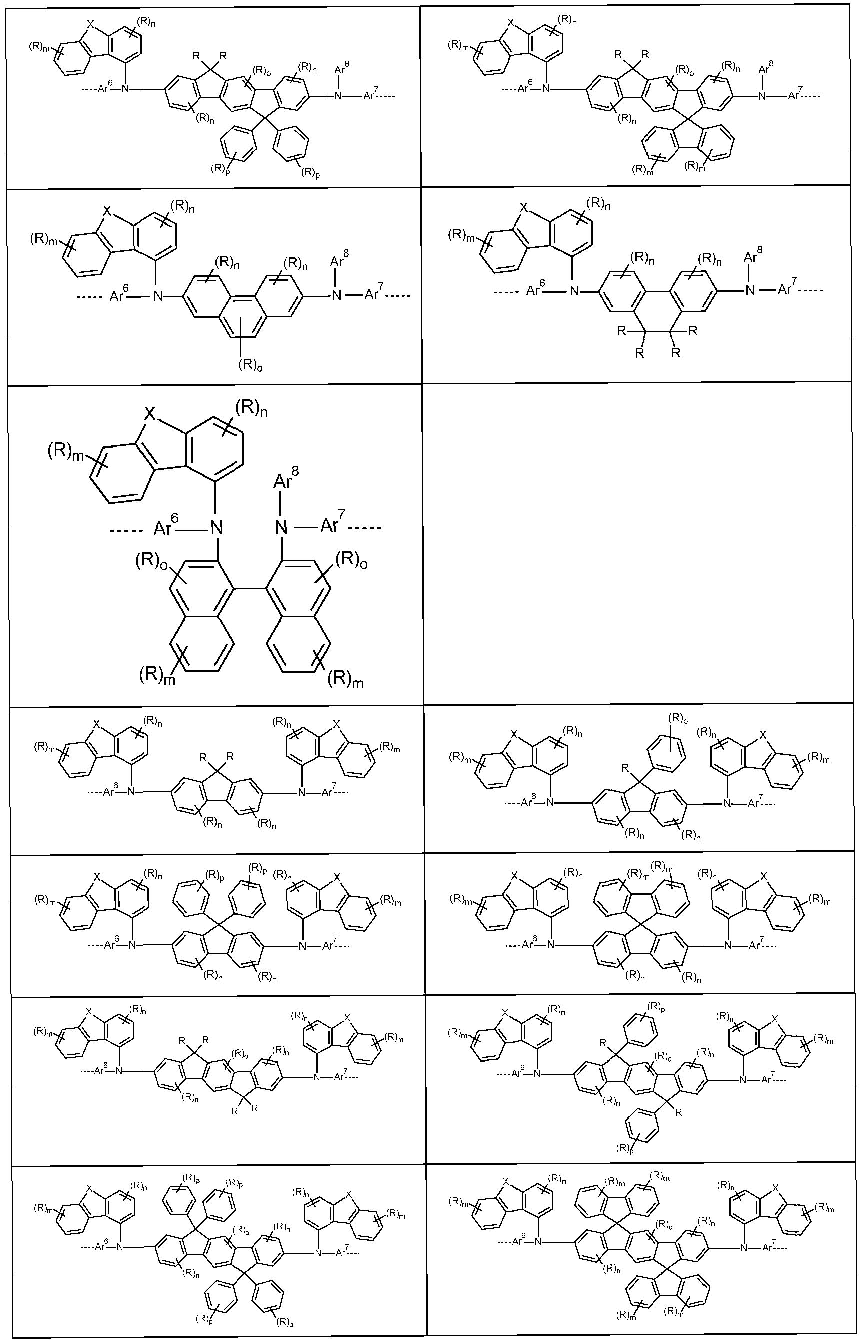

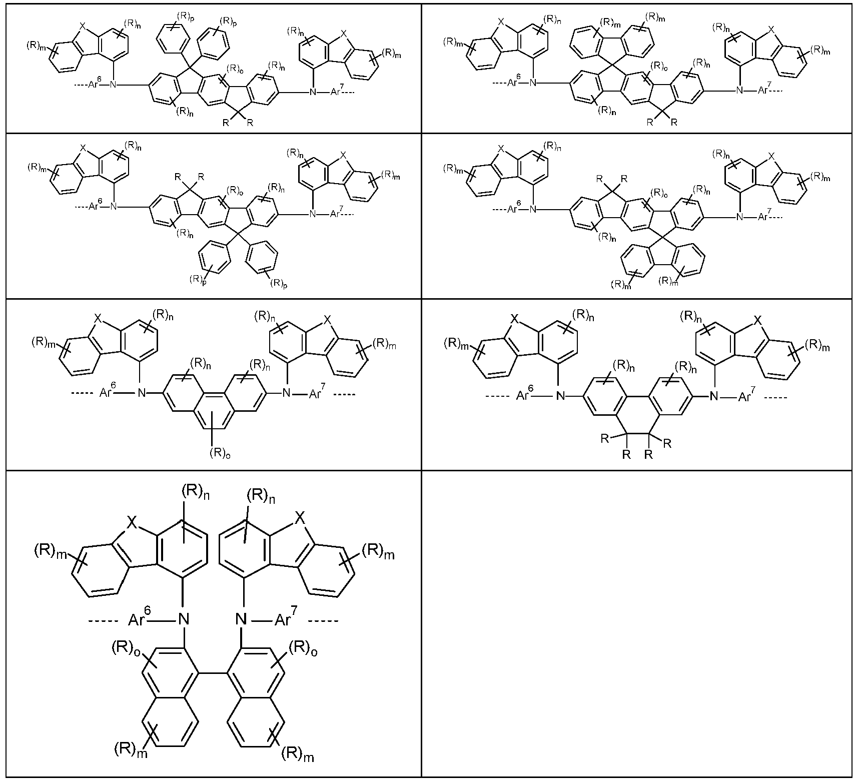

wobei Ar⁶, Ar⁷, Ar⁸, R, m, n und p die zuvor, insbesondere für die Formeln (I), (la), (Ib), (VIIIa) und/oder (Vlllb) angegebenen Bedeutungen annehmen können, und o = 0, 1 oder 2 ist.

In noch einer weiteren besonders bevorzugten Ausführungsform sind die Struktureinheiten der Formeln (XIII) und (XIV) ausgewählt aus den Struktureinheiten der folgenden Formeln (XIIIa) und (XIVa): 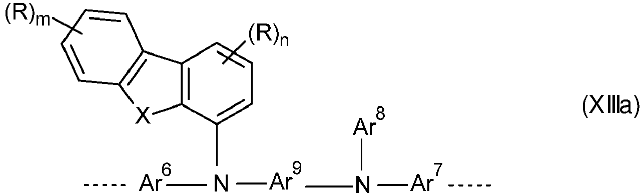 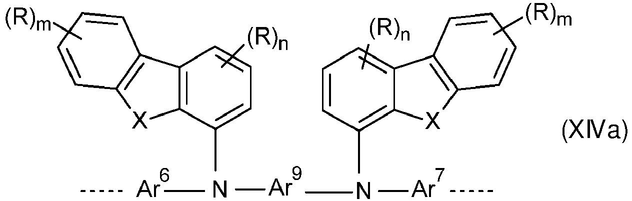 wobei Ar⁶, Ar⁷, Ar⁸, Ar⁹, R, m, n und X die zuvor, insbesondere für die Formeln (I), (la), (Ib), (VIII) und/oder (Vlllb) angegebenen Bedeutungen annehmen können.

Beispiele für bevorzugte Struktureinheiten der Formeln (XIIIa) und (XIVa) sind in der folgenden Tabelle abgebildet:

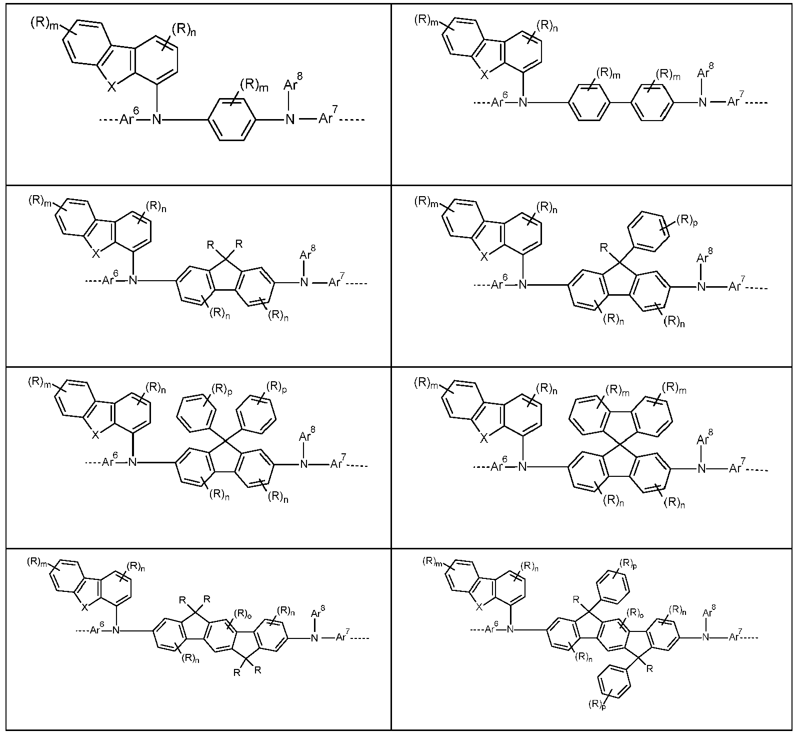

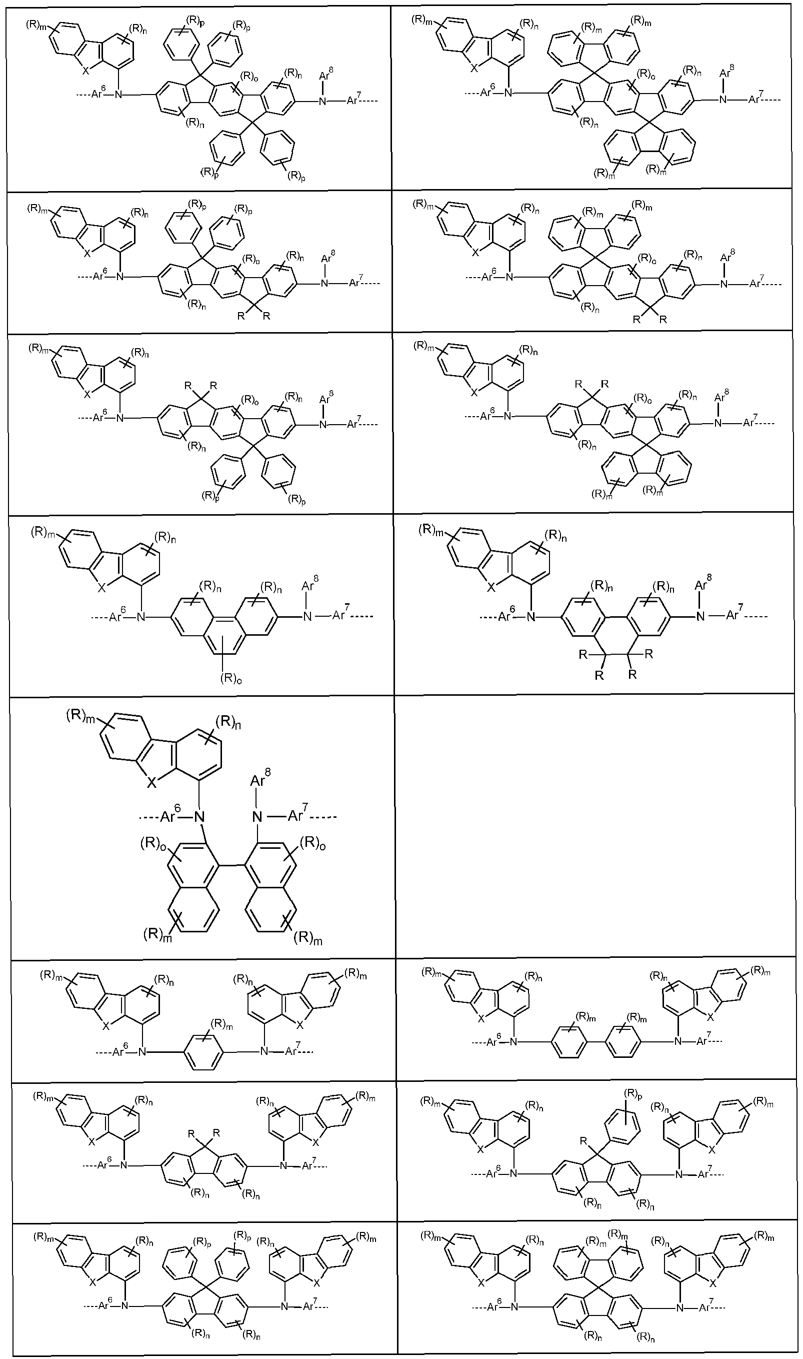

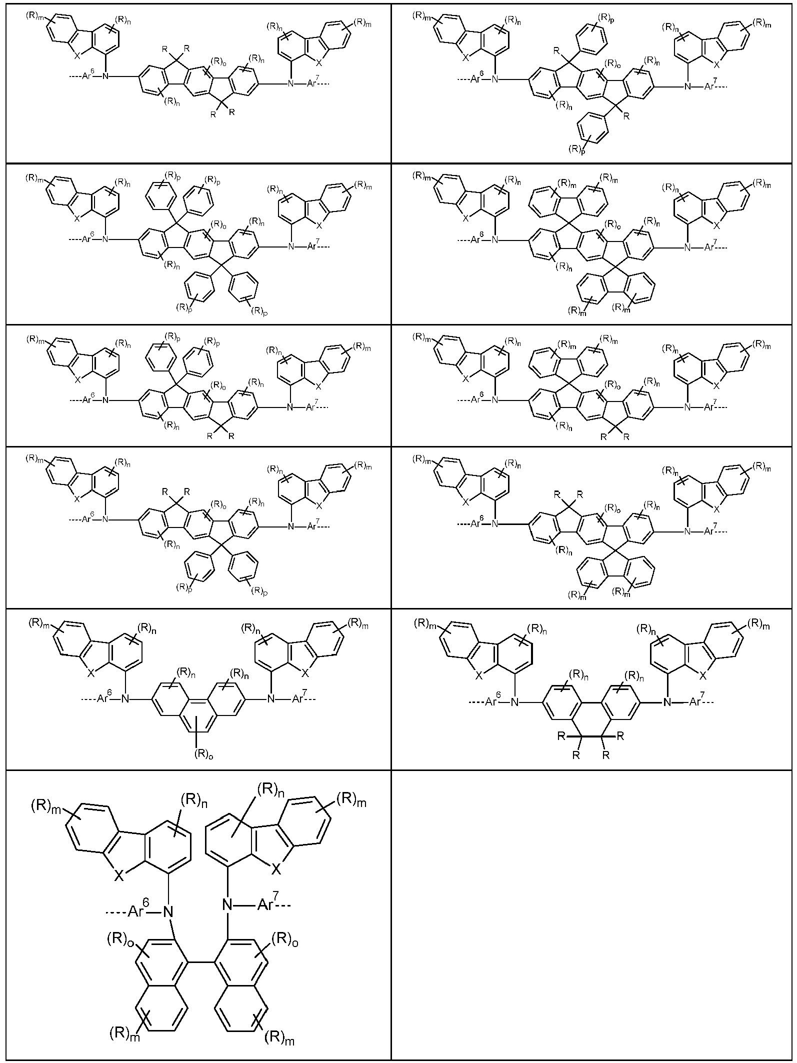

wobei Ar⁶, Ar⁷, Ar⁸, R, m, n und p die zuvor, insbesondere für die Formeln (I), (la), (Ib), (VIIIa) und/oder (Vlllb) angegebenen Bedeutungen annehmen können, und o = 0, 1 oder 2 ist.

In einer ganz besonders bevorzugten Ausführungsform sind die Struktureinheiten der Formeln (IXa) und (Xa) ausgewählt aus den Struktureinheiten der folgenden Formeln (IXb) und (Xb): 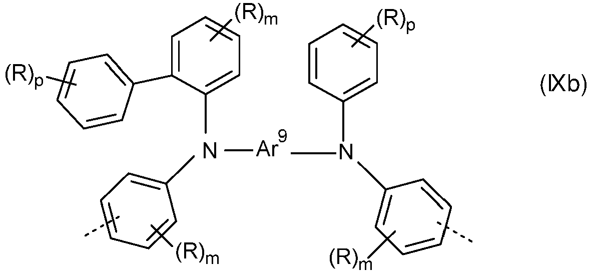 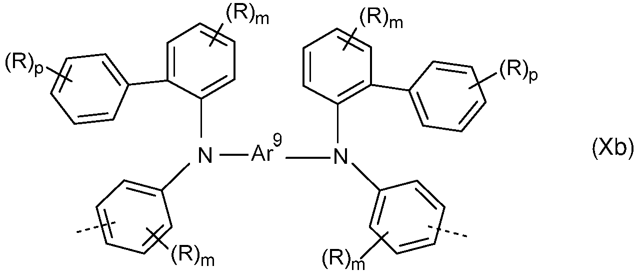 wobei Ar⁹, R, m und p die zuvor, insbesondere für die Formeln (I), (la), (Ib), (VIIIa) und/oder (VIIIb) angegebenen Bedeutungen annehmen können.

Beispiele für bevorzugte Struktureinheiten der Formeln (IXb) und (Xb) sind in der folgenden Tabelle abgebildet:

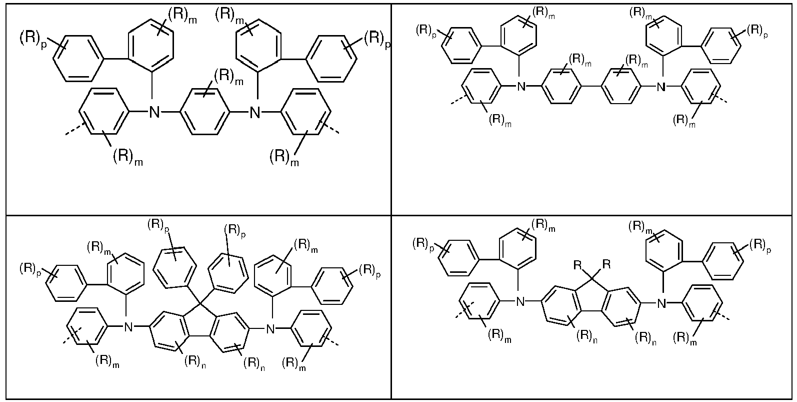

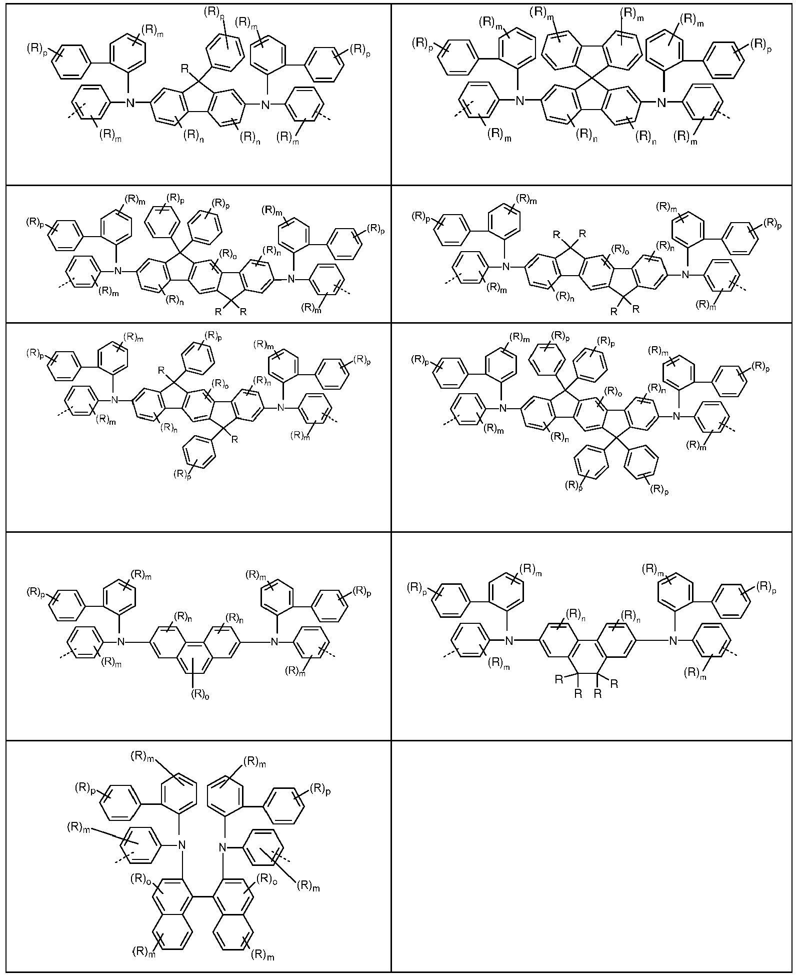

wobei R, m, n und p die zuvor, insbesondere für die Formeln (I), (la), (Ib), (VIIIa) und/oder (Vlllb) angegebenen Bedeutungen annehmen können, und o = 0, 1 oder 2 ist.

In einer weiteren ganz besonders bevorzugten Ausführungsform sind die Struktureinheiten der Formeln (XIa) und (Xlla) ausgewählt aus den Struktureinheiten der folgenden Formeln (XIb) und (XIIb): 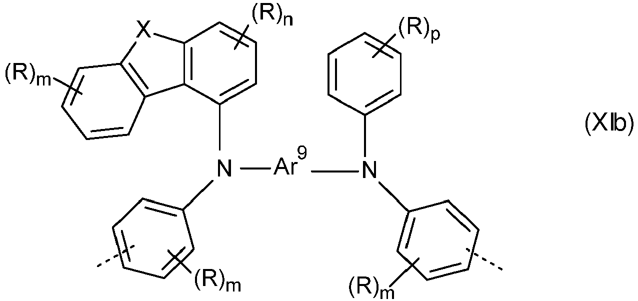 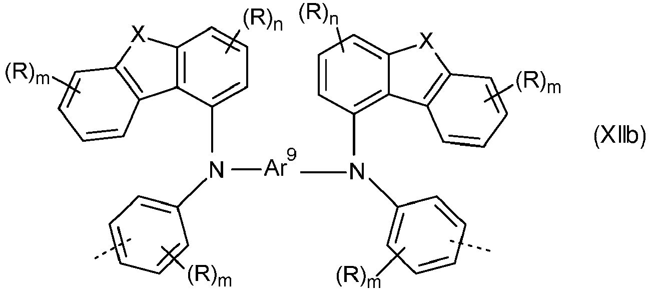 wobei Ar⁹, R, X, m, n und p die zuvor, insbesondere für die Formeln (I), (la), (Ib), (VIIIa) und/oder (Vlllb) angegebenen Bedeutungen annehmen können.

Beispiele für bevorzugte Struktureinheiten der Formeln (XIb) und (XIIb) sind in der folgenden Tabelle abgebildet:

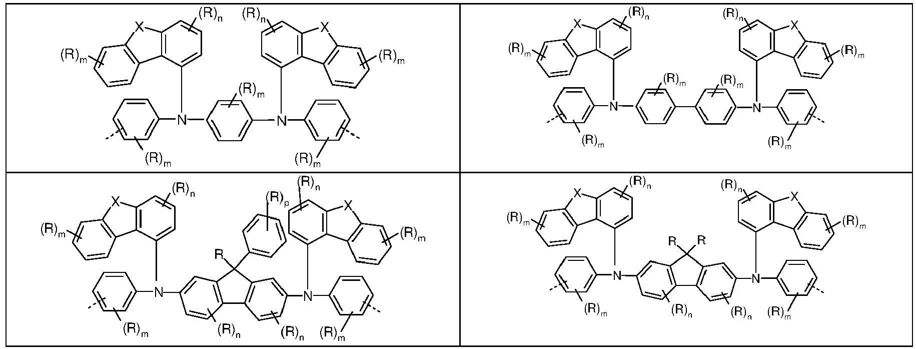

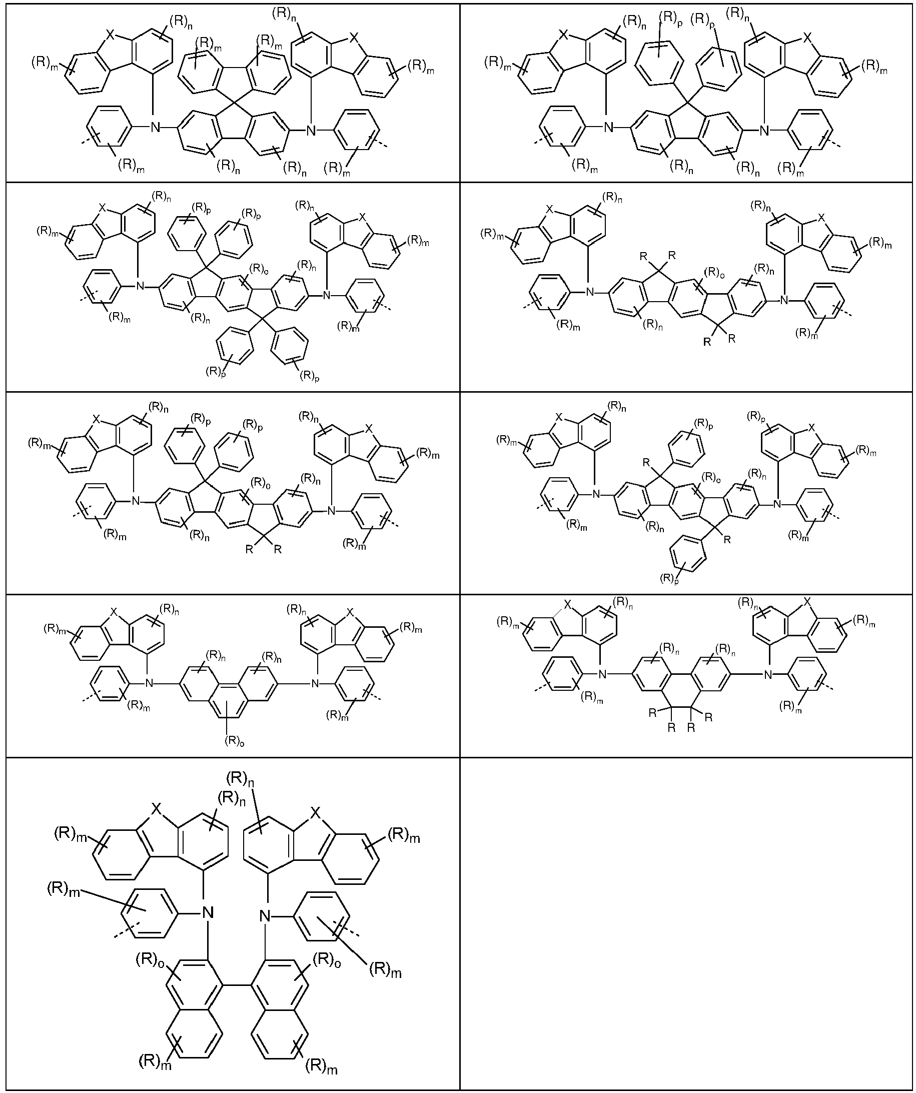

wobei R, X, m, n und p die zuvor, insbesondere für die Formeln (I), (la), (Ib), (VIIIa) und/oder (Vlllb) angegebenen Bedeutungen annehmen können, und o = 0, 1 oder 2 ist.

In noch einer weiteren ganz besonders bevorzugten Ausführungsform sind die Struktureinheiten der Formeln (XIIIa) und (XIVa) ausgewählt aus den Struktureinheiten der folgenden Formeln (XIIIb) und (XIVb): 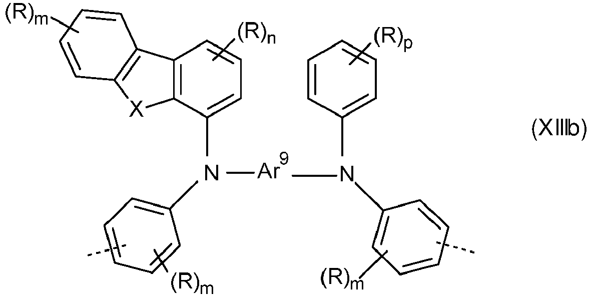 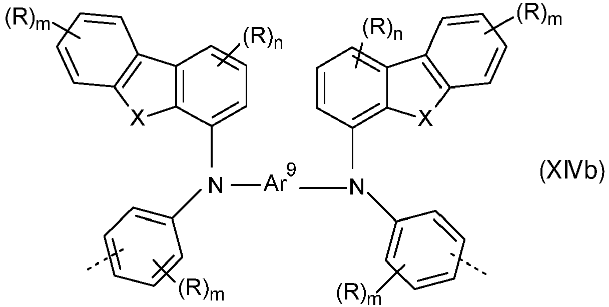 wobei R, X, m, n und p die zuvor, insbesondere für die Formeln (I), (la), (Ib), (VIIIa) und/oder (Vlllb) angegebenen Bedeutungen annehmen können.

Beispiele für bevorzugte Struktureinheiten der Formel (XIIIb) und (XIVb) sind in der folgenden Tabelle abgebildet:

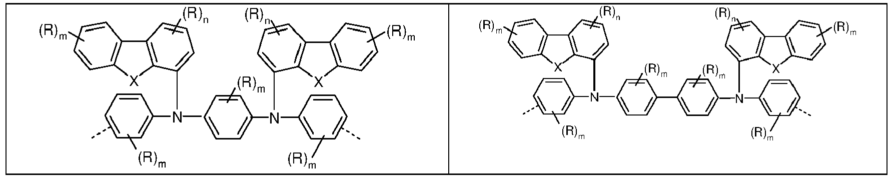

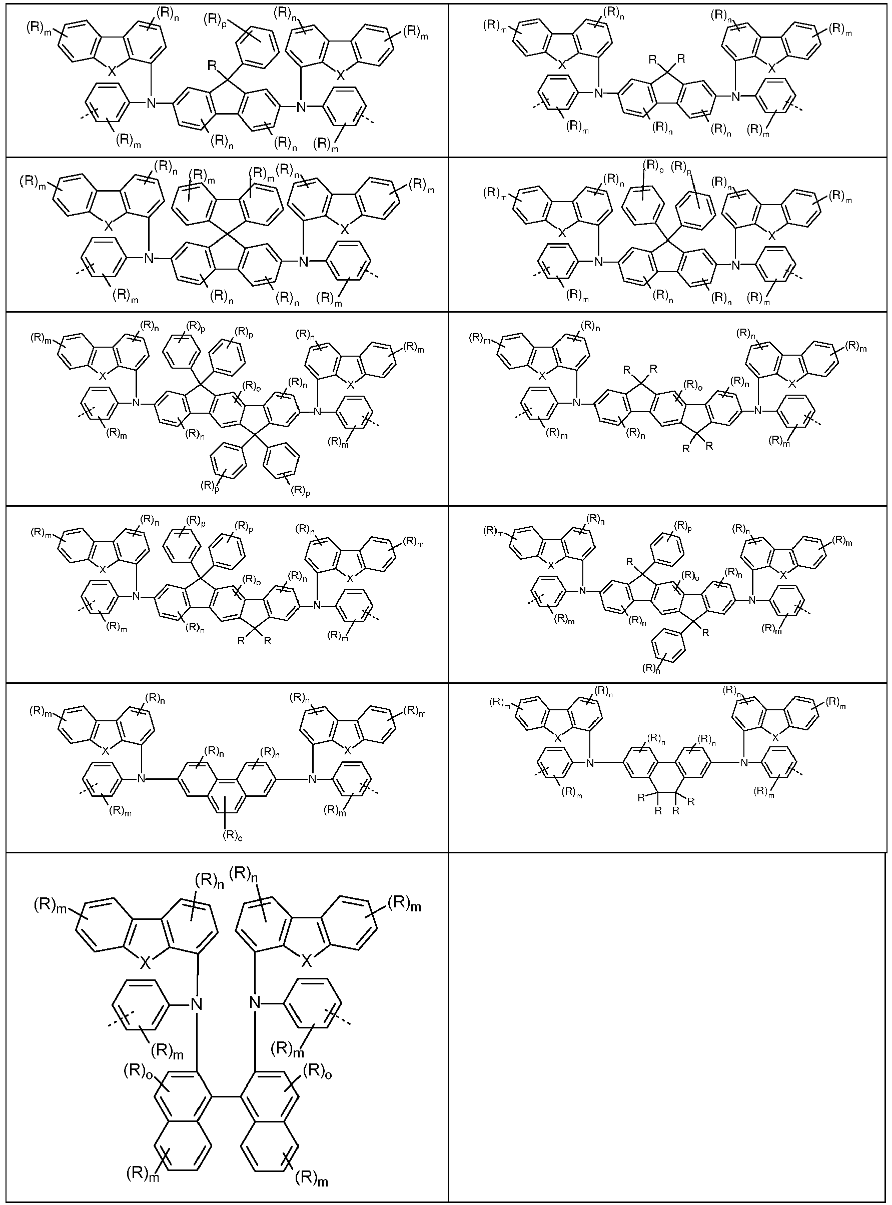

wobei R, X, m, n und p die zuvor, insbesondere für die Formeln (I), (la), (Ib), (VIIIa) und/oder (Vlllb) angegebenen Bedeutungen annehmen können, und o = 0, 1 oder 2 ist.

In den Formeln (IXa) bis (XIVa) und (IXb) bis (XIVb), stellen die gestrichelten Linien die Bindungen zu den benachbarten Struktureinheiten im Polymer dar. Sie können dabei unabhängig voneinander, gleich oder verschieden, in ortho-, meta- oder para-Position angeordnet sein, vorzugsweise gleich in ortho-, meta- oder para-Position, besonders bevorzugt in meta- oder para-Position und ganz besonders bevorzugt in para-Position.

Gemäß einer bevorzugten Ausgestaltung der vorliegenden Erfindung kann vorgesehen sein, dass mindestens eine der Struktureinheiten der Formeln (Ia), (Ib), (II), (III), (IV), (V), (VI), (VII), (VIIIa), (Vlllb), (IX), (X), (XI), (XII), (XIII), (XIV), (XV), (XVI) und/oder einer bevorzugten Ausgestaltung dieser Struktureinheiten mindestens eine vernetzbare Gruppe Q aufweist. "Vernetzbare Gruppe Q" im Sinne der vorliegenden Erfindung bedeutet eine funktionelle Gruppe, die in der Lage ist, eine Reaktion einzugehen und so eine unlösliche Verbindung zu bilden. Die Reaktion kann dabei mit einer weiteren, gleichen Gruppe Q, einer weiteren, verschiedenen Gruppe Q oder einem beliebigen anderen Teil derselben oder einer anderen Polymerkette erfolgen. Bei der vernetzbaren Gruppe handelt es sich somit um eine reaktive Gruppe. Dabei erhält man als Ergebnis der Reaktion der vernetzbaren Gruppe eine entsprechend vernetzte Verbindung. Die chemische Reaktion kann auch in der Schicht durchgeführt werden, wobei eine unlösliche Schicht entsteht. Die Vernetzung kann gewöhnlich durch Wärme oder durch UV-, Mikrowellen-, Röntgen- oder Elektronenstrahlung unterstützt werden, gegebenenfalls in Gegenwart eines Initiators. "Unlöslich" im Sinne der vorliegenden Erfindung bedeutet vorzugsweise, dass das erfindungsgemäße Polymer nach der Vernetzungsreaktion, also nach der Reaktion der vernetzbaren Gruppen, bei Raumtemperatur in einem organischen Lösungsmittel eine Löslichkeit aufweist, die mindestens einen Faktor 3, vorzugsweise mindestens einen Faktor 10, geringer ist als die des entsprechenden, nicht-vernetzten, erfindungsgemäßen Polymers in demselben organischen Lösungsmittel.

Mindestens eine vernetzbare Gruppe heißt in der vorliegenden Anmeldung, dass eine Struktureinheit eine oder mehrere vernetzbare Gruppen aufweist.

Vorzugsweise weist eine Struktureinheit genau eine vernetzbare Gruppe auf.

Weist die Struktureinheit der Formel (Ia) eine vernetzbare Gruppe auf, so kann diese an Ar¹, Ar² oder Ar³ gebunden sein. Vorzugsweise ist die vernetzbare Gruppe an dem monovalent gebundenen, mono- oder polycyclischen, aromatischen oder heteroaromatischen Ringsystem Ar³ gebunden.

Weist die Struktureinheit der Formel (VIIIa) oder (Vlllb) eine vernetzbare Gruppe auf, so kann diese an Ar⁵, Ar⁶, Ar⁷, Ar⁸ oder Ar⁹ gebunden sein. Vorzugsweise ist die vernetzbare Gruppe an eine der monovalent gebundenen, mono- oder polycyclischen, aromatischen oder heteroaromatischen Ringsysteme gebunden, d.h. an Ar⁵ oder Ar⁸. Bevorzugte mono- oder polycyclische, aromatische oder heteroaromatische Gruppen Ar³ in Formel (I), Ar⁴ in Formeln (la), (Ib), (II), (III), (IV), (V), (VI), (VII), (VIIIa), (Vlllb), (IX), (X), (XI), (XII), (XIII), (XIV), (XV) und/oder (XVI); Ar⁵ und Ar⁸ in Formeln (VIIIa) und/oder (Vlllb), sowie deren bevorzugten Ausführungsformen sind die folgenden:

| | | |
|---|---|---|
| 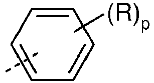 | 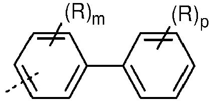 | 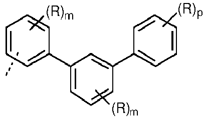 |
| E1 | E2 | E3 |
| 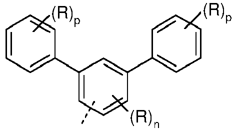 | 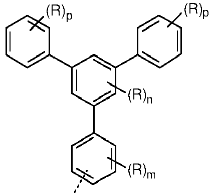 | 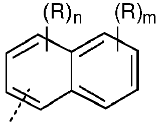 |
| E4 | E5 | E6 |
| 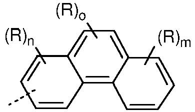 | 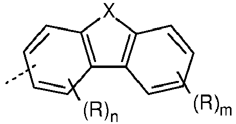 | 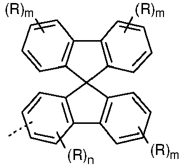 |
| E7 | E8 | E9 |
| 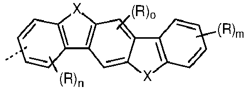 | 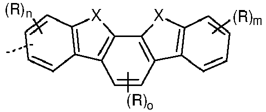 | 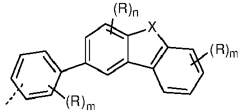 |
| E10 | E11 | E12 |

Die Reste R in den Formeln E1 bis E12 können dabei die gleiche Bedeutung annehmen, wie die Reste R in der Formel (I). X kann CR₂, NR, SiR₂, O, S, C=O oder P=O, vorzugsweise CR₂, SiR₂, NR, O oder S bedeuten, wobei auch hier R die gleiche Bedeutung annehmen kann, wie die Reste R in Bezug auf die Formel (I). Die gestrichelte Linie stellt die Bindungsstelle an die benachbarte Gruppe dar.

Die verwendeten Indices haben die folgende Bedeutung:
m = 0, 1, 2, 3 oder 4;
n = 0, 1, 2 oder 3;
o = 0, 1 oder 2; und
p = 0, 1, 2, 3, 4 oder 5.

Bevorzugte mono- oder polycyclische, aromatische oder heteroaromatische Gruppen Ar¹ und Ar² in Formel (I), Ar⁶, Ar⁷ und Ar⁹ in Formeln (VIIIa) und/oder (Vlllb) sind die folgenden:

| | | |
|---|---|---|
| 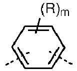 | 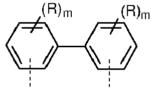 | 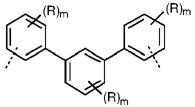 |
| M1 | M2 | M3 |
| 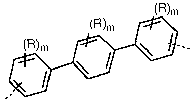 | 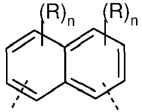 | 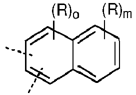 |
| M4 | M5 | M6 |
| 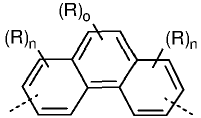 | 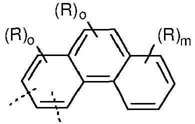 | 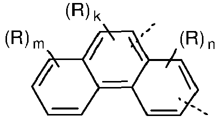 |
| M7 | M8 | M9 |
| 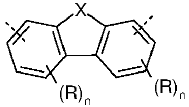 | 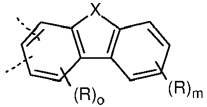 | 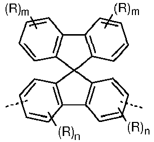 |
| M10 | M11 | M12 |
| 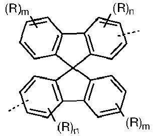 | 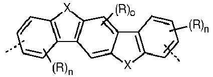 | 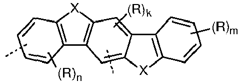 |
| M13 | M14 | M15 |
| 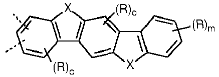 | 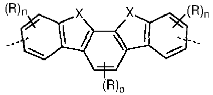 | 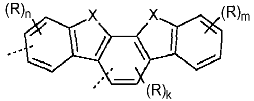 |
| M16 | M17 | M18 |
| 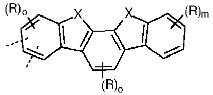 | 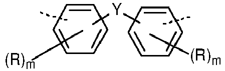 | |
| M19 | M20 | |
| 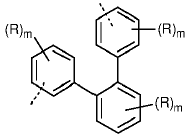 | 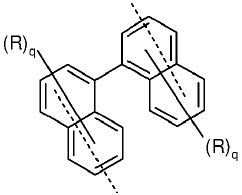 | 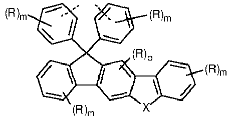 |
| M21 | M22 | M23 |

Die Reste R in den Formeln M1 bis M23 können dabei die gleiche Bedeutung annehmen, wie die Reste R in der Formel (I). X kann CR₂, NR, SiR₂, O, S, C=O oder P=O, vorzugsweise CR₂, SiR₂, NR, O oder S bedeuten, wobei auch hier R die gleiche Bedeutung annehmen kann, wie die Reste R in Bezug auf die Formel (I). Die gestrichelten Linien stellen die Bindungsstellen an die benachbarten Gruppen dar.

Y kann CR₂, SiR₂, O, S oder eine geradkettige oder verzweigte Alkylgruppe mit 1 bis 20 C-Atomen oder eine Alkenyl- oder Alkinylgruppe mit 2 bis 20 C-Atomen sein, die jeweils mit einem oder mehreren Resten R¹ substituiert sein kann, und wobei eine oder mehrere nicht benachbarte CH₂-Gruppen, CH-Gruppen bzw. C-Atome der Alkyl-, Alkenyl- oder Alkinylgruppen durch Si(R¹)₂, C=O, C=S, C=NR¹, P(=O)(R¹), SO, SO₂, NR¹, O, S, CONR¹ oder ein aromatisches oder heteroaromatisches Ringsystem mit 5 bis 60 aromatischen Ringatomen, das jeweils durch einen oder mehrere Reste R¹ substituiert sein kann, oder eine Aryloxy- oder Heteroaryloxygruppe mit 5 bis 60 aromatischen Ringatomen, die durch einen oder mehrere Reste R¹ substituiert sein kann, oder eine Aralkyl- oder Heteroaralkylgruppe mit 5 bis 60 aromatischen Ringatomen, die durch einen oder mehrere Reste R¹ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R¹ substituiert sein kann, ersetzt sein können; wobei auch hier die Reste R und R¹ die gleichen Bedeutungen annehmen können, wie die Reste R und R¹ in Formel (I).

Die verwendeten Indices haben die folgende Bedeutung:
k = 0 oder 1;
m = 0, 1, 2, 3 oder 4;
n = 0, 1, 2 oder 3;
0 = 0, 1 oder 2; und
q = 0, 1, 2, 3, 4, 5 oder 6.

Besonders bevorzugte mono- oder polycyclische, aromatische oder heteroaromatische Gruppen Ar³ in Formel (I), Ar⁴ in Formeln (la), (Ib), (II), (III), (IV), (V), (VI), (VII), (VIIIa), (Vlllb), (IX), (X), (XI), (XII), (XIII), (XIV), (XV) und/oder (XVI); Ar⁵ und Ar⁸ in Formeln (VIIIa) und/oder (VIIIb), sowie deren bevorzugten Ausführungsformen sind die folgenden:

| | | |
|---|---|---|
| 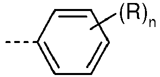 | | |
| E1a | | |
| 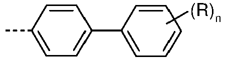 | 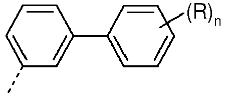 | 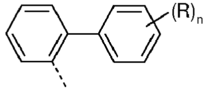 |
| E2a | E2b | E2c |
| 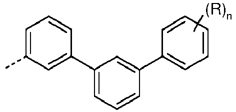 | 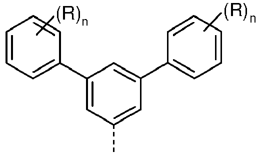 | 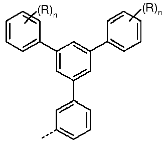 |
| E3a | E4a | E5a |
| 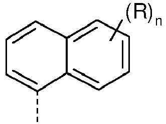 | 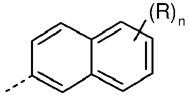 | 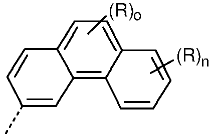 |
| E6a | E6b | E7a |
| 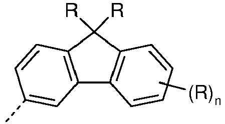 | 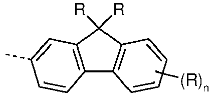 | 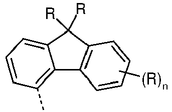 |
| E8a | E8b | E8c |
| 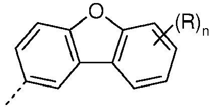 | 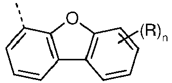 | 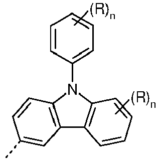 |
| E8d | E8e | E8f |
| 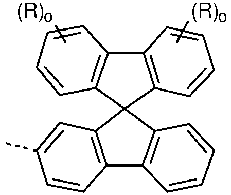 | 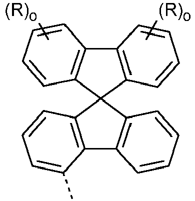 | |
| E9a | E9b | |
| 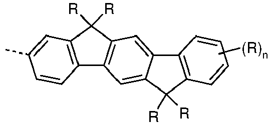 | 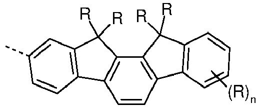 | 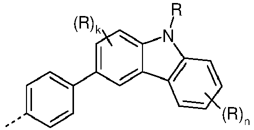 |
| E10a | E11a | E12a |

Die Reste R in den Formeln E1a bis E12a können dabei die gleiche Bedeutung annehmen, wie die Reste R in Formel (I).

Die verwendeten Indices haben die folgende Bedeutung:
o = 0 oder 1; und
n = 0, 1, 2 oder 3.

Die Reste R in den Formeln E1a bis E12a, können bei jedem Auftreten, gleich oder verschieden, vorzugsweise H oder eine geradkettige oder verzweigte Alkylgruppe mit 1 bis 12 C-Atomen, vorzugsweise 1 bis 10 C-Atomen darstellen. Besonders bevorzugt sind die Reste R in den Formeln E1a bis E12a Methyl, n-Butyl, sec-Butyl, tert-Butyl, n-Hexyl und n-Octyl.

Besonders bevorzugte mono- oder polycyclische, aromatische oder heteroaromatische Gruppen Ar² und Ar³ in Formel (I), Ar⁵, Ar⁷ und Ar⁸ in Formel (IIa), Ar⁴, Ar⁵ und Ar⁸ in Formel (IIb), sowie Ar⁹ in Formel (III) sind die folgenden:

| | | |
|---|---|---|
| 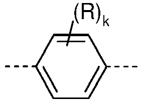 | 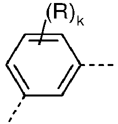 | 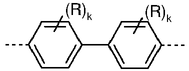 |
| M1a | M1b | M2a |
| 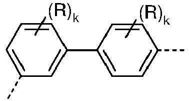 | 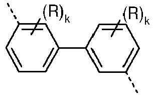 | 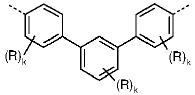 |
| M2b | M2c | M3a |
| 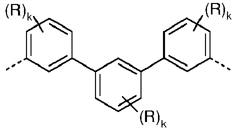 | | |
| M3b | | |
| 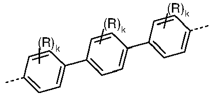 | 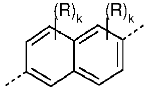 | 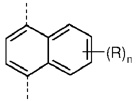 |
| M4a | M5a | M6a |
| 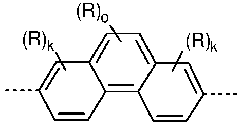 | 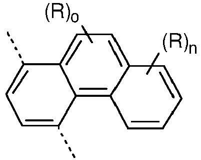 | 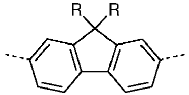 |
| M7a | M8a | M10a |
| 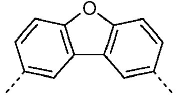 | 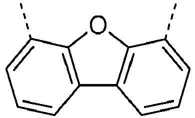 | 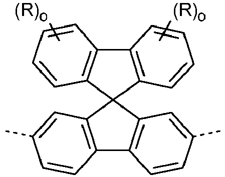 |
| M10b | M10c | M12a |
| 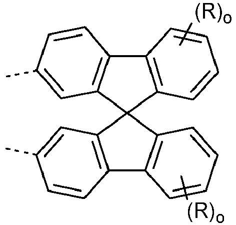 | 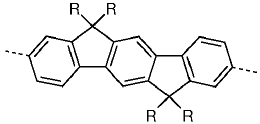 | 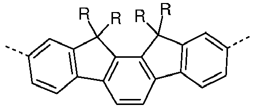 |
| M13a | M14a | M17a |
| 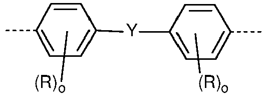 | 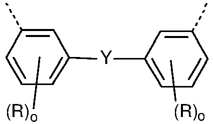 | 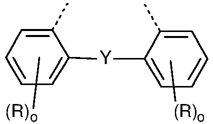 |
| M20a | M20b | M20c |
| 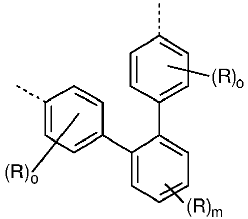 | 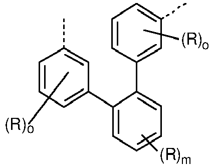 | 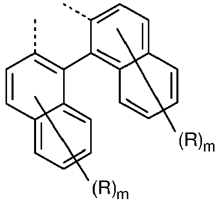 |
| M21a | M21b | M22a |
| 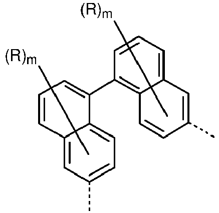 | 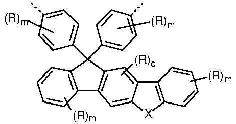 | 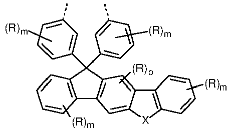 |
| M22b | M23a | M23b |

Die Reste R in den Formeln M1 a bis M23b können dabei die gleiche Bedeutung annehmen, wie die Reste R in Formel (I). X kann CR₂ oder SiR₂ bedeuten, wobei auch hier R die gleiche Bedeutung annehmen kann, wie die Reste R in Formel (I).

Y kann CR₂, SiR₂, O, S oder eine geradkettige Alkylgruppe mit 1 bis 10 C-Atomen oder eine Alkenyl- oder Alkinylgruppe mit 2 bis 10 C-Atomen sein, die jeweils mit einem oder mehreren Resten R¹ substituiert sein kann, und wobei eine oder mehrere nicht benachbarte CH₂-Gruppen, CH-Gruppen bzw. C-Atome der Alkyl-, Alkenyl- oder Alkinylgruppen durch Si(R¹)₂, C=O, C=NR¹, P(=O)(R¹), NR¹, O, CONR¹ oder ein aromatisches oder heteroaromatisches Ringsystem mit 5 bis 30 aromatischen Ringatomen, das jeweils durch einen oder mehrere Reste R¹ substituiert sein kann, oder eine Aryloxy- oder Heteroaryloxygruppe mit 5 bis 30 aromatischen Ringatomen, die durch einen oder mehrere Reste R¹ substituiert sein kann, oder eine Aralkyl- oder Heteroaralkylgruppe mit 5 bis 30 aromatischen Ringatomen, die durch einen oder mehrere Reste R¹ substituiert sein kann, oder eine Diarylaminogruppe, Diheteroarylaminogruppe oder Arylheteroarylaminogruppe mit 10 bis 20 aromatischen Ringatomen, welche durch einen oder mehrere Reste R¹ substituiert sein kann, ersetzt sein können; wobei auch hier die Reste R und R¹ die gleichen Bedeutungen annehmen können, wie die Reste R und R¹ in Formel (I).

Die verwendeten Indices haben die folgende Bedeutung:
k = 0 oder 1;
o = 0, 1 oder 2;
n = 0, 1, 2 oder 3; und
m = 0, 1, 2, 3 oder 4.

Eine Auswahl möglicher Struktureinheiten der Formel (I) ist in der folgenden Tabelle 1 aufgeführt.

**Tabelle 1**

| Formel (I) | Ar¹ | Ar² | Ar³ |
|---|---|---|---|
| I1 | M1 | M1 | E1 |
| I2 | M2 | M2 | E1 |
| I3 | M10 | M10 | E1 |
| I4 | M12 | M12 | E1 |
| I5 | M14 | M14 | E1 |
| I6 | M19 | M19 | E1 |
| I7 | M1 | M1 | E2 |
| I8 | M1 | M2 | E2 |
| I9 | M7 | M7 | E2 |
| I10 | M12 | M12 | E2 |
| I11 | M13 | M13 | E2 |
| I12 | M1 | M1 | E3 |
| I13 | M13 | M13 | E3 |
| I14 | M1 | M1 | E4 |
| I15 | M2 | M2 | E4 |
| I16 | M14 | M14 | E4 |
| I17 | M3 | M3 | E5 |
| I18 | M12 | M12 | E5 |
| I19 | M6 | M6 | E6 |
| I20 | M10 | M10 | E6 |
| I21 | M16 | M16 | E6 |
| I22 | M2 | M2 | E7 |
| I23 | M15 | M15 | E7 |
| I24 | M1 | M1 | E8 |
| I25 | M2 | M2 | E8 |
| I26 | M4 | M4 | E8 |
| I27 | M5 | M5 | E8 |
| I28 | M10 | M10 | E8 |
| I29 | M12 | M12 | E8 |
| I30 | M14 | M14 | E8 |
| I31 | M1 | M1 | E9 |
| I32 | M8 | M8 | E9 |
| I33 | M13 | M13 | E9 |
| I34 | M10 | M10 | E10 |
| I35 | M9 | M9 | E11 |
| I36 | M17 | M17 | E11 |
| I37 | M7 | M7 | E12 |
| I38 | M18 | M18 | E12 |
| I39 | M23 | M23 | E1 |
| I40 | M1 | M21 | E2 |
| I41 | M20 | M20 | E8 |
| I42 | M22 | M22 | E9 |

Eine weitere Auswahl möglicher Struktureinheiten der Formel (I) ist in der folgenden Tabelle 2 aufgeführt.

**Tabelle 2**

| Formel (I) | Ar¹ | Ar² | Ar³ |
|---|---|---|---|
| I1a | M1a | M1a | E1a |
| I2a | M2a | M2a | E1a |
| I2b | M2c | M2c | E1a |
| I3a | M10a | M10a | E1a |
| I4a | M12a | M12a | E1a |
| I5a | M14a | M14a | E1a |
| I7a | M1b | M1b | E2a |
| I7b | M1a | M1a | E2c |
| I8a | M1a | M2c | E2c |
| I9a | M7a | M7a | E2b |
| I10a | M12a | M12a | E2a |
| I11a | M13a | M13a | E2a |
| I12a | M1b | M1b | E3a |
| I13a | M13a | M13a | E3a |
| I14a | M1a | M1a | E4a |
| I15a | M2a | M2a | E4a |
| I15b | M2b | M2b | E4a |
| I16a | M14a | M14a | E4a |
| I17a | M3a | M3a | E5a |
| I18a | M12a | M12a | E5a |
| I19a | M6a | M6a | E6a |
| I20a | M10b | M10b | E6b |
| I22a | M2a | M2a | E7a |
| I24a | M1a | M1a | E8a |
| I24b | M1b | M1b | E8b |
| I24c | M1a | M1a | E8e |
| I24d | M1b | M1b | E8f |
| I25a | M2c | M2c | E8a |
| I25b | M2b | M2b | E8b |
| I25c | M2c | M2c | E8f |
| I26a | M4a | M4a | E8c |
| I27a | M5a | M5a | E8d |
| I28a | M10a | M10a | E8c |
| I29a | M12a | M12a | E8b |
| I30a | M14a | M14a | E8e |
| I31a | M1a | M1a | E9b |
| I32a | M8a | M8a | E9a |
| I33a | M13a | M13a | E9a |
| I34a | M10c | M10c | E10a |
| I36a | M17a | M17a | E11a |
| I37a | M7a | M7a | E12a |
| I39a | M23a | M23a | E1a |
| I39b | M23b | M23b | E1a |
| I40a | M1a | M21a | E2c |
| I40b | M1b | M21a | E2a |
| I41a | M20a | M20a | E8b |
| I41b | M20b | M20b | E8c |

Eine Auswahl möglicher Struktureinheiten der Formeln (VIIIa) und (VIIIb) ist in der folgenden Tabelle 3 aufgeführt.

**Tabelle 3**

| Formel (VIIIa) | Ar⁵ | Ar⁶ | Ar⁷ | Ar⁸ | Ar⁹ |
|---|---|---|---|---|---|
| Formel (VIIIb) | Ar⁵ | Ar⁶ | Ar⁷ | Ar⁸ | Ar⁹ |
| VIII1 | E1 | M1 | M1 | E1 | M1 |
| VIII2 | E1 | M1 | M1 | E1 | M2 |
| VIII3 | E1 | M1 | M1 | E1 | M10 |
| VIII4 | E1 | M1 | M1 | E1 | M13 |
| VIII5 | E1 | M1 | M1 | E1 | M14 |
| VIII6 | E1 | M14 | M14 | E1 | M12 |
| VIII7 | E2 | M1 | M1 | E2 | M2 |
| VIII8 | E2 | M2 | M2 | E2 | M12 |
| VIII9 | E3 | M7 | M7 | E3 | M1 |
| VIII10 | E3 | M10 | M10 | E3 | M16 |
| VIII11 | E4 | M1 | M1 | E4 | M7 |
| VIII12 | E4 | M1 | M1 | E4 | M12 |
| VIII13 | E4 | M2 | M2 | E4 | M14 |
| VIII14 | E4 | M10 | M10 | E4 | M13 |
| VIII15 | E4 | M1 | M1 | E8 | M7 |
| VIII16 | E5 | M2 | M13 | E5 | M13 |
| VIII17 | E6 | M3 | M3 | E6 | M6 |
| VIII18 | E6 | M17 | M17 | E6 | M10 |
| VIII19 | E7 | M5 | M5 | E7 | M4 |
| VIII20 | E8 | M1 | M1 | E8 | M1 |
| VIII21 | E8 | M1 | M1 | E8 | M2 |
| VIII22 | E8 | M1 | M1 | E8 | M12 |
| VIII23 | E8 | M2 | M2 | E8 | M10 |
| VIII24 | E8 | M6 | M6 | E8 | M8 |
| VIII25 | E8 | M10 | M10 | E8 | M7 |
| VIII26 | E8 | M13 | M13 | E8 | M2 |
| VIII27 | E8 | M14 | M14 | E8 | M12 |
| VIII28 | E9 | M1 | M1 | E9 | M2 |
| VIII29 | E9 | M9 | M9 | E9 | M11 |
| VIII30 | E9 | M19 | M19 | E9 | M18 |
| VIII31 | E10 | M1 | M1 | E10 | M4 |
| VIII32 | E11 | M2 | M2 | E11 | M10 |
| VIII33 | E11 | M13 | M13 | E11 | M15 |
| VIII34 | E12 | M7 | M7 | E12 | M14 |
| VIII35 | E2 | M1 | M1 | E2 | M14 |
| VIII36 | E2 | M1 | M1 | E2 | M12 |
| VIII37 | E8 | M1 | M1 | E8 | M20 |
| VIII38 | E9 | M1 | M1 | E9 | M23 |

Eine weitere Auswahl möglicher Struktureinheiten der Formel (VIIIa) bzw. (VIIIb) ist in der folgenden Tabelle 4 aufgeführt.

**Tabelle 4**

| Formel (VIIIa) | Ar⁵ | Ar⁶ | Ar⁷ | Ar⁸ | Ar⁹ |
|---|---|---|---|---|---|
| Formel (VIIIb) | Ar⁵ | Ar⁶ | Ar⁷ | Ar⁸ | Ar⁹ |
| VIII1a | E1a | M1a | M1a | E1a | M1a |
| VIII1b | E1a | M1b | M1b | E1a | M1b |
| VIII2a | E1a | M1a | M1a | E1a | M2a |
| VIII3a | E1a | M1a | M1a | E1a | M10a |
| VIII4a | E1a | M1a | M1a | E1a | M13a |
| VIII4b | E1a | M1b | M1b | E1a | M13a |
| VIII5a | E1a | M1a | M1a | E1a | M14a |
| VIII6a | E1a | M14a | M14a | E1a | M12a |
| VIII7a | E2a | M1a | M1a | E2a | M2a |
| VIII7b | E2c | M1a | M1a | E2c | M2a |
| VIII8a | E2b | M2b | M2b | E2b | M12a |
| VIII9a | E3a | M7a | M7a | E3a | M1b |
| VIII11a | E4a | M1b | M1b | E4a | M7a |
| VIII12a | E4a | M1b | M1b | E4a | M12a |
| VIII13a | E4a | M2b | M2b | E4a | M14a |
| VIII14a | E4a | M10a | M10a | E4a | M13a |
| VIII15a | E4a | M1b | M1b | E8a | M7a |
| VIII16a | E5a | M2c | M13a | E5a | M13a |
| VIII17a | E6a | M3a | M3a | E6a | M6a |
| VIII18a | E6b | M17a | M17a | E6b | M10b |
| VIII19a | E7a | M5a | M5a | E7a | M4a |
| VIII20a | E8f | M1a | M1a | E8f | M1a |
| VIII21a | E8b | M1a | M1a | E8b | M2a |
| VIII21b | E8e | M1a | M1a | E8e | M2a |
| VIII22a | E8b | M1b | M1b | E8b | M12a |
| VIII23a | E8d | M2b | M2b | E8d | M10c |
| VIII24a | E8f | M6a | M6a | E8f | M8a |
| VIII25a | E8a | M10a | M10a | E8a | M7a |
| VIII26a | E8c | M13a | M13a | E8c | M2c |
| VIII27a | E8b | M14a | M14a | E8b | M12a |
| VIII28a | E9a | M1a | M1a | E9a | M2a |
| VIII28b | E9b | M1a | M1a | E9b | M2a |
| VIII31a | E10a | M1b | M1b | E10a | M4a |
| VIII32a | E11a | M2c | M2c | E11a | M10c |
| VIII34a | E12a | M7a | M7a | E12a | M14a |
| VIII35a | E2a | M1a | M1a | E2a | M14a |
| VIII35b | E2c | M1a | M1a | E2c | M14a |
| VIII36a | E2c | M1a | M1a | E2c | M12a |
| VIII37a | E8b | M1a | M1a | E8b | M20a |
| VIII37b | E8e | M1a | M1a | E8e | M20b |
| VIII38a | E9a | M1b | M1b | E9a | M23a |
| VIII38b | E9b | M1b | M1b | E9b | M23b |

Wie oben beschrieben, handelt es sich bei der vernetzbaren Gruppe Q um eine funktionelle Gruppe, die in der Lage ist, eine chemische Reaktion einzugehen und so eine unlösliche polymere Verbindung zu bilden. Es können generell alle Gruppen Q eingesetzt werden, die dem Fachmann für diesen Zweck bekannt sind. Es ist insbesondere die Aufgabe dieser Gruppe, durch eine Vernetzungsreaktion die erfindungsgemäßen polymeren Verbindungen, gegebenenfalls mit weiteren reaktiven polymeren Verbindungen, miteinander zu verknüpfen. Dies führt zu einer vernetzten Verbindung, bzw., wenn die Reaktion in einer Schicht durchgeführt wird, zu einer vernetzten Schicht. Unter einer vernetzten Schicht im Sinne der vorliegenden Erfindung wird eine Schicht verstanden, die erhältlich ist durch Durchführung der Vernetzungsreaktion aus einer Schicht der erfindungsgemäßen, vernetzbaren, polymeren Verbindung. Die Vernetzungsreaktion kann im Allgemeinen durch Wärme und/oder durch UV-, Mikrowellen-, Röntgen- oder Elektronenstrahlung und/oder durch den Einsatz von Radikalbildnern, Anionen, Kationen, Säuren und/oder Photosäuren initiiert werden. Ebenso kann die Anwesenheit von Katalysatoren sinnvoll oder notwendig sein. Bevorzugt ist die Vernetzungsreaktion eine Reaktion, für die kein Initiator und kein Katalysator zugesetzt werden muss.

Erfindungsgemäß bevorzugte vernetzbare Gruppen Q sind die im Folgenden aufgeführten Gruppen:
a) Endständige oder cyclische Alkenyl- bzw. endständige Dienyl- und Alkinylgruppen:
   Geeignet sind Einheiten, die eine endständige oder cyclische Doppelbindung, eine endständige Dienylgruppe oder eine endständige Dreifachbindung enthalten, insbesondere endständige oder cyclische Alkenyl-, endständige Dienyl- bzw. endständige Alkinylgruppen mit 2 bis 40 C-Atomen, vorzugsweise mit 2 bis 10 C-Atomen, wobei auch einzelne CH₂-Gruppen und/oder einzelne H-Atome durch die oben genannten Gruppen R ersetzt sein können. Weiterhin eignen sich auch Gruppen, die als Vorstufen zu betrachten sind und die in situ zu einer Bildung einer Doppel- oder Dreifachbindung in der Lage sind.
b) Alkenyloxy-, Dienyloxy- bzw. Alkinyloxygruppen:
   Weiterhin geeignet sind Alkenyloxy-, Dienyloxy- bzw. Alkinyloxygruppen, vorzugsweise Alkenyloxygruppen.
c) Acrylsäuregruppen:
   Weiterhin geeignet sind Acrylsäureeinheiten im weitesten Sinne, vorzugsweise Acrylester, Acrylamide, Methacrylester und Methacrylamide. Besonders bevorzugt sind C₁-₁o-Alkylacrylat und C₁₋₁₀-Alkylmethacrylat.
   Die Vernetzungsreaktion der oben unter a) bis c) genannten Gruppen kann über einen radikalischen, einen kationischen oder einen anionischen Mechanismus aber auch über Cycloaddition erfolgen.
   Es kann sinnvoll sein, einen entsprechenden Initiator für die Vernetzungsreaktion zuzugeben. Geeignete Initiatoren für die radikalische Vernetzung sind beispielsweise Dibenzoylperoxid, AIBN oder TEMPO. Geeignete Initiatoren für die kationische Vernetzung sind beispielsweise AlCl₃, BF₃, Triphenylmethylperchlorat oder Tropyliumhexachlorantimonat. Geeignete Initiatoren für die anionische Vernetzung sind Basen, insbesondere Butyllithium.
   In einer bevorzugten Ausführungsform der vorliegenden Erfindung wird die Vernetzung jedoch ohne den Zusatz eines Initiators durchgeführt und ausschließlich thermisch initiiert. Diese Bevorzugung wird dadurch begründet, dass die Abwesenheit des Initiators Verunreinigungen der Schicht verhindert, die zu einer Verschlechterung der Deviceeigenschaften führen könnten.
d) Oxetane und Oxirane:
   Eine weitere geeignete Klasse vernetzbarer Gruppen Q sind Oxetane und Oxirane, die durch Ringöffnung kationisch vernetzen.
   Es kann sinnvoll sein, einen entsprechenden Initiator für die Vernetzungsreaktion zuzugeben. Geeignete Initiatoren sind beispielsweise AlCl₃, BF₃, Triphenylmethylperchlorat oder Tropyliumhexachlorantimonat. Ebenso können Photosäuren als Initiatoren zugegeben werden.
e) Silane:
   Weiterhin geeignet als Klasse vernetzbarer Gruppen sind Silangruppen SiR₃, wobei mindestens zwei Gruppen R, bevorzugt alle drei Gruppen R für Cl oder eine Alkoxygruppe mit 1 bis 20 C-Atomen stehen. Diese Gruppe reagiert in der Anwesenheit von Wasser zu einem Oligo- oder Polysiloxan.
f) Cyclobutangruppen
   Die oben genannten vernetzbaren Gruppen Q sind dem Fachmann generell bekannt, ebenso wie die geeigneten Reaktionsbedingungen, die zur Reaktion dieser Gruppen verwendet werden.

Bevorzugte vernetzbare Gruppen Q umfassen Alkenylgruppen der folgenden Formel Q1, Dienylgruppen der folgenden Formel Q2, Alkinylgruppen der folgenden Formel Q3, Alkenyloxygruppen der folgenden Formel Q4, Dienyloxygruppen der folgenden Formeln Q5, Alkinyloxygruppen der folgenden Formel Q6, Acrylsäuregruppen der folgenden Formeln Q7 und Q8, Oxetangruppen der folgenden Formeln Q9 und Q10, Oxirangruppen der folgenden Formel Q 11 und Cyclobutangruppen der folgenden Formel Q12:

| | |
|---|---|
| 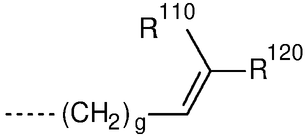 | 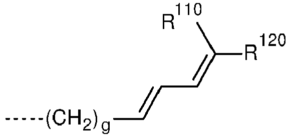 |
| Q1 | Q2 |
| 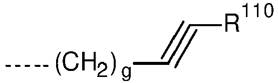 | 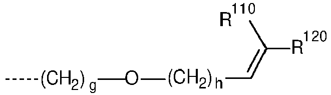 |
| Q3 | Q4 |
| 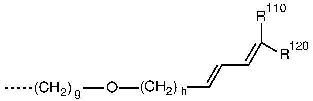 | 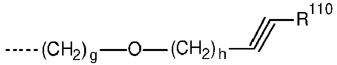 |
| Q5 | Q6 |
| 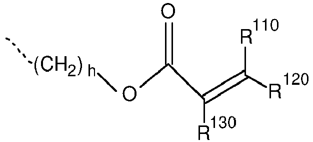 | 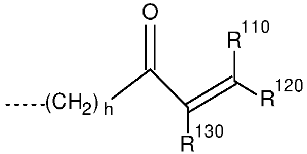 |
| Q7 | Q8 |
| 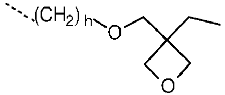 | 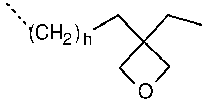 |
| Q9 | Q10 |
| 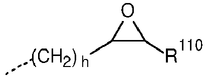 | 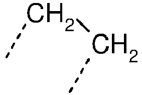 |
| Q11 | Q12 |

Die Reste R¹¹⁰, R¹²⁰ und R¹³⁰ in den Formeln Q1 bis Q8 und Q11 sind bei jedem Auftreten, gleich oder verschieden, H, eine geradkettige oder verzweigte Alkylgruppe mit 1 bis 6 C-Atomen, vorzugsweise 1 bis 4 C-Atomen. Besonders bevorzugt sind die Reste R¹¹⁰, R¹²⁰ und R¹³⁰ H, Methyl, Ethyl, n-Propyl, iso-Propyl, n-Butyl, sec-Butyl oder tert-Butyl und ganz besonders bevorzugt H oder Methyl. Die verwendeten Indices haben die folgende Bedeutung: g = 0 bis 8; und h = 1 bis 8.

Die gestrichelte Bindung in den Formeln Q1 bis Q11 sowie die gestrichelten Bindungen in der Formel Q12 stellen die Anknüpfung der vernetzbaren Gruppe an die Struktureinheiten dar.

Die vernetzbaren Gruppen der Formeln Q1 bis Q12 können dabei direkt mit der Struktureinheit verknüpft sein, oder aber indirekt, über ein weiteres, mono- oder polycyclisches, aromatisches oder heteroaromatisches Ringsystem Ar¹⁰, wie in den folgenden Formeln Q13 bis Q24 dargestellt:

| | |
|---|---|
| 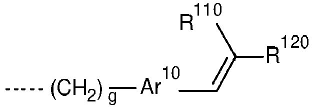 | 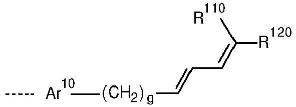 |
| Q13 | Q14 |
| 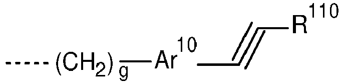 | 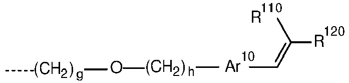 |
| Q15 | Q16 |
| 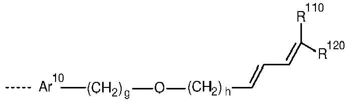 | 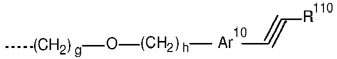 |
| Q17 | Q18 |
| 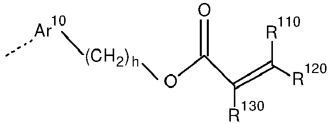 | 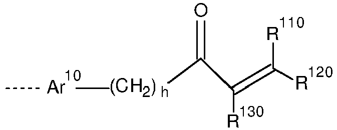 |
| Q19 | Q20 |
| 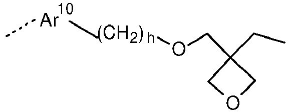 | 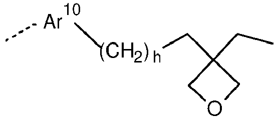 |
| Q21 | Q22 |
| 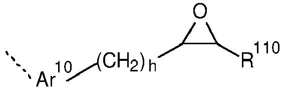 | 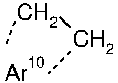 |
| Q23 | Q24 |

wobei Ar¹⁰ in den Formeln Q13 bis Q24 die gleichen Bedeutungen annehmen kann wie der für Formel (I) näher beschreibene Rest Ar¹. Die verwendeten Indices haben die folgende Bedeutung: g = 0 bis 8; und h = 1 bis 8.

Besonders bevorzugte vernetzbare Gruppen Q sind die folgenden:

| | |
|---|---|
| 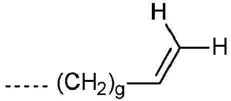 | 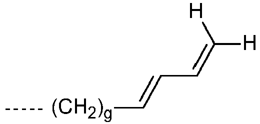 |
| Q1a | Q2a |
| 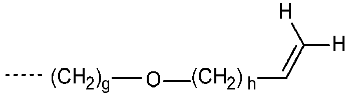 | 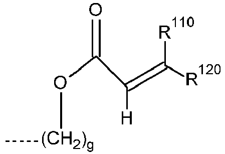 |
| Q4a | Q7a |
| 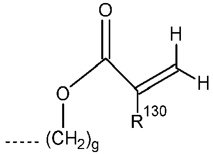 | 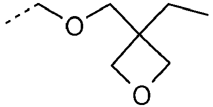 |
| Q7b | Q9a |
| 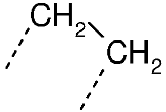 | 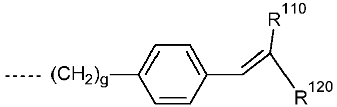 |
| Q12a | Q13a |
| 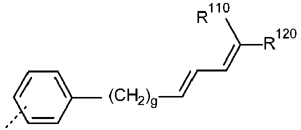 | 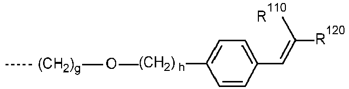 |
| Q14a | Q16a |
| 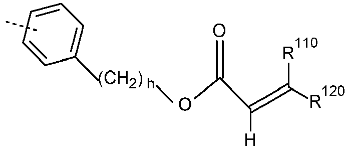 | 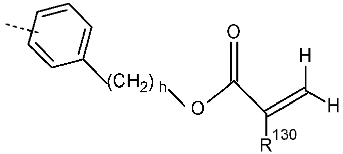 |
| Q19a | Q19b |
| 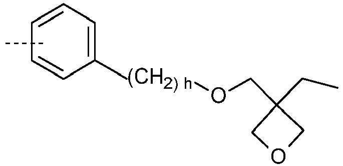 | 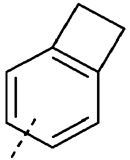 |
| Q21a | Q24a |

Die verwendeten Indices haben die folgende Bedeutung: g = 0 bis 8 und h = 1 bis 8.

Die Reste R¹¹⁰ und R¹²⁰ in den Formeln Q7a und Q13a bis Q19a sind bei jedem Auftreten, gleich oder verschieden, H oder eine geradkettige oder verzweigte Alkylgruppe mit 1 bis 6 C-Atomen, vorzugsweise 1 bis 4 C-Atomen. Besonders bevorzugt sind die Reste R¹¹⁰ und R¹²⁰ Methyl, Ethyl, n-Propyl, iso-Propyl, n-Butyl, sec-Butyl oder tert-Butyl und ganz besonders bevorzugt Methyl.

Der Rest R¹³⁰ in den Formeln Q7b und Q19b ist bei jedem Auftreten eine geradkettige oder verzweigte Alkylgruppe mit 1 bis 6 C-Atomen, vorzugsweise 1 bis 4 C-Atomen. Besonders bevorzugt ist der Rest R¹³⁰ Methyl, Ethyl, n-Propyl, iso-Propyl, n-Butyl, sec-Butyl oder tert-Butyl und ganz besonders bevorzugt Methyl.

Ganz besonders bevorzugte vernetzbare Gruppen Q sind die folgenden:

| | |
|---|---|
| 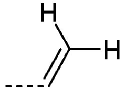 | 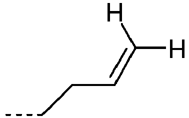 |
| Q1b | Q1c |
| 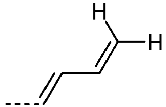 | 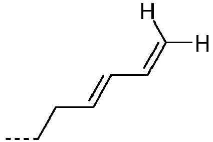 |
| Q2b | Q2c |
| 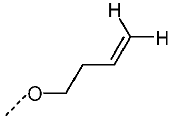 | 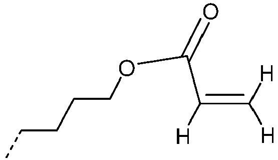 |
| Q4b | Q7c |
| 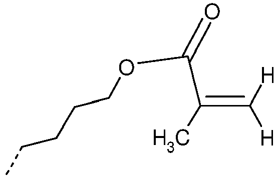 | 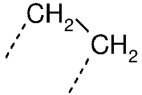 |
| Q7d | Q12b |
| 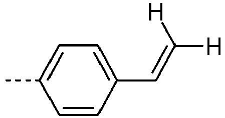 | 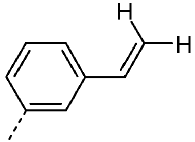 |
| Q13b | Q13c |
| 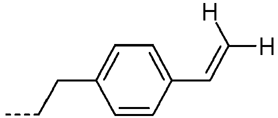 | 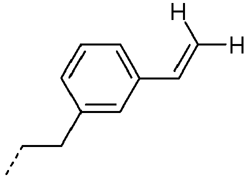 |
| Q13d | Q13e |
| 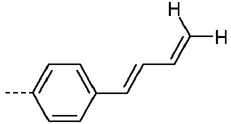 | 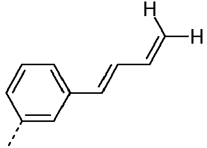 |
| Q14b | Q14c |
| 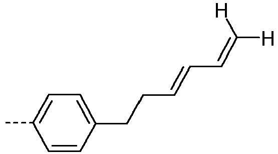 | 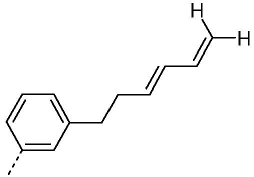 |
| Q14d | Q14e |
| 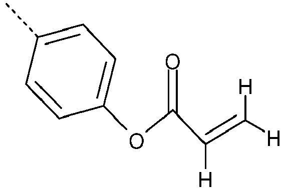 | 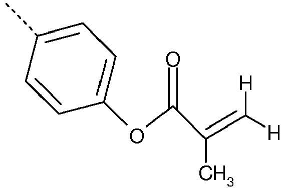 |
| Q19c | Q19d |
| 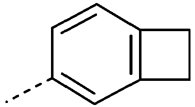 | 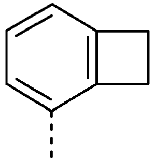 |
| Q24b | Q24c |

In den bevorzugten Gruppen Q1 bis Q24, in den besonders bevorzugten Gruppen Q1a bis Q24a sowie in den ganz besonders bevorzugten Gruppen Q1b bis Q24c stellen die gestrichelten Linien die Bindungen zu den Struktureinheiten dar. Anzumerken ist in diesem Zusammenhang, dass die Gruppen Q12, Q12a, Q12b und Q24 jeweils zwei Bindungen zu zwei benachbarten Ring-Kohlenstoffatomen der Struktureinheit aufweisen. Alle anderen vernetzbaren Gruppen weisen lediglich eine Bindung zu der Struktureinheit auf.

Die Struktureinheit, die die vernetzbare Gruppe Q trägt, kann dabei in einer ersten Ausführungsform ausgewählt werden aus den Struktureinheiten der Formel (I), (Ia), (Ib), (II), (III), (IV), (V), (VI), (VII), (VIIIa), (Vlllb), (IX), (X), (XI), (XII), (XIII), (XIV), (XV), (XVI) und/oder einer bevorzugten Ausgestaltung dieser Struktureinheiten.

Eine bevorzugte Struktureinheit, die die vernetzbare Gruppe Q tragen, ist die folgende, aus den Triarylamineinheiten der Gruppe 1 abgeleitete Struktureinheit der Formel (XVII): 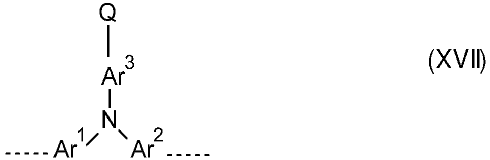 wobei Ar¹, Ar² Ar³, und die gestrichelten Linien die oben, insbesondere in Bezug auf Formel (I) angegebenen Bedeutungen annehmen können und Q eine vernetzbare Gruppe darstellt.

Beispiele für bevorzugte Struktureinheiten der Formel (XVII) sind in der folgenden Tabelle abgebildet:

| | | |
|---|---|---|
| 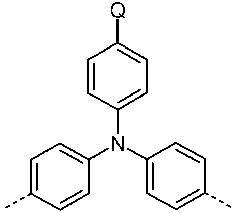 | 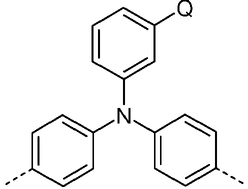 | |
| (17a) | (17b) | |

worin Q eine vernetzbare Gruppe darstellt und die gestrichelten Linien die oben, insbesondere in Bezug auf Formel (I) angegebene Bedeutung annehmen kann.

Bevorzugte Struktureinheiten, die die vernetzbare Gruppe Q tragen, sind die folgenden, aus der Struktureinheit der Formel (Ia) abgeleiteten Struktureinheiten der Formeln (XVIIIa1) bis (XVIIIa3): 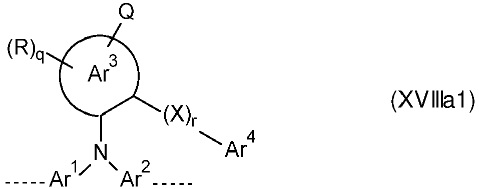 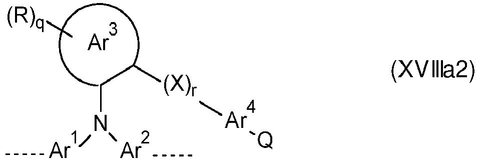 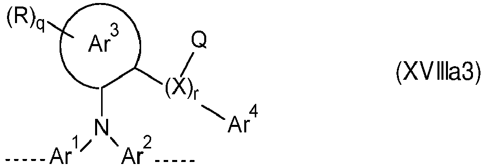 wobei Ar¹, Ar², Ar³, Ar⁴, R, q, r, X und r die oben, insbesondere in Bezug auf Formel (Ia) angegebenen Bedeutungen annehmen können, Q eine vernetzbare Gruppe darstellt und die gestrichelten Linien die oben, insbesondere in Bezug auf Formel (I) angegebene Bedeutung annehmen kann.

Beispiele für bevorzugte Struktureinheiten der Formel (XVIIIa) sind in der folgenden Tabelle abgebildet:

| | | |
|---|---|---|
| 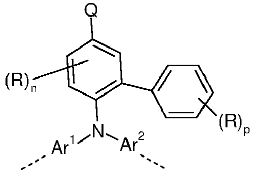 | 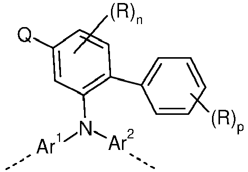 | 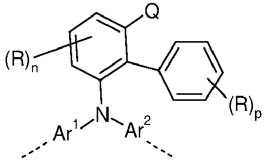 |
| (18a) | (18b) | (18c) |
| 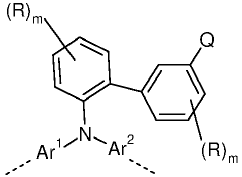 | 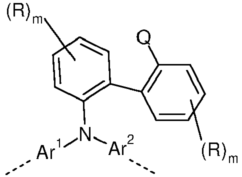 | 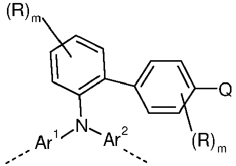 |
| (18d) | (18e) | (18f) |

wobei R, m, n, p und die gestrichelten Linien die oben, insbesondere in Bezug auf Formeln (I) und (Ib) angegebenen Bedeutungen annehmen können und Q eine vernetzbare Gruppe darstellt.

Weitere bevorzugte Struktureinheiten, die die vernetzbare Gruppe Q tragen, sind die folgenden, aus der Struktureinheit der Formel (Ib) abgeleiteten Struktureinheiten der Formeln (XVIIIb1) bis (XVIII1b4): 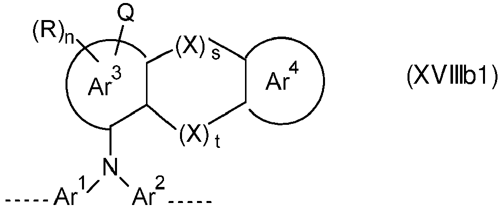 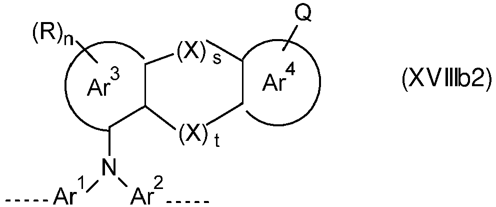 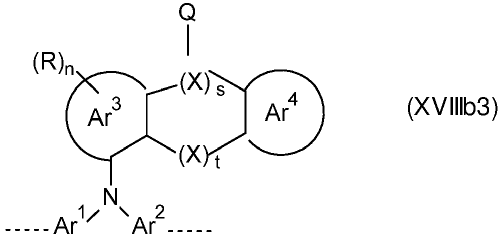 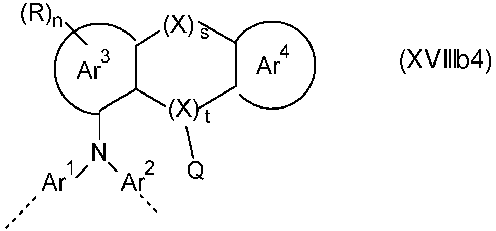 wobei Ar¹, Ar², Ar³, Ar⁴, R n, X, s und t die oben, insbesondere in Bezug auf Formel (Ib) angegebenen Bedeutungen annehmen können.

Beispiele für bevorzugte Struktureinheiten der Formel (XVIIIb) sind in der folgenden Tabelle abgebildet:

| | | |
|---|---|---|
| 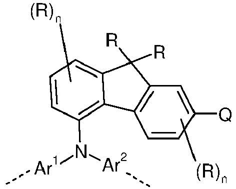 | 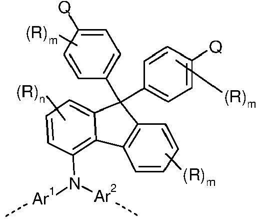 | 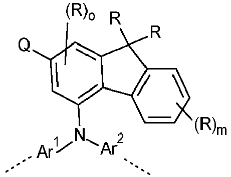 |
| (18g) | (18h) | (18i) |
| 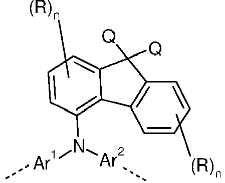 | 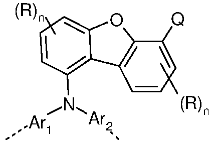 | 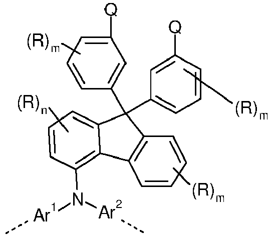 |
| (18j) | (18k) | (18l) |
| 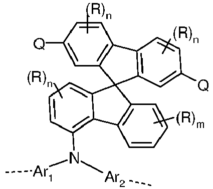 | 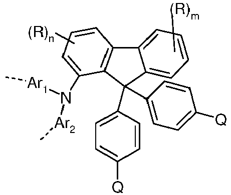 | 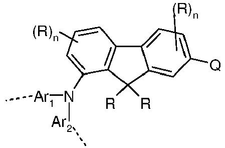 |
| (18m) | (18n) | (18o) |

wobei R, m, n und p die oben, insbesondere in Bezug auf Formel (Ib) angegebenen Bedeutungen annehmen können und o = 0, 1 oder 2 ist.

In den Formeln (18g) bis (18o) stellen die gestrichelten Linien mögliche Bindungen zu den benachbarten Struktureinheiten im Polymer dar. Sofern in den Formeln zwei gestrichelte Linien vorhanden sind, weist die Struktureinheit ein oder zwei, vorzugsweise zwei, Bindungen zu benachbarten Struktureinheiten auf.

Im Folgenden wird die Anbindung der vernetzbaren Gruppe Q im Detail in Bezug auf die Anbindung an Ar³, die besonders bevorzugte Ausführungsform, beschrieben. Die gleichen Aussagen gelten aber auch für Ar⁵ und Ar⁸ in Formel (VIIIa) sowie für Ar⁵ und Ar⁸ in Formel (VIIIb).

Die bevorzugten vernetzbaren Gruppen Q1 bis Q24 sind dabei vorzugsweise an die bevorzugten Gruppen E1 bis E12 von Ar³ gebunden. Die besonders bevorzugten Gruppen Q1 a bis Q24a sind dabei vorzugsweise an die besonders bevorzugten Gruppen E1a bis E12a von Ar³ gebunden.

Bevorzugte vernetzbare, mono- oder polycyclische, aromatische oder heteroaromatische Gruppen Ar³ in Formel (I), Ar⁴ in Formeln (Ia), (Ib), (II), (III), (IV), (V), (VI), (VII), (VIIIa), (VIIIb), (IX), (X), (XI), (XII), (XIII), (XIV), (XV) und/oder (XVI); Ar⁵ und Ar⁸ in Formeln (VIIIa) und/oder (VIIIb), sowie deren bevorzugten Ausführungsformen sind die folgenden:

| | | |
|---|---|---|
| 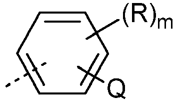 | 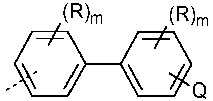 | 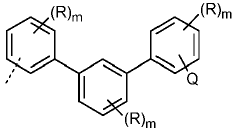 |
| VE1 | VE2 | VE3 |
| 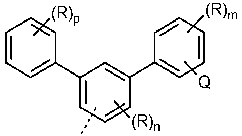 | 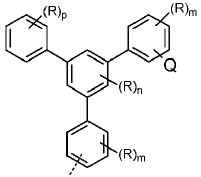 | 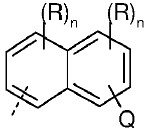 |
| VE4 | VE5 | VE6 |
| 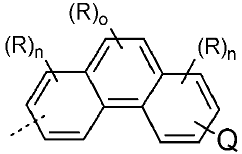 | 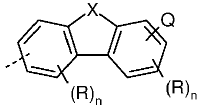 | 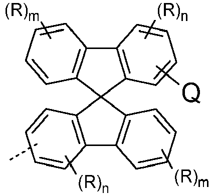 |
| VE7 | VE8 | VE9 |
| 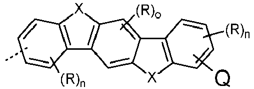 | 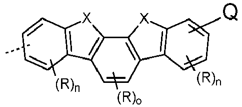 | 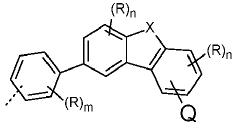 |
| VE10 | VE11 | VE12 |

Die Reste R in den Formeln VE1 bis VE12 können dabei die gleiche Bedeutung annehmen, wie die Reste R in den Formeln (I) und (II). X kann CR₂, SiR₂, NR, O oder S bedeuten, wobei auch hier R die gleiche Bedeutung annehmen kann, wie die Reste R in den Formeln (I) und (II).

Die verwendeten Indices haben die folgende Bedeutung:
o = 0, 1 oder 2;
n = 0, 1, 2 oder 3;
m = 0, 1, 2, 3 oder 4; und
p = 0, 1, 2, 3, 4 oder 5.

Besonders bevorzugte vernetzbare, mono- oder polycyclische, aromatische oder heteroaromatische Gruppen Ar¹ und Ar² in Formel (I), Ar⁶, Ar⁷ und Ar⁹ in Formeln (VIIIa) und/oder (VIIIb) sind die folgenden:

| | | |
|---|---|---|
| 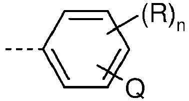 | | |
| VE1a | | |
| 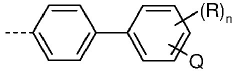 | 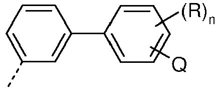 | 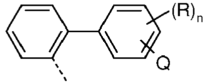 |
| VE2a | VE2b | VE2c |
| 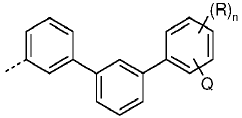 | 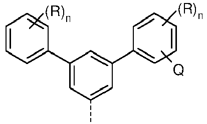 | 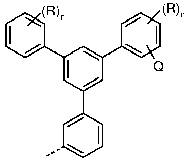 |
| VE3a | VE4a | VE5a |
| 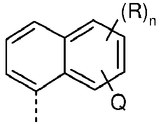 | 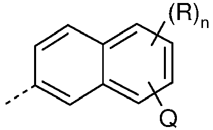 | 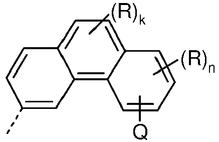 |
| VE6a | VE6b | VE7a |
| 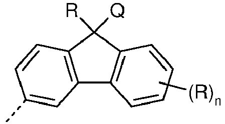 | 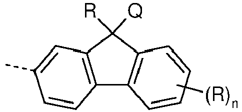 | 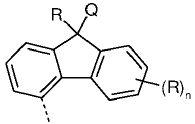 |
| VE8a | VE8b | VE8c |
| 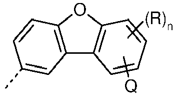 | 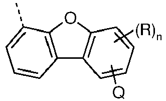 | 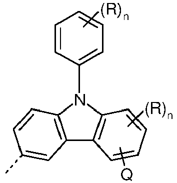 |
| VE8d | VE8e | VE8f |
| 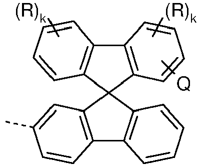 | 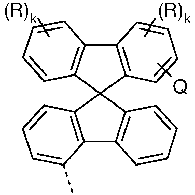 | |
| VE9a | VE9b | |
| 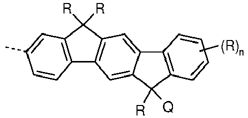 | 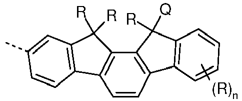 | 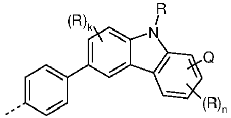 |
| VE10a | VE11a | VE12a |

Die Reste R in den Formeln VE1a bis VE12a können dabei die gleiche Bedeutung annehmen, wie die Reste R in der Formel (I). Darüber hinaus kann auch mindestens einer der Reste R die Bedeutung Q annehmen, das heißt, eine weitere vernetzbare Gruppe Q in den Gruppen Ar³ bedeuten.

Die verwendeten Indices haben die folgende Bedeutung:
k = 0 oder 1; und
n = 0, 1, 2 oder 3.

Eine Auswahl bevorzugter, vernetzbarer Struktureinheiten der Formel (XVII) ist in der folgenden Tabelle 6 aufgeführt.

**Tabelle 6**

| Formel (I) | Ar³ | Q | Ar¹ | Ar² |
|---|---|---|---|---|
| XVII 1 | VE1 | Q1 | M1 | M1 |
| XVII 2 | VE1 | Q14 | M2 | M2 |
| XVII 3 | VE1 | Q7 | M10 | M10 |
| XVII 4 | VE1 | Q2 | M12 | M12 |
| XVII 5 | VE1 | Q2 | M14 | M14 |
| XVII 6 | VE1 | Q10 | M19 | M19 |
| XVII 7 | VE2 | Q13 | M1 | M1 |
| XVII 8 | VE2 | Q24 | M2 | M1 |
| XVII 9 | VE2 | Q19 | M7 | M7 |
| XVII 10 | VE2 | Q2 | M12 | M12 |
| XVIII 11 | VE2 | Q13 | M13 | M13 |
| XVII 12 | VE3 | Q1 | M1 | M1 |
| XVII 13 | VE3 | Q14 | M13 | M13 |
| XVII 14 | VE4 | Q7 | M1 | M1 |
| XVII 15 | VE4 | Q19 | M2 | M2 |
| XVII 16 | VE4 | Q24 | M14 | M14 |
| XVII 17 | VE5 | Q16 | M3 | M3 |
| XVII 18 | VE5 | Q13 | M12 | M12 |
| XVII 19 | VE6 | Q9 | M6 | M6 |
| XVII 20 | VE6 | Q16 | M10 | M10 |
| XVII 21 | VE6 | Q3 | M16 | M16 |
| XVII 22 | VE7 | Q9 | M2 | M2 |
| XVII 23 | VE7 | Q20 | M15 | M15 |
| XVII 24 | VE8 | Q13 | M1 | M1 |
| XVII 25 | VE8 | Q19 | M2 | M2 |
| XVII 26 | VE8 | Q16 | M4 | M4 |
| XVII 27 | VE8 | Q21 | M5 | M5 |
| XVII 28 | VE8 | Q2 | M10 | M10 |
| XVII 29 | VE8 | Q24 | M12 | M12 |
| XVII 30 | VE8 | Q14 | M14 | M14 |
| XVII 31 | VE9 | Q4 | M1 | M1 |
| XVII 32 | VE9 | Q21 | M8 | M8 |
| XVII 33 | VE9 | Q1 | M13 | M13 |
| XVII 34 | VE10 | Q9 | M10 | M10 |
| XVII 35 | VE11 | Q5 | M9 | M9 |
| XVII 36 | VE11 | Q9 | M17 | M17 |
| XVII 37 | VE12 | Q1 | M7 | M7 |
| XVII 38 | VE12 | Q12 | M18 | M18 |
| XVII 39 | VE1 | Q12 | M1 | M1 |

Besonders bevorzugt als vernetzbare Struktureinheiten der Formel (XVII) sind Struktureinheiten in denen Ar³ ausgewählt ist aus den Gruppen der Formeln VE1a bis VE12a, Ar¹ sowie Ar² ausgewählt sind aus den Gruppen der Formeln M1a bis M17a, wobei es besonders bevorzugt ist, wenn Ar¹ und Ar² gleich sind, und Q ausgewählt ist aus den Gruppen Q1a bis Q24a.

Eine Auswahl besonders bevorzugter, vernetzbarer Struktureinheiten der Formel (XVII) ist in der folgenden Tabelle 7 aufgeführt.

**Tabelle 7**

| Formel (I) | Ar³ | Q | Ar¹ | Ar² |
|---|---|---|---|---|
| XVII 1a | VE1a | Q1a | M1a | M1a |
| XVII 2a | VE1a | Q14a | M2a | M2a |
| XVII 2b | VE1a | Q14a | M2c | M2c |
| XVII 3a | VE1a | Q7a | M10a | M10a |
| XVII 4a | VE1a | Q2a | M12a | M12a |
| XVII 5a | VE1a | Q2a | M14a | M14a |
| XVII 7a | VE2a | Q13a | M1b | M1b |
| XVII 7b | VE2c | Q13b | M1a | M1a |
| XVII 8a | VE2c | Q24a | M2c | M1a |
| XVII 9a | VE2b | Q19b | M7a | M7a |
| XVII 10a | VE2a | Q2a | M12a | M12a |
| XVII 11a | VE2a | Q13a | M13a | M13a |
| XVII 12a | VE3a | Q1a | M1b | M1b |
| XVII 13a | VE3a | Q14a | M13a | M13a |
| XVII 14a | VE4a | Q7b | M1a | M1a |
| XVII 15a | VE4a | Q19a | M2a | M2a |
| XVII 15b | VE4a | Q19b | M2b | M2b |
| XVII 16a | VE4a | Q24a | M14a | M14a |
| XVII 17a | VE5a | Q16a | M3a | M3a |
| XVII 18a | VE5a | Q13a | M12a | M12a |
| XVII 19a | VE6a | Q9a | M6a | M6a |
| XVII 20a | VE6b | Q16a | M10b | M10b |
| XVII 22a | VE7a | Q9a | M2a | M2a |
| XVII 24a | VE8a | Q13a | M1a | M1a |
| XVII 24b | VE8b | Q13a | M1b | M1b |
| XVII 24c | VE8e | Q13a | M1a | M1a |
| XVII 24d | VE8f | Q13a | M1b | M1b |
| XVII 25a | VE8a | Q19b | M2c | M2c |
| XVII 25b | VE8b | Q19b | M2b | M2b |
| XVII 25c | VE8f | Q19a | M2c | M2c |
| XVII 26a | VE8c | Q16a | M4a | M4a |
| XVII 27a | VE8d | Q21a | M5a | M5a |
| XVII 28a | VE8c | Q2a | M10a | M10a |
| XVII 29a | VE8b | Q24a | M12a | M12a |
| XVII 30a | VE8e | Q14a | M14a | M14a |
| XVII 31a | VE9b | Q4a | M1a | M1a |
| XVII 32a | VE9a | Q21a | M8a | M8a |
| XVII 33a | VE9a | Q1a | M13a | M13a |
| XVII 34a | VE10a | Q9a | M10c | M10c |
| XVII 36a | VE11a | Q9a | M17a | M17a |
| XVII 37a | VE12a | Q1a | M7a | M7a |
| XVII 39a | VE1a | Q12a | M1a | M1a |

Bevorzugt als vernetzbare Struktureinheiten der Formel (VIIIva) 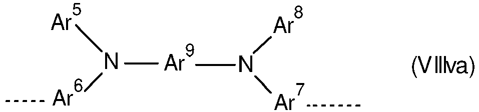 sind Struktureinheiten, in denen Ar⁵ ausgewählt ist aus den Gruppen der Formeln E1 bis E12, Ar⁶, Ar⁷ sowie Ar⁹, unabhängig voneinander, gleich oder verschieden, ausgewählt sind aus den Gruppen der Formeln M1 bis M19, wobei es besonders bevorzugt ist, wenn Ar⁶ und Ar⁷ gleich sind, Ar⁸ ausgewählt ist aus den Gruppen VE1 bis VE12 und Q ausgewählt ist aus den Gruppen Q1 bis Q24.

Bevorzugt als vernetzbare Struktureinheiten der Formel (VIIIvb) 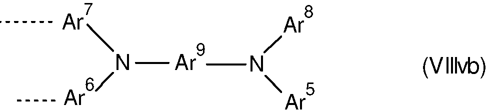 sind Struktureinheiten, in denen Ar⁵ ausgewählt ist aus den Gruppen der Formeln E1 bis E12, Ar⁶, Ar⁷ sowie Ar⁹, unabhängig voneinander, gleich oder verschieden, ausgewählt sind aus den Gruppen der Formeln M1 bis M19, wobei es besonders bevorzugt ist, wenn Ar⁴ und Ar⁵ gleich sind, Ar⁸ ausgewählt ist aus den Gruppen der Formeln VE1 bis VE12 und Q ausgewählt ist aus den Gruppen Q1 bis Q24.

Eine Auswahl bevorzugter Struktureinheiten der Formel (VIIIva) bzw. (VIIIvb) ist in der folgenden Tabelle 8 aufgeführt.

**Tabelle 8**

| Formel (VIIIva) | Ar⁵ | Ar⁸ | Q | Ar⁶ | Ar⁷ | Ar⁹ |
|---|---|---|---|---|---|---|
| Formel (VIIIvb) | Ar⁵ | Ar⁸ | Q | Ar⁶ | Ar⁷ | Ar⁹ |
| IIv1 | E1 | VE1 | Q1 | M1 | M1 | M1 |
| IIv2 | E1 | VE1 | Q13 | M1 | M1 | M2 |
| IIv3 | E1 | VE1 | Q19 | M1 | M1 | M10 |
| IIv4 | E1 | VE1 | Q2 | M1 | M1 | M13 |
| IIv5 | E1 | VE1 | Q13 | M1 | M1 | M14 |
| IIv6 | E1 | VE1 | Q24 | M14 | M14 | M12 |
| IIv7 | E2 | VE2 | Q13 | M1 | M1 | M2 |
| IIv8 | E2 | VE2 | Q7 | M2 | M2 | M12 |
| IIv9 | E3 | VE3 | Q4 | M7 | M7 | M1 |
| IIv10 | E3 | VE3 | Q22 | M10 | M10 | M16 |
| IIv11 | E4 | VE4 | Q4 | M1 | M1 | M7 |
| IIv12 | E4 | VE4 | Q1 | M1 | M1 | M12 |
| IIv13 | E4 | VE4 | Q14 | M2 | M2 | M14 |
| IIv14 | E4 | VE4 | Q24 | M10 | M10 | M13 |
| IIv15 | E4 | VE8 | Q19 | M1 | M1 | M7 |
| IIv16 | E5 | VE5 | Q14 | M2 | M13 | M13 |
| IIv17 | E6 | VE6 | Q21 | M3 | M3 | M6 |
| IIv18 | E6 | VE6 | Q16 | M17 | M17 | M10 |
| IIv19 | E7 | VE7 | Q9 | M5 | M5 | M4 |
| IIv20 | E8 | VE8 | Q14 | M1 | M1 | M1 |
| IIv21 | E8 | VE8 | Q19 | M1 | M1 | M2 |
| IIv22 | E8 | VE8 | Q1 | M1 | M1 | M12 |
| IIv23 | E8 | VE8 | Q9 | M2 | M2 | M10 |
| IIv24 | E8 | VE8 | Q21 | M6 | M6 | M8 |
| IIv25 | E8 | VE8 | Q7 | M10 | M10 | M7 |
| IIv26 | E8 | VE8 | Q13 | M13 | M13 | M2 |
| IIv27 | E8 | VE8 | Q7 | M14 | M14 | M12 |
| IIv28 | E9 | VE9 | Q24 | M1 | M1 | M2 |
| IIv29 | E9 | VE9 | Q22 | M9 | M9 | M11 |
| IIv30 | E9 | VE9 | Q12 | M19 | M19 | M18 |
| IIv31 | E10 | VE10 | Q9 | M1 | M1 | M4 |
| IIv32 | E11 | VE11 | Q16 | M2 | M2 | M10 |
| IIv33 | E11 | VE11 | Q8 | M13 | M13 | M15 |
| IIv34 | E12 | VE12 | Q14 | M7 | M7 | M14 |
| IIv35 | E1 | VE1 | Q12 | M1 | M1 | M2 |
| IIv36 | E2 | VE2 | Q1 | M1 | M1 | M14 |

Besonders bevorzugt als Struktureinheiten der Formel (VIIIva) sind Struktureinheiten in denen Ar⁵ ausgewählt ist aus den Gruppen der Formeln E1a bis E12a, Ar⁶, Ar⁷ sowie Ar⁹, unabhängig voneinander, gleich oder verschieden, ausgewählt sind aus den Gruppen der Formeln M1a bis M17a, wobei es besonders bevorzugt ist, wenn Ar⁶ und Ar⁷ gleich sind, Ar⁸ ausgewählt ist aus den Gruppen der Formeln VE1a bis VE12a und Q ausgewählt ist aus den Gruppen Q1a bis Q24a.

Besonders bevorzugt als Struktureinheiten der Formel (VIIIvb) sind Struktureinheiten in denen Ar⁵ ausgewählt ist aus den Gruppen der Formeln E1a bis E12a, Ar⁶, Ar⁷ sowie Ar⁹, unabhängig voneinander, gleich oder verschieden, ausgewählt sind aus den Gruppen der Formeln M1a bis M17a, wobei es besonders bevorzugt ist, wenn Ar⁶ und Ar⁷ gleich sind, Ar⁸ ausgewählt ist aus den Gruppen der Formeln VE1a bis VE12a und Q ausgewählt ist aus den Gruppen Q1a bis Q24a.

Eine Auswahl besonders bevorzugter Struktureinheiten der Formel (VIIIva) bzw. (VIIIvb) ist in der folgenden Tabelle 9 aufgeführt.

**Tabelle 9**

| Formel (VIIIa) | Ar⁵ | Ar⁸ | Q | Ar⁶ | Ar⁷ | Ar⁹ |
|---|---|---|---|---|---|---|
| Formel (VIIIb) | Ar⁵ | Ar⁸ | Q | Ar⁶ | Ar⁷ | Ar⁹ |
| IIv1a | E1a | VE1a | Q1a | M1a | M1a | M1a |
| IIv1b | E1a | VE1a | Q1a | M1b | M1b | M1b |
| IIv2a | E1a | VE1a | Q13a | M1a | M1a | M2a |
| IIv3a | E1a | VE1a | Q19b | M1a | M1a | M10a |
| IIv4a | E1a | VE1a | Q2a | M1a | M1a | M13a |
| IIv4b | E1a | VE1a | Q2a | M1b | M1b | M13a |
| IIv5a | E1a | VE1a | Q13a | M1a | M1a | M14a |
| IIv6a | E1a | VE1a | Q24a | M14a | M14a | M12a |
| IIv7a | E2a | VE2a | Q13a | M1a | M1a | M2a |
| IIv7b | E2c | VE2c | Q13a | M1a | M1a | M2a |
| IIv8a | E2b | VE2b | Q7b | M2b | M2b | M12a |
| IIv9a | E3a | VE3a | Q4a | M7a | M7a | M1b |
| IIv11a | E4a | VE4a | Q4a | M1b | M1b | M7a |
| IIv12a | E4a | VE4a | Q1a | M1b | M1b | M12a |
| IIv13a | E4a | VE4a | Q14a | M2b | M2b | M14a |
| IIv14a | E4a | VE4a | Q24a | M10a | M10a | M13a |
| IIv15a | E4a | VE8a | Q19b | M1b | M1b | M7a |
| IIv16a | E5a | VE5a | Q14a | M2c | M13a | M13a |
| IIv17a | E6a | VE6a | Q21a | M3a | M3a | M6a |
| IIv18a | E6b | VE6b | Q16a | M17a | M17a | M10b |
| IIv19a | E7a | VE7a | Q9a | M5a | M5a | M4a |
| IIv20a | E8f | VE8f | Q14a | M1a | M1a | M1a |
| IIv21a | E8b | VE8b | Q19a | M1a | M1a | M2a |
| IIv21b | E8e | VE8e | Q19b | M1a | M1a | M2a |
| IIv22a | E8b | VE8b | Q1a | M1b | M1b | M12a |
| IIv23a | E8d | VE8d | Q9a | M2b | M2b | M10c |
| IIv24a | E8f | VE8f | Q21a | M6a | M6a | M8a |
| IIv25a | E8a | VE8a | Q7a | M10a | M10a | M7a |
| IIv26a | E8c | VE8c | Q13a | M13a | M13a | M2c |
| IIv27a | E8b | VE8b | Q7a | M14a | M14a | M12a |
| IIv28a | E9a | VE9a | Q24a | M1a | M1a | M2a |
| IIv28b | E9b | VE9b | Q24a | M1a | M1a | M2a |
| IIv31a | E10a | VE10a | Q9a | M1b | M1b | M4a |
| IIv32a | E11a | VE11a | Q16a | M2c | M2c | M10c |
| IIv34a | E12a | VE12a | Q14a | M7a | M7a | M14a |
| IIv35a | E1a | VE1a | Q12a | M1a | M1a | M2a |
| IIv36a | E2a | VE2a | Q1a | M1a | M1a | M14a |

Der Anteil an Struktureinheiten der Formeln (la), (Ib), (II), (III), (IV), (V), (VI), (VII), (VIIIa), (VIIIb), (IX), (X), (XI), (XII), (XIII), (XIV), (XV) und/oder (XVI) im Polymer liegt im Bereich von 1 bis 100 mol%, vorzugsweise im Bereich von 25 bis 100 mol%, besonders bevorzugt im Bereich von 50 bis 95 mol%, bezogen auf 100 mol% aller copolymerisierten Monomere, die im Polymer als Struktureinheiten enthalten sind.

In einer ersten bevorzugten Ausführungsform enthält das erfindungsgemäße Polymer nur eine Struktureinheit der Formel (la), (Ib), (II), (III), (IV), (V), (VI), (VII), (VIIIa), (Vlllb), (IX), (X), (XI), (XII), (XIII), (XIV), (XV) oder (XVI), d.h. deren Anteil im Polymer beträgt 100 mol%. Es handelt sich in diesem Fall bei dem erfindungsgemäßen Polymer um ein Homopolymer.

In einer zweiten bevorzugten Ausführungsform liegt der Anteil an Struktureinheiten der Formel (la), (Ib), (II), (III), (IV), (V), (VI), (VII), (VIIIa), (Vlllb), (IX), (X), (XI), (XII), (XIII), (XIV), (XV) und/oder (XVI) im Polymer im Bereich von 50 bis 95 mol%, besonders bevorzugt im Bereich von 60 bis 95 mol%, bezogen auf 100 mol% aller copolymerisierbaren Monomere, die im Polymer als Struktureinheiten enthalten sind, d.h., dass das erfindungsgemäße Polymer neben einer oder mehrerer Struktureinheiten der Formel (la), (Ib), (II), (III), (IV), (V), (VI), (VII), (VIIIa), (Vlllb), (IX), (X), (XI), (XII), (XIII), (XIV), (XV) und/oder (XVI) noch weitere, von den Struktureinheiten der Formeln (la), (Ib), (II), (III), (IV), (V), (VI), (VII), (VIIIa), (Vlllb), (IX), (X), (XI), (XII), (XIII), (XIV), (XV) und/oder (XVI) verschiedene Struktureinheiten aufweist.

In einer dritten bevorzugten Ausführungsform liegt der Anteil an Struktureinheiten der Formel (la), (Ib), (II), (III), (IV), (V), (VI), (VII), (VIIIa), (Vlllb), (IX), (X), (XI), (XII), (XIII), (XIV), (XV) und/oder (XVI) im Polymer im Bereich von 5 bis 50 mol%, besonders bevorzugt im Bereich von 25 bis 50 mol%, bezogen auf 100 mol% aller copolymerisierbaren Monomere, die im Polymer als Struktureinheiten enthalten sind, d.h., dass das erfindungsgemäße Polymer neben einer oder mehrerer Struktureinheiten der Formel (la), (Ib), (II), (III), (IV), (V), (VI), (VII), (VIIIa), (Vlllb), (IX), (X), (XI), (XII), (XIII), (XIV), (XV) und/oder (XVI) noch weitere, von den Struktureinheiten der Formeln (la), (Ib), (II), (III), (IV), (V), (VI), (VII), (VIIIa), (Vlllb), (IX), (X), (XI), (XII), (XIII), (XIV), (XV) und/oder (XVI) verschiedene Struktureinheiten aufweist.

Der Anteil vernetzbarer Struktureinheiten im Polymer kann bevorzugt im Bereich von 0,01 bis 50 mol%, vorzugsweise im Bereich von 0,1 bis 30 mol%, besonders bevorzugt im Bereich von 0,5 bis 25 mol% und ganz besonders bevorzugt im Bereich von 1 bis 20 mol% liegen, bezogen auf 100 mol% aller copolymerisierten Monomere, die im Polymer als Struktureinheiten enthalten sind.

Diese, von den Struktureinheiten der Formeln (la), (Ib), (II), (III), (IV), (V), (VI), (VII), (VIIIa), (Vlllb), (IX), (X), (XI), (XII), (XIII), (XIV), (XV) und/oder (XVI) verschiedenen Struktureinheiten, sind unter anderem solche, wie sie in der WO 02/077060 A1 und in der WO 2005/014689 A2 offenbart und umfangreich aufgelistet sind. Diese werden via Zitat als Bestandteil der vorliegenden Erfindung betrachtet.

Vorzugsweise kann das Polymer mindestens eine weitere Struktureinheit der folgenden Formel (XIX) enthalten, die von den Struktureinheiten der Formeln (I), (la), (Ib), (II), (III), (IV), (V), (VI), (VII), (VIIIa), (Vlllb), (IX), (X), (XI), (XII), (XIII), (XIV), (XV) und/oder (XVI) verschieden ist:

----- Ar¹¹----- (XIX)

wobei Ar¹¹ ein mono- oder polycyclisches, aromatisches oder heteroaromatisches Ringsystem ist, das mit einem oder mehreren Resten R substituiert sein kann, wobei R die in Formel (I) angegebenen Bedeutungen annehmen kann.

Bevorzugt als Struktureinheiten der folgenden Formel (XIX) sind Struktureinheiten in denen Ar¹¹ ausgewählt ist aus den Gruppen der Formeln M1 bis M23, wie in der folgenden Tabelle 10 aufgeführt.

**Tabelle 10**

| Formel (XIX) | Ar¹¹ |
|---|---|
| XIX1 | M1 |
| XIX2 | M2 |
| XIX3 | M3 |
| XIX4 | M4 |
| XIX5 | M5 |
| XIX6 | M6 |
| XIX7 | M7 |
| XIX8 | M8 |
| XIX9 | M9 |
| XIX10 | M10 |
| XIX11 | M11 |
| XIX12 | M12 |
| XIX13 | M13 |
| XIX14 | M14 |
| XIX15 | M15 |
| XIX16 | M16 |
| XIX17 | M17 |
| XIX18 | M18 |
| XIX19 | M19 |
| XIX20 | M20 |
| XIX21 | M21 |
| XIX22 | M22 |
| XIX23 | M23 |

Besonders bevorzugt als Struktureinheiten der Formel (XIX) sind Struktureinheiten in denen Ar¹¹ ausgewählt ist aus den Gruppen der Formeln M1a bis M23a, wie in der folgenden Tabelle 11 aufgeführt.

**Tabelle 11**

| Formel (XIX) | Ar¹¹ |
|---|---|
| XIX1a | M1a |
| XIX1b | M1b |
| XIX2a | M2a |
| XIX2b | M2b |
| XIX2c | M2c |
| XIX3a | M3a |
| XIX4a | M4a |
| XIX5a | M5a |
| XIX6a | M6a |
| XIX7a | M7a |
| XIX8a | M8a |
| XIX10a | M10a |
| XIX10b | M10b |
| XIX10c | M10c |
| XIX12a | M12a |
| XIX13a | M13a |
| XIX14a | M14a |
| XIX17a | M17a |
| XIX20a | M20a |
| XIX20b | M20b |
| XIX20c | M20c |
| XIX21a | M21a |
| XIX21b | M21b |
| XIX22a | M22a |
| XIX22b | M22b |
| XIX23a | M23a |
| XIX23b | M23b |

Die weiteren Struktureinheiten können beispielsweise aus den folgenden Klassen stammen:
- Gruppe 1:: Einheiten, welche die Lochinjektions- und/oder Lochtransporteigenschaften der Polymere beeinflussen;
- Gruppe 2:: Einheiten, welche die Elektroneninjektions- und/oder Elektronentransporteigenschaften der Polymere beeinflussen;
- Gruppe 3:: Einheiten, die Kombinationen von Einzeleinheiten der Gruppe 1 und Gruppe 2 aufweisen;
- Gruppe 4:: Einheiten, welche die Emissionscharakteristik insoweit verändern, dass Elektrophosphoreszenz statt Elektrofluoreszenz erhalten werden kann;
- Gruppe 5:: Einheiten, welche den Übergang vom Singulett- zum Triplettzustand verbessern;
- Gruppe 6:: Einheiten, welche die Emissionsfarbe der resultierenden Polymere beeinflussen;
- Gruppe 7:: Einheiten, welche typischerweise als Polymergrundgerüst (Backbone) verwendet werden;
- Gruppe 8:: Einheiten, welche die Filmmorphologie und/oder die rheologischen Eigenschaften der resultierenden Polymere beeinflussen.

Bevorzugte erfindungsgemäße Polymere sind solche, bei denen mindestens eine Struktureinheit Ladungstransporteigenschaften aufweist, d.h. die Einheiten aus der Gruppe 1 und/oder 2 enthalten.

Struktureinheiten aus der Gruppe 1, die Lochinjektions- und/oder Lochtransporteigenschaften aufweisen, sind beispielsweise Triarylamin-, Benzidin-, Tetraaryl-para-phenylendiamin-, Triarylphosphin-, Phenothiazin-, Phenoxazin-, Dihydrophenazin-, Thianthren-, Dibenzo-para-dioxin-, Phenoxathiin-, Carbazol-, Azulen-, Thiophen-, Pyrrol- und Furanderivate und weitere O-, S- oder N-haltige Heterocyclen.

Bevorzugte Struktureinheiten aus der Gruppe 1 sind die Struktureinheiten der folgenden Formeln (1a) bis (1q):

| | | |
|---|---|---|
| 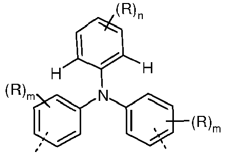 | 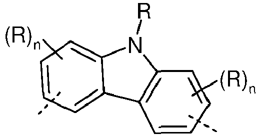 | |
| (1a) | (1b) | |
| 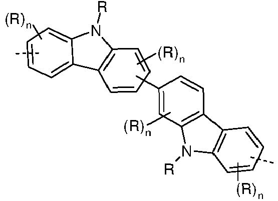 | 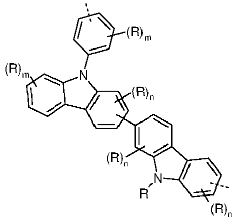 | 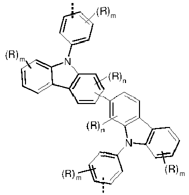 |
| (1c) | (1d) | (1e) |
| 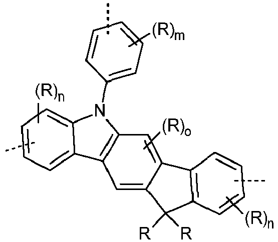 | 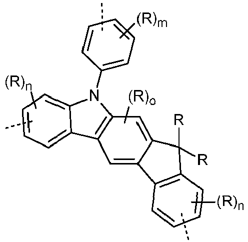 | |
| (1f) | (1g) | |
| 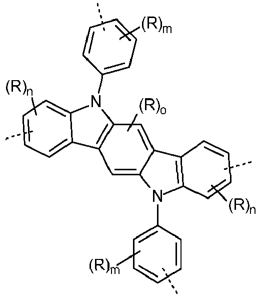 | 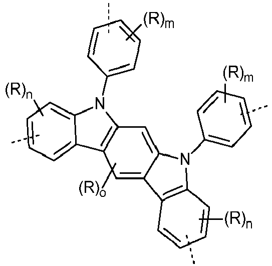 | |
| (1h) | (1i) | |
| | | 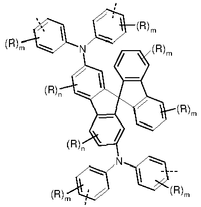 |
| 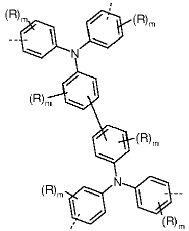 | 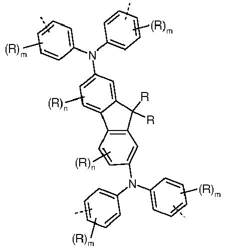 | |
| (1j) | (1k) | (1m) |
| 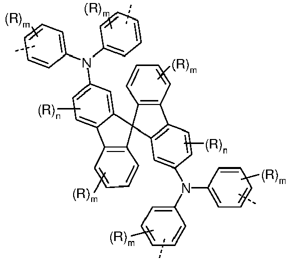 | 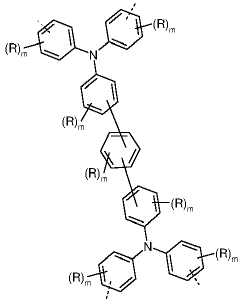 | 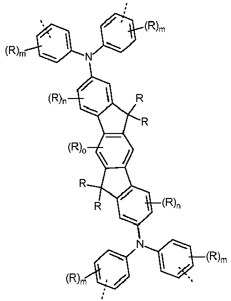 |
| (1n) | (1p) | (1q) |

wobei R, m, n und o die oben angegebenen Bedeutungen annehmen können.

In den Formeln (1a) bis (1q) stellen die gestrichelten Linien mögliche Bindungen zu den benachbarten Struktureinheiten im Polymer dar. Sofern in den Formeln zwei gestrichelte Linien vorhanden sind, weist die Struktureinheit ein oder zwei, vorzugsweise zwei, Bindungen zu benachbarten Struktureinheiten auf. Sofern in den Formeln drei gestrichelte Linien vorhanden sind, weist die Struktureinheit ein, zwei oder drei, vorzugsweise zwei, Bindungen zu benachbarten Struktureinheiten auf. Sofern in den Formeln vier gestrichelte Linien vorhanden sind, weist die Struktureinheit ein, zwei, drei oder vier, vorzugsweise zwei, Bindungen zu benachbarten Struktureinheiten auf. Sie können dabei unabhängig voneinander, gleich oder verschieden, in ortho-, meta- oder para-Position angeordnet sein.

Struktureinheiten aus der Gruppe 2, die Elektroneninjektions- und/oder Elektronentransporteigenschaften aufweisen, sind beispielsweise Pyridin-, Pyrimidin-, Pyridazin-, Pyrazin-, Oxadiazol-, Chinolin-, Chinoxalin-, Anthracen-, Benzanthracen-, Pyren-, Perylen-, Benzimidazol-, Triazin-, Keton-, Phosphinoxid- und Phenazinderivate, aber auch Triarylborane und weitere O-, S- oder N-haltige Heterocyclen.

Es kann bevorzugt sein, wenn in den erfindungsgemäßen Polymeren Einheiten aus der Gruppe 3 enthalten sind, in denen Strukturen, welche die Lochmobilität und welche die Elektronenmobilität erhöhen (also Einheiten aus Gruppe 1 und 2), direkt aneinander gebunden sind oder Strukturen enthalten sind, die sowohl die Lochmobilität als auch die Elektronenmobilität erhöhen. Einige dieser Einheiten können als Emitter dienen und verschieben die Emissionsfarbe ins Grüne, Gelbe oder Rote. Ihre Verwendung eignet sich also beispielsweise für die Erzeugung anderer Emissionsfarben aus ursprünglich blau emittierenden Polymeren.

Struktureinheiten der Gruppe 4 sind solche, welche auch bei Raumtemperatur mit hoher Effizienz aus dem Triplettzustand Licht emittieren können, also Elektrophosphoreszenz statt Elektrofluoreszenz zeigen, was häufig eine Steigerung der Energieeffizienz bewirkt. Hierfür eignen sich zunächst Verbindungen, welche Schweratome mit einer Ordnungszahl von mehr als 36 enthalten. Bevorzugt sind Verbindungen, welche d- oder f-Übergangsmetalle enthalten, die die o.g. Bedingung erfüllen. Besonders bevorzugt sind hier entsprechende Struktureinheiten, welche Elemente der Gruppen 8 bis 10 (Ru, Os, Rh, Ir, Pd, Pt) enthalten. Als Struktureinheiten für die erfindungsgemäß einsetzbaren Polymere kommen hier z.B. verschiedene Komplexe in Frage, wie sie z.B. in der WO 02/068435 A1, der WO 02/081488 A1, der EP 1239526 A2 und der WO 2004/026886 A2 beschrieben werden. Entsprechende Monomere werden in der WO 02/068435 A1 und in der WO 2005/042548 A1 beschrieben.

Struktureinheiten der Gruppe 5 sind solche, welche den Übergang vom Singulett- zum Triplettzustand verbessern und welche, unterstützend zu den Strukturelementen der Gruppe 4 eingesetzt, die Phosphoreszenzeigenschaften dieser Strukturelemente verbessern. Hierfür kommen insbesondere Carbazol- und überbrückte Carbazoldimereinheiten in Frage, wie sie z.B. in der WO 2004/070772 A2 und der WO 2004/113468 A1 beschrieben werden. Weiterhin kommen hierfür Ketone, Phosphinoxide, Sulfoxide, Sulfone, Silan-Derivate und ähnliche Verbindungen in Frage, wie sie z.B. in der WO 2005/040302 A1 beschrieben werden.

Struktureinheiten der Gruppe 6 sind neben den oben genannten solche, die mindestens noch eine weitere aromatische oder eine andere konjugierte Struktur aufweisen, welche nicht unter die o.g. Gruppen fallen, d.h. die die Ladungsträgermobilitäten nur wenig beeinflussen, die keine metallorganischen Komplexe sind oder die keinen Einfluss auf den Singulett-Triplett-Übergang haben. Derartige Strukturelemente können die Emissionsfarbe der resultierenden Polymere beeinflussen. Je nach Einheit können sie daher auch als Emitter eingesetzt werden. Bevorzugt sind dabei aromatische Strukturen mit 6 bis 40 C-Atomen oder auch Tolan-, Stilben- oder Bisstyrylarylenderivate, die jeweils mit einem oder mehreren Resten R substituiert sein können. Besonders bevorzugt ist dabei der Einbau von 1,4- oder 9,10-Anthrylen-, 1,6-, 2,7- oder 4,9-Pyrenylen-, 3,9- oder 3,10-Perylenylen-, 4,4'-Tolanylen-, 4,4'-Stilbenylen-, Benzothiadiazol- und entsprechenden Sauerstoffderivaten, Chinoxalin-, Phenothiazin-, Phenoxazin-, Dihydrophenazin-, Bis(thiophenyl)arylen-, Oligo(thiophenylen)-, Phenazin-, Rubren-, Pentacen- oder Perylenderivaten, die vorzugsweise substituiert sind, oder vorzugsweise konjugierte Push-Pull-Systeme (Systeme, die mit Donor- und Akzeptorsubstituenten substituiert sind) oder Systeme wie Squarine oder Chinacridone, die vorzugsweise substituiert sind.

Struktureinheiten der Gruppe 7 sind Einheiten, die aromatische Strukturen mit 6 bis 40 C-Atomen beinhalten, welche typischerweise als Polymergrundgerüst (Backbone) verwendet werden. Dies sind beispielsweise 4,5-Dihydropyrenderivate, 4,5,9,10-Tetrahydropyrenderivate, Fluorenderivate, 9,9'-Spirobifluorenderivate, Phenanthrenderivate, 9,10-Dihydrophenanthrenderivate, 5,7-Dihydrodibenzooxepinderivate und cis- und trans-Indenofluorenderivate aber auch 1,2-, 1,3- oder 1,4-Phenylen-, 1,2-, 1,3- oder 1,4-Naphthylen-, 2,2'-, 3,3'- oder 4,4'-Biphenylylen-, 2,2"-, 3,3"- oder 4,4"-Terphenylylen, 2,2'-, 3,3'- oder 4,4'-Bi-1,1 '-naphthylylen- oder 2,2"'-, 3,3"'- oder 4,4'"-Quarterphenylylenderivate.

Bevorzugte Struktureinheiten aus der Gruppe 7 sind die Struktureinheiten der folgenden Formeln (7a) bis (7o):

| | | |
|---|---|---|
| 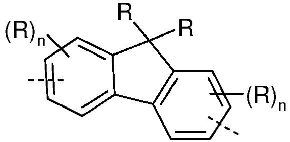 | 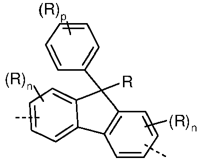 | 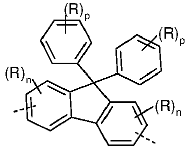 |
| (7a) | (7b) | (7c) |
| 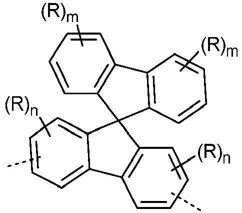 | 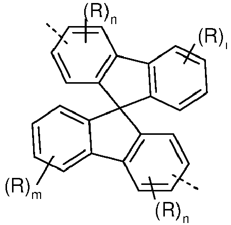 1 | |
| (7d) | (7e) | |
| 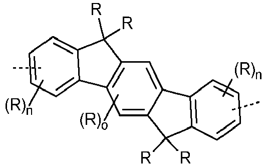 | 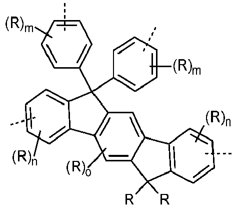 | 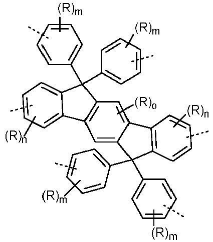 |
| (7f) | (7g) | (7h) |
| 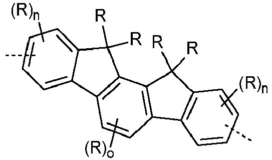 | 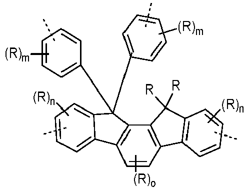 | |
| (7i) | (7j) | |
| 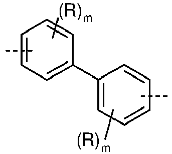 | 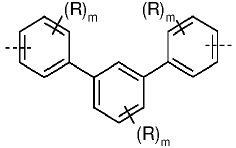 | |
| (7k) | (7m) | |
| 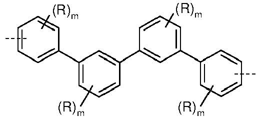 | 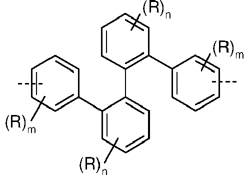 | |
| (7n) | (7o) | |

wobei R, m, n, o und p die oben angegebenen Bedeutungen annehmen können.

In den Formeln (7a) bis (7o) stellen die gestrichelten Linien mögliche Bindungen zu den benachbarten Struktureinheiten im Polymer dar. Sofern in den Formeln zwei gestrichelte Linien vorhanden sind, weist die Struktureinheit ein oder zwei, vorzugsweise zwei, Bindungen zu benachbarten Struktureinheiten auf. Sofern in den Formeln vier oder mehr gestrichelte Linien vorhanden sind (Formeln (7g), (7h) und (7j)), weisen die Struktureinheiten ein, zwei, drei oder vier, vorzugsweise zwei, Bindungen zu benachbarten Struktureinheiten auf. Sie können dabei unabhängig voneinander, gleich oder verschieden, in ortho-, meta- oder para-Position angeordnet sein.

Struktureinheiten der Gruppe 8 sind solche, die die Filmmorphologie und/oder die rheologischen Eigenschaften der Polymere beeinflussen, wie z.B. Siloxane, Alkylketten oder fluorierte Gruppen, aber auch besonders steife oder flexible Einheiten, flüssigkristallbildende Einheiten oder vernetzbare Gruppen.

Bevorzugt sind erfindungsgemäße Polymere, die gleichzeitig neben Struktureinheiten der Formel (la), (Ib), (II), (III), (IV), (V), (VI), (VII), (VIIIa), (VIIIb), (IX), (X), (XI), (XII), (XIII), (XIV), (XV) und/oder (XVI) zusätzlich noch ein oder mehrere Einheiten ausgewählt aus den Gruppen 1 bis 8 enthalten. Es kann ebenfalls bevorzugt sein, wenn gleichzeitig mehr als eine weitere Struktureinheit aus einer Gruppe vorliegt.

Bevorzugt sind dabei erfindungsgemäße Polymere, die neben mindestens einer Struktureinheit der Formel (la), (Ib), (II), (III), (IV), (V), (VI), (VII), (VIIIa), (Vlllb), (IX), (X), (XI), (XII), (XIII), (XIV), (XV) und/oder (XVI) noch Einheiten aus der Gruppe 7 enthalten.

Ebenfalls bevorzugt ist es, wenn die erfindungsgemäß einsetzbaren Polymere Einheiten enthalten, die den Ladungstransport oder die Ladungsinjektion verbessern, also Einheiten aus der Gruppe 1 und/oder 2.

Besonders bevorzugt ist es weiterhin, wenn die erfindungsgemäß einsetzbaren Polymere Struktureinheiten aus der Gruppe 7 und Einheiten aus der Gruppe 1 und/oder 2 enthalten.

Die erfindungsgemäß einsetzbaren Polymere sind entweder Homopolymere aus Struktureinheiten der Formel (la), (Ib), (II), (III), (IV), (V), (VI), (VII), (VIIIa), (Vlllb), (IX), (X), (XI), (XII), (XIII), (XIV), (XV) und/oder (XVI) oder Copolymere. Die erfindungsgemäß einsetzbaren Polymere können linear oder verzweigt sein, vorzugsweise linear. Erfindungsgemäße Copolymere können dabei neben einer oder mehreren Struktureinheiten der Formel (la), (Ib), (II), (III), (IV), (V), (VI), (VII), (VIIIa), (Vlllb), (IX), (X), (XI), (XII), (XIII), (XIV), (XV) und/oder (XVI) potentiell eine oder mehrere weitere Struktureinheiten aus den oben aufgeführten Gruppen 1 bis 8 besitzen.

Die erfindungsgemäßen Copolymere können statistische, alternierende oder blockartige Strukturen aufweisen oder auch mehrere dieser Strukturen abwechselnd besitzen. Besonders bevorzugt weisen die erfindungsgemäßen Copolymere statistische oder alternierende Strukturen auf. Besonders bevorzugt sind die Copolymere statistische oder alternierende Copolymere. Wie Copolymere mit blockartigen Strukturen erhalten werden können und welche weiteren Strukturelemente dafür besonders bevorzugt sind, ist beispielsweise ausführlich in der WO 2005/014688 A2 beschrieben. Diese ist via Zitat Bestandteil der vorliegenden Anmeldung. Ebenso sei an dieser Stelle nochmals hervorgehoben, dass das Polymer auch dendritische Strukturen haben kann.

In einer besonders bevorzugten Ausführungsform der vorliegenden Erfindung enthalten die erfindungsgemäß einsetzbaren Polymere neben einer oder mehrerer Struktureinheiten der Formel (la), (Ib), (II), (III), (IV), (V), (VI), (VII), (VIIIa), (Vlllb), (IX), (X), (XI), (XII), (XIII), (XIV), (XV) und/oder (XVI), wobei Rest Ar³ gemäß Formel (I) in mindestens einer, vorzugsweise in einer der beiden ortho-Positionen, bezogen auf die Position des in Formel (I) dargestellten Stickstoffatoms, mit Ar⁴ substituiert ist oder mindestens einer der der Rest Ar⁵ und/oder Ar⁸ gemäß Formeln (VIIIa) und/oder (VIIIb) in mindestens einer, vorzugsweise in einer der beiden ortho-Positionen, bezogen auf die Position des in Formel (VIIIa) und/oder (VIIIb) dargestellten Stickstoffatoms, mit Ar⁴ substituiert ist, sowie gegebenenfalls weiteren Struktureinheiten ausgewählt aus den oben genannten Gruppen 1 bis 8 noch mindestens eine, vorzugsweise eine Struktureinheit, die eine vernetzbare Gruppe Q aufweist.

Desweiteren kann die Struktureinheit, die die vernetzbare Gruppe Q trägt, in einer zweiten Ausführungsform ausgewählt werden aus den in den Gruppen 1 bis 8 offenbarten Struktureinheiten.

Eine weitere bevorzugte Struktureinheit, die die vernetzbare Gruppe Q tragen kann, ist die folgende, aus der Gruppe 7 abgeleitete Struktureinheit der Formel (XX): 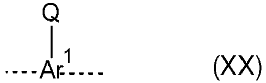 wobei Ar¹ die in Bezug auf die Struktureinheit der Formel (I) angegebene Bedeutung annehmen kann.

Beispiele für bevorzugte Struktureinheiten der Formel (XX) sind in der folgenden Tabelle abgebildet:

| | | |
|---|---|---|
| 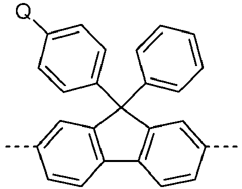 | 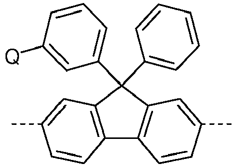 | 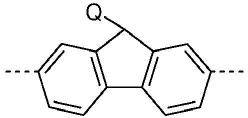 |
| (20a) | (20b) | (20c) |
| 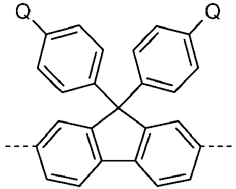 | 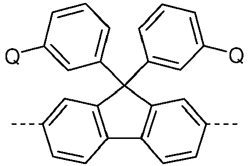 | 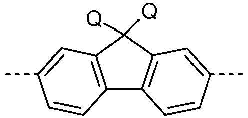 |
| (20d) | (20e) | (20f) |

Die erfindungsgemäß einsetzbaren Polymere enthaltend Struktureinheiten der Formel (la), (Ib), (II), (III), (IV), (V), (VI), (VII), (VIIIa), (Vlllb), (IX), (X), (XI), (XII), (XIII), (XIV), (XV) und/oder (XVI) werden in der Regel durch Polymerisation von einer oder mehreren Monomersorten hergestellt, von denen mindestens ein Monomer im Polymer zu Struktureinheiten der Formel (la), (Ib), (II), (III), (IV), (V), (VI), (VII), (VIIIa), (Vlllb), (IX), (X), (XI), (XII), (XIII), (XIV), (XV) und/oder (XVI) führt. Geeignete Polymerisationsreaktionen sind dem Fachmann bekannt und in der Literatur beschrieben. Besonders geeignete und bevorzugte Polymerisationsreaktionen, die zu C-C- bzw. C-N-Verknüpfungen führen, sind folgende:
(A) SUZUKI-Polymerisation;
(B) YAMAMOTO-Polymerisation;
(C) STILLE-Polymerisation;
(D) HECK-Polymerisation;
(E) NEGISHI-Polymerisation;
(F) SONOGASHIRA-Polymerisation;
(G) HIYAMA-Polymerisation; und
(H) HARTWIG-BUCHWALD-Polymerisation.

Wie die Polymerisation nach diesen Methoden durchgeführt werden kann und wie die Polymere dann vom Reaktionsmedium abgetrennt und aufgereinigt werden können, ist dem Fachmann bekannt und in der Literatur, beispielsweise in der WO 03/048225 A2, der WO 2004/037887 A2 und der WO 2004/037887 A2 im Detail beschrieben.

Die C-C-Verknüpfungen sind vorzugsweise ausgewählt aus den Gruppen der SUZUKI-Kupplung, der YAMAMOTO-Kupplung und der STILLE-Kupplung; die C-N-Verknüpfung ist vorzugsweise eine Kupplung gemäß HARTWIG-BUCHWALD.

Zur Synthese der erfindungsgemäß einsetzbaren Polymere können die entsprechenden Monomere der Formel (MI) eingesetzt werden, 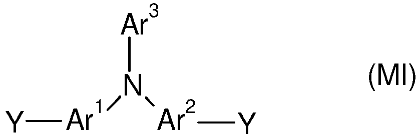 wobei Ar¹, Ar² und Ar³ die in Bezug auf die Struktureinheit der Formel (I) angegebenen Bedeutungen annehmen kann.

Die Monomere der Formel (MI), die in den erfindungsgemäßen Polymeren zu Struktureinheiten der Formel (Ia) führen, sind Verbindungen, die entsprechend substituiert sind und an zwei Positionen geeignete Funktionalitäten aufweisen, die es erlauben, diese Monomereinheit in das Polymer einzubauen. Diese Monomere der Formel (MI) sind somit ebenfalls Gegenstand der vorliegenden Erfindung. Die Gruppe Y stellt, gleich oder verschieden, eine für eine Polymerisationsreaktion geeignete Abgangsgruppe dar, so dass der Einbau der Monomerbausteine in polymere Verbindungen ermöglicht wird. Vorzugsweise stellt Y eine chemische Funktionalität dar, welche gleich oder verschieden ausgewählt ist aus der Klasse der Halogene, O-Tosylate, O-Triflate, O-Sulfonate, Borsäureester, teilfluorierten Silylgruppen, Diazoniumgruppen und zinnorganischen Verbindungen.

Entsprechende Monomere zur Herstellung von Struktureinheiten der Formeln (VIIIa) und/oder (VIIIb) ergeben sich entsprechend durch Ersatz der gestrichelten Linien durch Abgangsgruppen Y, wie für Formel (MI) definiert.

Das Grundgerüst der Monomerverbindungen lässt sich nach Standardmethoden funktionalisieren, beispielsweise durch Friedel-Crafts-Alkylierung oder -Acylierung. Weiterhin lässt sich das Grundgerüst nach Standardmethoden der organischen Chemie halogenieren. Die halogenierten Verbindungen lassen sich in zusätzlichen Funktionalisierungsschritten wahlweise weiter umsetzen. Beispielsweise können die halogenierten Verbindungen entweder direkt oder nach Überführung in ein Boronsäurederivat oder zinnorganisches Derivat als Ausgangsstoffe für die Umsetzung zu Polymeren, Oligomeren oder Dendrimeren eingesetzt werden.

Die genannten Methoden stellen lediglich eine Auswahl aus den dem Fachmann bekannten Reaktionen dar, welche dieser, ohne erfinderisch tätig zu werden, zur Synthese der erfindungsgemäßen Verbindungen einsetzen kann.

Die erfindungsgemäß einsetzbaren Polymere können als Reinsubstanz, aber auch als Mischung zusammen mit weiteren beliebigen polymeren, oligomeren, dendritischen oder niedermolekularen Substanzen verwendet werden. Als niedermolekulare Substanz versteht man in der vorliegenden Erfindung Verbindungen mit einem Molekulargewicht im Bereich von 100 bis 3000 g/mol, vorzugsweise 200 bis 2000 g/mol. Diese weiteren Substanzen können z.B. die elektronischen Eigenschaften verbessern oder selbst emittieren. Als Mischung wird vor- und nachstehend eine Mischung enthaltend mindestens eine polymere Komponente bezeichnet. Auf diese Art können eine oder mehrere Polymerschichten bestehend aus einer Mischung (Blend) aus einem oder mehreren erfindungsgemäßen Polymeren mit einer Struktureinheit der Formel (la), (Ib), (II), (III), (IV), (V), (VI), (VII), (VIIIa), (VIIIb), (IX), (X), (XI), (XII), (XIII), (XIV), (XV) und/oder (XVI) und optional einem oder mehreren weiteren Polymeren mit einer oder mehreren niedermolekularen Substanzen hergestellt werden.

Die erfindungsgemäßen Zusammensetzungen umfassen mindestens ein Salz, wobei das Salz mindestens ein Kation der folgenden Formeln (K1), (K2) und/oder K(3): 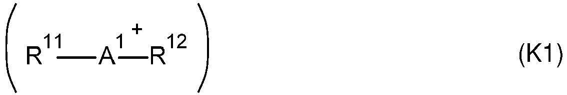 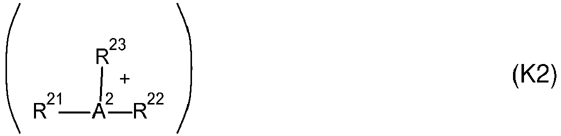 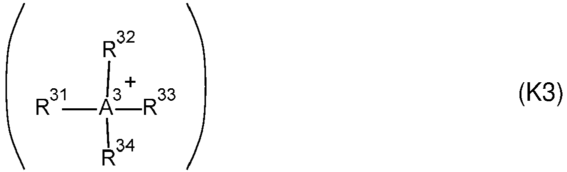
umfasst, wobei der Rest A¹, ein Element der 15 Gruppe des Periodensystems der Elemente ist; der Rest A², ein Element der 16 Gruppe des Periodensystems der Elemente ist; und A³, ein Element der 17 Gruppe des Periodensystems der Elemente ist;
und die Reste R¹¹, R²¹, R³¹, einen beliebigen Rest bedeuten, vorzugsweise eine Kohlenstoffatom-haltige Gruppe darstellen, die über ein Kohlenstoffatom jeweils an den Rest A¹, A² oder A³ bindet;
die Reste R¹², R²², R²³, R³², R³³ und R³⁴ jeweils eine Kohlenstoffatom-haltige Gruppe darstellen, die über ein Kohlenstoffatom jeweils an den Rest A¹, A² oder A³ bindet, wobei ein oder mehrere der Reste R¹¹ bis R³⁴ auch miteinander ein mono- oder polycyclisches, aliphatisches, heteroaliphatisches, heteroaromatisches oder aromatisches Ringsystem bilden können;
und mindestens ein Anion der folgenden Formel (A1) 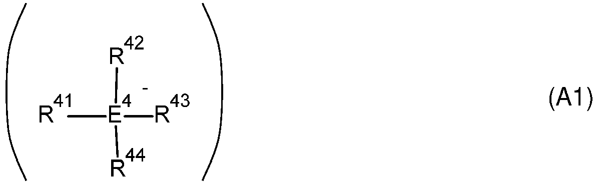
umfasst, wobei der Rest E⁴ ein Element der 13 Gruppe des Periodensystems der Elemente ist;
und die Reste R⁴¹, R⁴², R⁴³ und R⁴⁴ jeweils ein aromatisches oder heteroaromatisches Ringsystem mit 5 bis 60 aromatischen Ringatomen, das jeweils durch einen oder mehrere Reste R substituiert sein kann, wobei ein oder mehrere der Reste R⁴¹, R⁴², R⁴³ und R⁴⁴ auch miteinander ein mono- oder polycyclisches, aliphatisches, heteroaliphatisches, heteroaromatisches oder aromatisches Ringsystem bilden können.

In Bezug auf die die Reste R¹¹, R²¹, R³¹ bestehen keine besonderen Begrenzungen, wobei diese vorzugsweise über ein Kohlenstoffatom an mindestens einen der Reste A¹, A² oder A³ binden. Das Molekulargewicht der Reste R¹¹, R²¹, R³¹, einschließlich deren Substituenten beträgt vorzugsweise höchstens 1000 g/mol, besonders bevorzugt höchstens 500 g/mol.

Zu den bevorzugten Beispielen der Reste R¹¹, R²¹, R³¹ zählen unter anderem Alkylgruppen, Alkenylgruppen, Alkinylgruppen, aromatische Kohlenwasserstoffreste und und heteroaromatische Reste, wobei diese bevorzugt eine positive Ladung, insbesondere über Delokalisation stabilisieren können und wärmebeständig sind.

Besonders bevorzugte Beispiele für die Reste R¹¹, R²¹, R³¹ werden insbesondere in der EP 1725079 B1 und der EP 2325190 A1 dargelegt, die zu Offenbarungszwecken in die vorliegende Anmeldung durch Referenz hierauf eingefügt werden.

Vorzugsweise kann vorgesehen sein, dass die Reste R¹², R²², R²³, R³², R³³ und R³⁴ in den Formeln (K1), (K2) und/oder (K3) jeweils bei jedem Auftreten gleich oder verschieden unabhängig voneinander ein mono- oder polycyclisches, aromatisches oder heteroaromatisches Ringsystem mit 5 bis 60 aromatischen Ringatomen bedeuten, die mit einem Rest R substituiert sein können, wobei R die in Formel (I) angegebenen Bedeutungen annehmen kann.

In einer weiterhin bevorzugten Ausführungsform der vorliegenden Erfindung kann in den Formeln (K1), (K2) und/oder (K3) die Reste R¹¹, R²¹ und/oder R³¹ eine geradkettige Alkyl-, Alkoxy- oder Thioalkoxygruppe mit 1 bis 40 C-Atomen oder eine Alkenyl- oder Alkinylgruppe mit 2 bis 40 C-Atomen oder eine verzweigte oder cyclische Alkyl-, Alkoxy- oder Thioalkoxygruppe mit 3 bis 40 C-Atomen, die jeweils mit einem oder mehreren Resten R¹ substituiert sein kann, wobei eine oder mehrere nicht benachbarte CH₂-Gruppen durch R¹C=CR¹, C=C, Si(R¹)₂, C=O, C=S, C=NR¹, P(=O)(R¹), SO, SO₂, NR¹, O, S oder CONR¹ ersetzt sein können und wobei ein oder mehrere H-Atome durch D, F, Cl, Br, I oder CN ersetzt sein können, oder ein aromatisches oder heteroaromatisches Ringsystem mit 5 bis 60 aromatischen Ringatomen, das jeweils durch einen oder mehrere Reste R¹ substituiert sein kann, oder eine Aryloxy- oder Heteroaryloxygruppe mit 5 bis 60 aromatischen Ringatomen, die durch einen oder mehrere Reste R¹ substituiert sein kann, oder eine Aralkyl- oder Heteroaralkylgruppe mit 5 bis 60 aromatischen Ringatomen, die durch einen oder mehrere Reste R¹ substituiert sein kann, oder eine Diaryl aminogruppe, Diheteroarylaminogruppe oder Arylheteroarylaminogruppe mit 10 bis 40 aromatischen Ringatomen darstellen, welche durch einen oder mehrere Reste R¹ substituiert sein kann; ist; wobei zwei oder mehrere Reste R auch miteinander ein mono- oder polycyclisches, aliphatisches, aromatisches und/oder benzoannelliertes Ringsystem bilden können.

In einer weiteren Ausgestaltung der vorliegenden Erfindung kann ein Salz eingesetzt werden, in welchem der Rest A¹ in Formel (K1) ein Bromatom oder ein lodatom ist, der Rest A² in Formel (K2) ein Selenatom oder ein Schwefelatom ist und der Rest A³ in Formel (K3) ein Antimonatom, ein Arsenatom oder ein Phosphoratom ist.

Bevorzugte Ausführungsformen der Kationen von erfindungsgemäß einzusetzenden Salzen gemäß Formel (K1) sind in der nachfolgenden Tabelle K1 dargestellt.

**Tabelle K-1**

| | | |
|---|---|---|
| 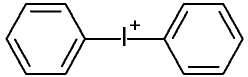 | 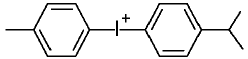 | 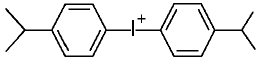 |
| K1-1 | K1-2 | K1-3 |
| 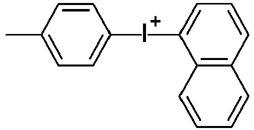 | 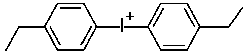 | 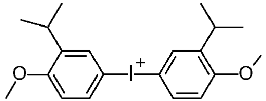 |
| K1-4 | K1-5 | K1-6 |
| 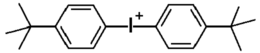 | 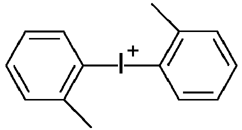 | 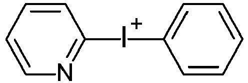 |
| K1-7 | K1-8 | K1-9 |
| 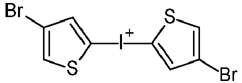 | 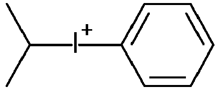 | 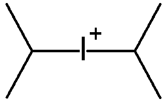 |
| K1-10 | K1-11 | K1-12 |
| 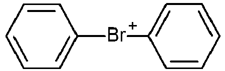 | 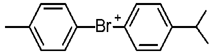 | 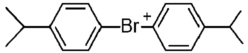 |
| K1-13 | K1-14 | K1-15 |
| 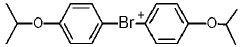 | 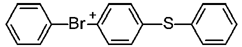 | 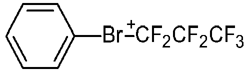 |
| K1-16 | K1-17 | K1-18 |
| 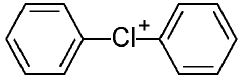 | 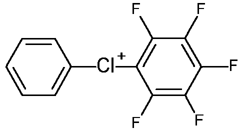 | 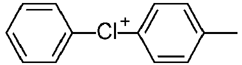 |
| K1-19 | K1-20 | K1-21 |
| 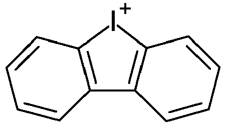 | 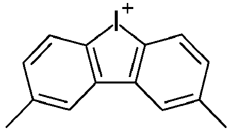 | 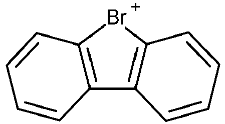 |
| K1-22 | K1-23 | K1-24 |

Bevorzugte Ausführungsformen der Kationen von erfindungsgemäß einzusetzenden Salzen gemäß Formel (K2) sind in der nachfolgenden Tabelle K2 dargestellt.

**Tabelle K-2**

| | | |
|---|---|---|
| 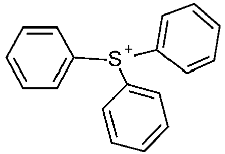 | 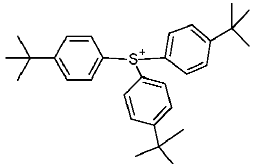 | 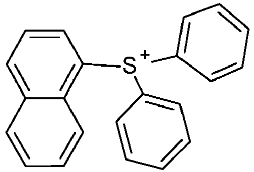 |
| K2-1 | K2-2 | K2-3 |
| 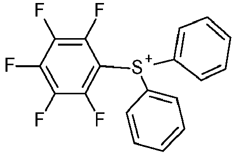 | 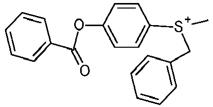 | 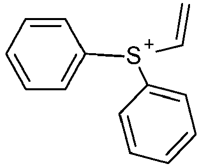 |
| K2-4 | K2-5 | K2-6 |
| 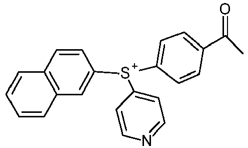 | 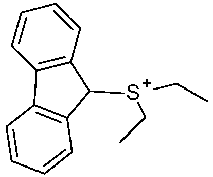 | 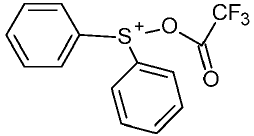 |
| K2-7 | K2-8 | K2-9 |
| 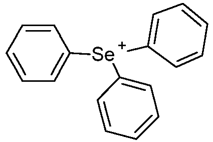 | 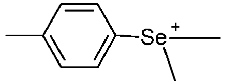 | 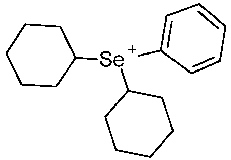 |
| K2-10 | K2-11 | K2-12 |
| 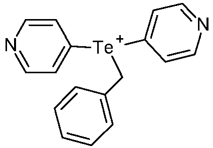 | 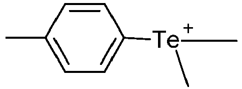 | 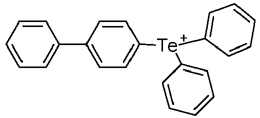 |
| K2-13 | K2-14 | K2-15 |
| 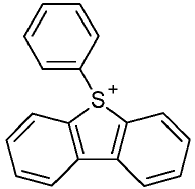 | 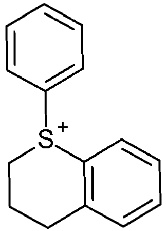 | 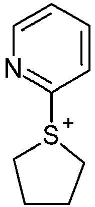 |
| K2-16 | K2-17 | K2-18 |
| 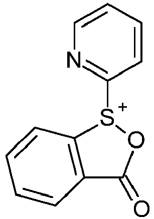 | 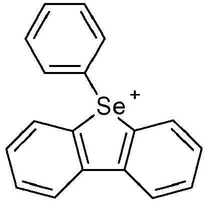 | 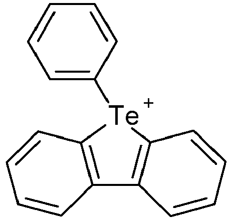 |
| K2-19 | K2-20 | K2-21 |

Bevorzugte Ausführungsformen der Kationen von erfindungsgemäß einzusetzenden Salzen gemäß Formel (K3) sind in der nachfolgenden Tabelle K3 dargestellt.

**Tabelle K-3**

| | | |
|---|---|---|
| 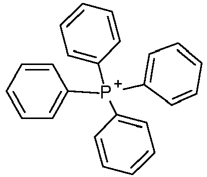 | 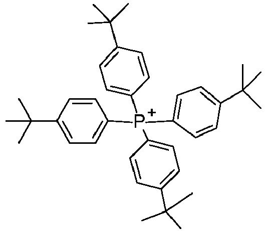 | 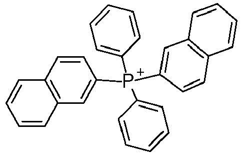 |
| K3-1 | K3-2 | K3-3 |
| 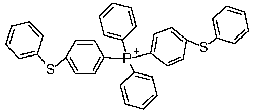 | 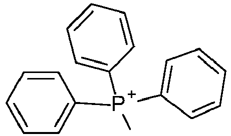 | 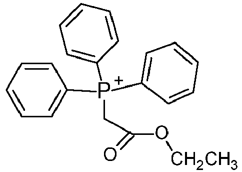 |
| K3-4 | K3-5 | K3-6 |
| 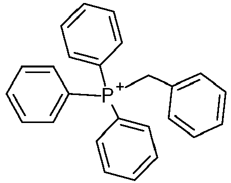 | 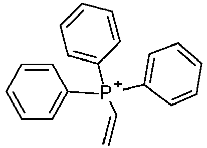 | 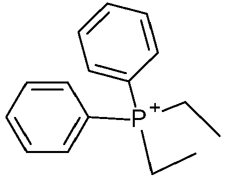 |
| K3-7 | K3-8 | K3-9 |
| 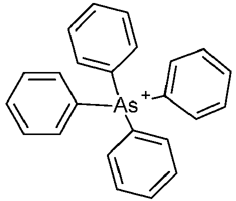 | 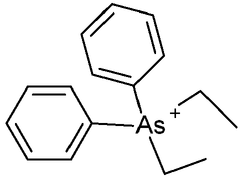 | 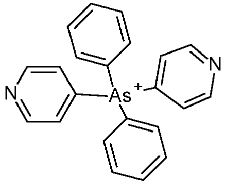 |
| K3-10 | K3-11 | K3-12 |
| 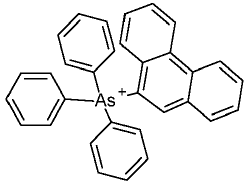 | 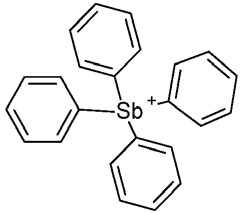 | 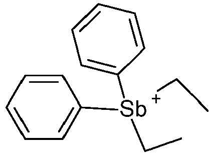 |
| K3-13 | K3-14 | K3-15 |
| 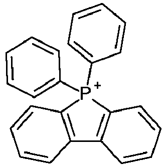 | 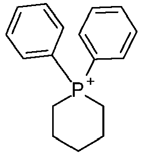 | 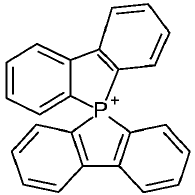 |
| K3-16 | K3-17 | K3-18 |
| 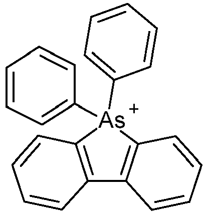 | 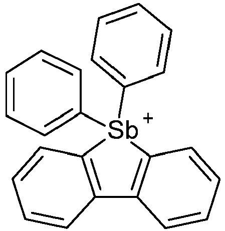 | |
| K3-19 | K3-20 | |

Die Reste R⁴¹, R⁴², R⁴³ und R⁴⁴ in Formel (A1) stellen jeweils ein aromatisches oder heteroaromatisches Ringsystem mit 5 bis 60, vorzugsweise mit 5 bis 20 und besonders bevorzugt mit 5 bis 12 aromatischen Ringatomen dar, das jeweils durch einen oder mehrere Reste R substituiert sein kann. Die Reste R⁴¹, R⁴², R⁴³ und R⁴⁴ in Formel (A1) können vorzugsweise jeweils mindestens einen, besonders bevorzugt zwei, drei oder mehr elektronenziehende Gruppen als Substituenten aufweisen. Zu den bevorzugten elektronenziehenden Gruppen zählen unter anderem Halogenatome, insbesondere Fluor-, Chor- und/oder Bromatome; Cyano-, Thiocyano-, Nitro-, Acyl-, Arylsulfonyl- und/oder Alkylsulfonylgruppen, die vorzugsweise höchstens 12, besonders bevorzugt höchstens 7 Kohlenstoffatome aufweisen.

Besonders bevorzugte Beispiele für elektronenziehende Gruppen, die insbesondere die Reste R⁴¹, R⁴², R⁴³ und R⁴⁴ in Formel (A1) aufweisen können, werden insbesondere in der EP 1725079 B1 und der EP 2325190 A1 dargelegt, die zu Offenbarungszwecken in die vorliegende Anmeldung durch Referenz hierauf eingefügt werden.

Ferner kann vorgesehen sein, dass mindestens einer der Reste R⁴¹, R⁴², R⁴³ und R⁴⁴ in Formel (A1) mindestens ein Halogenatom, vorzugsweise mindestens ein Chlor- und/oder Fluoratom, besonders bevorzugt mindestens ein Fluoratom als Substituent aufweist.

Besonders bevorzugt kann vorgesehen sein, dass mindestens die Hälfte, bevorzugt mindestens zwei Drittel, besonders bevorzugt alle Wasserstoffatome der Reste R⁴¹, R⁴², R⁴³ und R⁴⁴ in Formel (A1) durch Fluoratome ersetzt sind, so dass eine Perfluoraryl- oder heteroarylgruppe gebildet wird. Bevorzugte Beispiele für derartige Gruppen stellen unter anderem die Pentafluorophenylgruppe, die Heptafluoro-2-naphthylgruppe und die Tetrafluoro-4-pyridylgruppe dar.

Weiterhin kann einer der Reste R⁴¹, R⁴², R⁴³ und R⁴⁴ in Formel (A1) einen Substituenten aufweisen, der durch folgende Formel (A2) dargestellt werden kann: 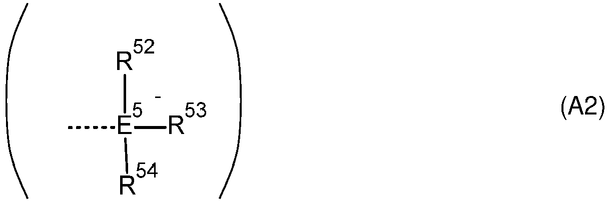
umfasst, wobei der Rest E⁵ ein Element der 13 Gruppe des Periodensystems der Elemente ist;
und die Reste R⁵², R⁵³ und R⁵⁴ jeweils ein aromatisches oder heteroaromatisches Ringsystem mit 5 bis 60 aromatischen Ringatomen, das jeweils durch einen oder mehrere Reste R substituiert sein kann, wobei ein oder mehrere der Reste R⁵², R⁵³ und R⁵⁴ auch miteinander ein mono- oder polycyclisches, aliphatisches, heteroaliphatisches, heteroaromatisches oder aromatisches Ringsystem bilden können.

Bevorzugte Ausgestaltungen der Reste beispielsweise die Art der Substituenten entsprechen den Resten R⁴¹, R⁴², R⁴³ und R⁴⁴ in Formel (A1).

Vorteilhaft kann ein Salz eingesetzt werden, in welchem der Rest E⁴ in Formel (A1) oder der Rest E⁵ in Formel (A2) ein Aluminium-, Gallium- oder Boratom, vorzugsweise ein Boratom ist.

Das Molekulargewicht der Reste R⁴¹, R⁴², R⁴³, R⁴⁴, R⁵², R⁵³ und R⁵⁴, einschließlich deren Substituenten beträgt vorzugsweise höchstens 1000 g/mol, besonders bevorzugt höchstens 500 g/mol.

Das Molekulargewicht des Anions gemäß Formel (A1) beträgt vorzugsweise mindestens 100 g/mol, besonders bevorzugt mindestens 200 g/mol.

Bevorzugt ist das Molekulargewicht des Anions gemäß Formel (A1) kleiner oder gleich 4000 g/mol, besonders bevorzugt kleiner oder gleich 2000 g/mol, und insbesondere bevorzugt kleiner oder gleich 1000 g/mol.

Bevorzugte Ausführungsformen der Anionen von erfindungsgemäß einzusetzenden Salzen sind nachfolgend in Tabelle A-1 dargestellt.

**Tabelle A-1**

| | | |
|---|---|---|
| 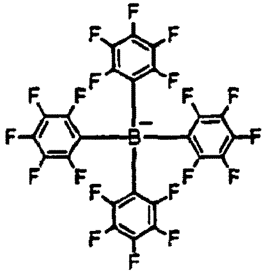 | 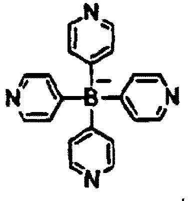 | 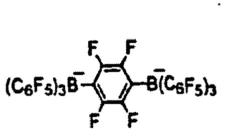 |
| A1-1 | A1-2 | A1-3 |
| 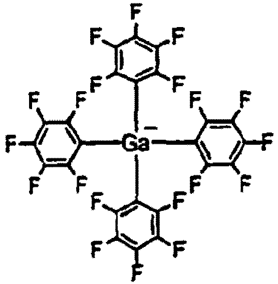 | 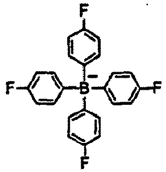 | 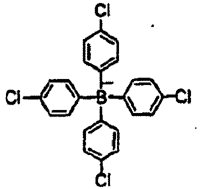 |
| A1-4 | A1-5 | A1-6 |
| 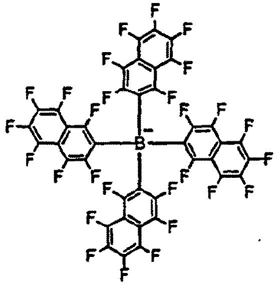 | 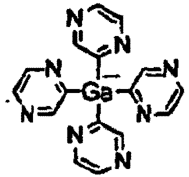 | 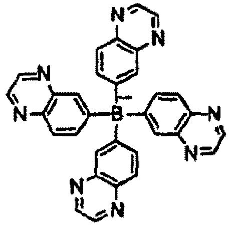 |
| A1-7 | A1-8 | A1-9 |
| 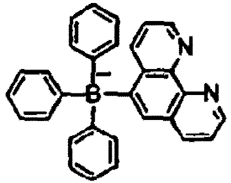 | 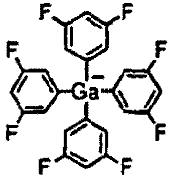 | 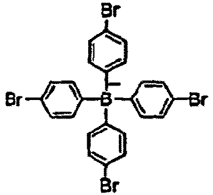 |
| A1-10 | A1-11 | A1-12 |
| 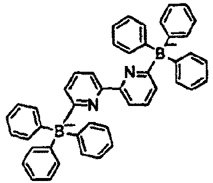 | 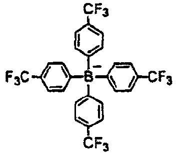 | 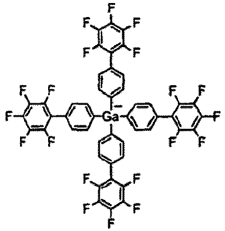 |
| A1-13 | A1-14 | A1-15 |
| 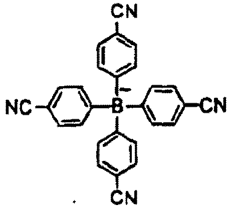 | 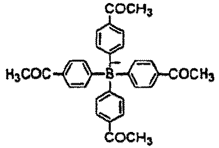 | 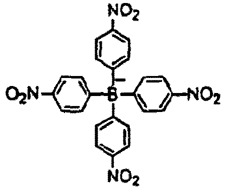 |
| A1-16 | A1-17 | A1-18 |

Besonders bevorzugt sind Kombinationen des Anions A1-1 mit den Kationen K1-1, K1-2, K1-3, K1-4, K1-5, K1-6, K1-7 und/oder K1-8. Ferner sind Kombinationen des Anions A1-3 mit den Kationen K1-1, K1-2, K1-3, K1-4, K1-5, K1-6, K1-7 und/oder K1-8 bevorzugt. Weiterhin sind Kombinationen des Anions A1-4 mit den Kationen K1-1, K1-2, K1-3, K1-4, K1-5, K1-6, K1-7 und/oder K1-8 bevorzugt.

Weitere bevorzugte Kombinationen von Kationen und Anionen sowie Verfahren zu deren Herstellung sind in der EP 1725079 B1 und der EP 2325190 A1 dargelegt, die zu Offenbarungszwecken in die vorliegende Anmeldung durch Referenz hierauf eingefügt werden. Ferner sind Verfahren zur Herstellung der zuvor dargelegten Salze in Chem. Rev., Vol. 66, 243 (1966) and J. Org. Chem., Vol. 53, 5571 (1988) beschrieben.

Die zuvor dargelegten Salze können als Mischungen eingesetzt werden, wobei diese Mischungen jeweils zwei oder mehr Anionen und/oder zwei oder mehr Kationen aufweisen können.

Neben den Kationen der Formeln (K1), (K2) und/oder (K3) kann das erfindungsgemäß einzusetzende Salz oder die erfindungsgemäße Zusammensetzung weitere Kationen, vorzugsweise radikalische Kationen, aufweisen oder Kationen durch eine Reaktion mit einem erfindungsgemäß einzusetzenden Polymer, beispielsweise durch Oxidation bilden. Ferner kann ein erfindungsgemäß einzusetzendes Salz oder die erfindungsgemäße Zusammensetzung neben Anionen der Formel (A1) weitere Anionen aufweisen. Beispiele dieser zusätzlich einsetzbaren Ionen finden sich unter anderem in der EP 1725079 B1 und der EP 2325190 A1, die zu Offenbarungszwecken in die vorliegende Anmeldung durch Referenz hierauf eingefügt werden.

Der Anteil an erfindungsgemäß einzusetzendem Salz in einer Zusammensetzung der vorliegenden Erfindung kann in einem weiten Bereich liegen. Mit Vorteil kann eine Zusammensetung eingesetzt werden, deren Gewichtsverhältnis von erfindungsgemäß einzusetzendem Polymer zu erfindungsgemäß einzusetzendem Salz im Bereich von 500:1 bis 1:1, vorzugsweise 200:1 bis 5:1, besonders bevorzugt im Bereich von 100:1 bis 7:1, ganz besonders bevorzugt im Bereich von 40:1 bis 9:1 liegt. Der Anteil an erfindungsgemäß einzusetzendem Salz kann vorzugsweise 0,2 bis 50 Gew.-%, besonders bevorzugt 0,5 bis 20 Gew.-%, ganz besonders bevorzugt 1 bis 15 Gew.-% und insbesondere bevorzugt 3 bis 10 Gew.-% betragen, bezogen auf die Summe aus Polymer und Salz. Eine Verwendung von einem größeren oder einem geringeren Anteil an Salz ist möglich, jedoch nimmt in diesem Fall die Leistungsfähigkeit der Zusammensetzung, der hieraus erhältlichen funktionalen Schichten oder der diese Schichten enthaltenden optoelektronischen Bauteile unerwartet ab. Der Anteil an erfindungsgemäß einzusetzendem Salz kann vorzugsweise 0,2 bis 50 Gew.-%, besonders bevorzugt 0,5 bis 20 Gew.-%, ganz besonders bevorzugt 1 bis 15 Gew.-% und insbesondere bevorzugt 3 bis 10 Gew.-% betragen, bezogen auf das Gewicht der Zusammensetzung. Der Anteil an erfindungsgemäß einzusetzendem Polymer kann vorzugsweise 50 bis 99,8 Gew.-%, besonders bevorzugt 80 bis 99,5 Gew.-%, ganz besonders bevorzugt 85 bis 99 Gew.-% und insbesondere bevorzugt 90 bis 97 Gew.-% betragen, bezogen auf das Gewicht der Zusammensetzung. Die Gewichtsprozentangaben beziehen sich hierbei auf Salze oder Polymere, die die zuvor dargestellten essentiellen Merkmale aufweisen. Andere Salze oder Polymere werden bei diesen Gewichtsangaben nicht berücksichtigt.

Ein weiterer Gegenstand der vorliegenden Erfindung ist ein Verfahren zur Herstellung einer erfindungsgemäßen Zusammensetzung, welches dadurch gekennzeichnet ist, dass ein Polymer mit Struktureinheiten der Formel (la) in Berührung mit einem Salz umfassend mindestens ein Kation gemäß einer der Formeln (K1), (K2) oder (K3) und mindestens ein Anion gemäß der Formel (A1) gebracht wird.

Die Art, wie das Salz mit dem Polymeren in Berührung gebracht wird ist hierbei unkritisch. Beispielsweise kann eine Lösung eines Polymeren mit einer Lösung eines Salzes gemischt werden. Weiterhin kann ein festes Polymer mit einer Lösung eines Salzes kontaktiert werden. Ferner kann ein festes Salz in eine Polymerlösung eingebracht werden. Vorzugsweise wird eine Lösung eines Polymeren und eines Salzes hergestellt.

Gegenstand der vorliegenden Erfindung sind weiterhin Lösungen und Formulierungen aus einem oder mehreren erfindungsgemäßen Zusammensetzungen. Wie solche Lösungen hergestellt werden können, ist dem Fachmann bekannt und beispielsweise in der WO 02/072714 A1, der WO 03/019694 A2 und der darin zitierten Literatur beschrieben.

Diese Lösungen können verwendet werden, um dünne Polymerschichten herzustellen, zum Beispiel durch Flächenbeschichtungsverfahren (z.B. Spin-coating) oder durch Druckverfahren (z.B. InkJet Printing).

Polymere enthaltend Struktureinheiten, die eine vernetzbare Gruppe Q aufweisen, eignen sich besonders zur Herstellung von Filmen oder Beschichtungen, insbesondere zur Herstellung von strukturierten Beschichtungen, z.B. durch thermische oder lichtinduzierte in-situ-Polymerisation und in-situ-Vernetzung, wie beispielsweise in-situ-UV-Photopolymerisation oder Photopatterning. Dabei können sowohl entsprechende Polymere in Reinsubstanz verwendet werden, es können aber auch Formulierungen oder Mischungen dieser Polymere wie oben beschrieben verwendet werden. Diese können mit oder ohne Zusatz von Lösungsmitteln und/oder Bindemitteln verwendet werden. Geeignete Materialien, Verfahren und Vorrichtungen für die oben beschriebenen Methoden sind z.B. in der WO 2005/083812 A2 beschrieben. Mögliche Bindemittel sind beispielsweise Polystyrol, Polycarbonat, Poly(meth)-acrylate, Polyacrylate, Polyvinylbutyral und ähnliche, optoelektronisch neutrale Polymere.

Geeignete und bevorzugte Lösungsmittel sind beispielsweise Toluol, Anisol, o-, m- oder p-Xylol, Methylbenzoat, Mesitylen, Tetralin, Veratrol, THF, Methyl-THF, THP, Chlorbenzol, Dioxan, Phenoxytoluol, insbesondere 3-Phenoxytoluol, (-)-Fenchon, 1,2,3,5-Tetramethylbenzol, 1,2,4,5-tetramethylbenzol, 1-Methylnaphtalin, 2-Methylbenzothiazol, 2-Phenoxyethanol, 2-Pyrrolidinon, 3-Methylanisol, 4-Methylanisol, 3,4-Dimethylanisol, 3,5-Dimethylanisol, Acetophenon, α-Terpineol, Benzothiazol, Butylbenzoat, Cumol, Cyclohexanol, Cyclohexanon, Cyclohexylbenzol, Decalin, Dodecylbenzol, Ethylbenzoat, Indan, Methylbenzoat, NMP, p-Cymol, Phenetol, 1,4-Diisopropylbenzol, Dibenzyl ether, Diethylenglycolbutylmethylether, Triethylenglycolbutylmethylether, Diethylenglycoldibutylether, Triethylenglycoldimethylether, Diethylenglycolmonobutylether, Tripropylenglycoldimethylether, Tetraethylenglycoldimethylether, 2-lsopropylnaphthalin, Pentylbenzol, Hexylbenzol, Heptylbenzol, Octylbenzol, 1,1-Bis(3,4-Dimethylphenyl)ethan oder Mischungen dieser Lösungsmittel. Bevorzugte Lösungsmittel sind insbesondere Ether und/oder Ester.

Möglich ist somit die Verwendung einer erfindungsgemäßen Zusammensetzung mit einem Polymer, das Struktureinheiten enthält, die eine vernetzbare Gruppe Q aufweisen, zur Herstellung eines vernetzten Polymers. Die vernetzbare Gruppe, die besonders bevorzugt eine Vinylgruppe oder Alkenylgruppe ist, wird vorzugsweise durch die WITTIG-Reaktion oder eine WITTIG-analoge Reaktion in das Polymer eingebaut. Ist die vernetzbare Gruppe eine Vinylgruppe oder Alkenylgruppe, so kann die Vernetzung durch radikalische oder ionische Polymerisation stattfinden, wobei diese thermisch oder durch Strahlung induziert werden kann. Bevorzugt ist die radikalische Polymerisation, die thermisch induziert wird, vorzugsweise bei Temperaturen von weniger als 250°C , besonders bevorzugt bei Temperaturen von weniger als 230°C.

Die durch das erfindungsgemäße Verfahren hergestellten vernetzten Polymere sind in allen gängigen Lösungsmitteln unlöslich. Auf diese Weise lassen sich definierte Schichtdicken herstellen, die auch durch das Aufbringen nachfolgender Schichten nicht wieder gelöst bzw. angelöst werden.

Vorzugsweise kann die erfindungsgemäße Zusammensetzung vor Vernetzung des Polymeren erzeugt werden. Demgemäß kann beispielsweise eine auf ein Substrat oder eine andere Schicht erzeugte Polymerschicht vor Vernetzung mit einem erfindungsgemäß einsetzbaren Salz in Kontakt gebracht werden. Besonders bevorzugt kann eine erfindungsgemäße Zusammensetzung aus Lösung auf ein Substrat oder eine andere Schicht aufgebracht und gegebenenfalls vernetzt werden.

Möglich ist auch eine Zusammensetzung mit einem vernetzten Polymer, das durch das zuvor genannte Verfahren erhältlich ist. Das vernetzte Polymer wird - wie vorstehend beschrieben - vorzugsweise in Form einer vernetzen Polymerschicht hergestellt. Auf die Oberfläche einer solchen vernetzten Polymerschicht kann aufgrund der Unlöslichkeit des vernetzten Polymers in sämtlichen Lösungsmitteln eine weitere Schicht aus einem Lösungsmittel mit den oben beschriebenen Techniken aufgebracht werden.

Möglich sind auch sogenannte Hybridvorrichtungen, in der eine oder mehrere Schichten, die aus Lösung prozessiert werden, und Schichten, die durch Aufdampfen von niedermolekularen Substanzen hergestellt werden, vorkommen können.

Die erfindungsgemäßen Zusammensetzungen können in elektronischen oder optoelektronischen Vorrichtungen bzw. zu deren Herstellung verwendet werden.

Möglich ist somit die Verwendung der erfindungsgemäßen Zusammensetzungen in elektronischen oder optoelektronischen Vorrichtungen, vorzugsweise in organischen Elektrolumineszenzvorrichtungen (OLED), organischen Feld-Effekt-Transistoren (OFETs), organischen integrierten Schaltungen (O-ICs), organischen Dünnfilmtransistoren (TFTs), organischen Solarzellen (O-SCs), organischen Laserdioden (O-Laser), organischen photovoltaischen (OPV) Elementen oder Vorrichtungen oder organischen Photorezeptoren (OPCs), besonders bevorzugt in organischen Elektrolumineszenzvorrichtungen (OLED).

Im Fall der zuvor genannten Hybridvorrichtung spricht man in Verbindung mit organischen Elektrolumineszenzvorrichtungen von kombinierten PLED/SMOLED (Polymeric Light Emitting Diode/Small Molecule Organic Light Emitting Diode) Systemen.

Wie OLEDs hergestellt werden können, ist dem Fachmann bekannt und wird beispielsweise als allgemeines Verfahren ausführlich in der WO 2004/070772 A2 beschrieben, das entsprechend für den Einzelfall anzupassen ist.

Wie oben beschrieben, eignen sich die erfindungsgemäßen Zusammensetzungen ganz besonders als Elektrolumineszenzmaterialien in derart hergestellten OLEDs oder Displays.

Als Elektrolumineszenzmaterialien im Sinne der vorliegenden Erfindung gelten Materialien, die als aktive Schicht Verwendung finden können. Aktive Schicht bedeutet, dass die Schicht befähigt ist, bei Anlegen eines elektrischen Feldes Licht abzustrahlen (lichtemittierende Schicht) und/oder dass sie die Injektion und/oder den Transport der positiven und/oder negativen Ladungen verbessert (Ladungsinjektions- oder Ladungstransportschicht).

Bevorzugt ist daher auch die Verwendung der erfindungsgemäßen Zusammensetzungen in OLEDs, insbesondere als Elektrolumineszenzmaterial.

Gegenstand der vorliegenden Erfindung sind ferner elektronische oder optoelektronische Bauteile, vorzugsweise organische Elektrolumineszenzvorrichtungen (OLED), organische Feld-Effekt-Transistoren (OFETs), organische integrierte Schaltungen (O-ICs), organische Dünnfilmtransistoren (TFTs), organische Solarzellen (O-SCs), organische Laserdioden (O-Laser), organische photovoltaische (OPV) Elemente oder Vorrichtungen und organische Photorezeptoren (OPCs), besonders bevorzugt organische Elektrolumineszenzvorrichtungen, mit einer oder mehreren aktiven Schichten, wobei mindestens eine dieser aktiven Schichten eine erfindungsgemäße Zusammensetzung enthält. Die aktive Schicht kann beispielsweise eine lichtemittierende Schicht, eine Ladungstransportschicht und/oder eine Ladungsinjektionsschicht sein.

Besonders bevorzugt kann die aktive Schicht eine Zusammensetzung der vorliegenden Erfindung mit einem vernetzten Polymer umfassen.

Im vorliegenden Anmeldungstext und auch in den im Weiteren folgenden Beispielen wird hauptsächlich auf die Verwendung der erfindungsgemäßen Zusammensetzungen in Bezug auf OLEDs und entsprechende Displays abgezielt. Trotz dieser Beschränkung der Beschreibung ist es für den Fachmann ohne weiteres erfinderisches Zutun möglich, die erfindungsgemäßen Zusammensetzungen als Halbleiter auch für die weiteren, oben beschriebenen Verwendungen in anderen elektronischen Vorrichtungen zu benutzen.

Die folgenden Beispiele sollen die Erfindung erläutern, ohne sie einzuschränken. Insbesondere sind die darin beschriebenen Merkmale, Eigenschaften und Vorteile der dem betreffenden Beispiel zu Grunde liegenden definierten Verbindungen auch auf andere, nicht im Detail aufgeführte, aber unter den Schutzbereich der Ansprüche fallende Verbindungen anwendbar, sofern an anderer Stelle nichts Gegenteiliges gesagt wird.

### Beispiele:

### Teil A: Synthese der Monomere

Die Monomere zur Herstellung der erfindungsgemäßen Zusammensetzungen sind bereits im Stand der Technik beschrieben, kommerziell erhältlich oder werden gemäß Literaturvorschrift hergestellt und sind in der nachfolgenden Tabelle zusammengefaßt:

| Monomer | Struktur | Synthese gemäß |
|---|---|---|
| Mo1 | 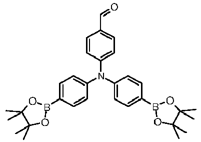 | WO 2010/097155 A1 |
| Mo2 | 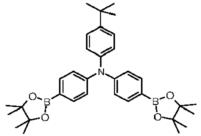 | WO 99/048160 A1 |
| Mo3 | 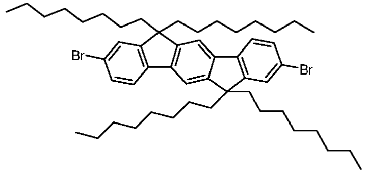 | Macromolecules 2000, 33, 2016-2020 |
| Mo4 | 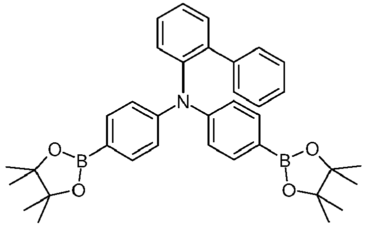 | WO2013/156130 |
| Mo5 | 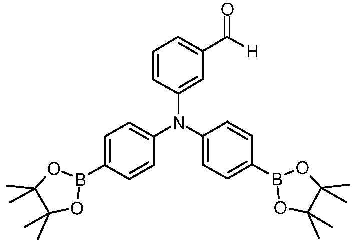 | WO2013/156130 |
| Mo6 | 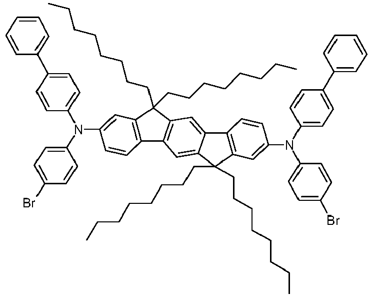 | WO2013/156130 |
| Mo7 | 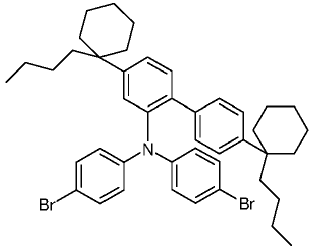 | WO2013/156130 (analog Mo14) |

### Teil B: Synthese der Polymere

Die Vergleichspolymere V1 und V2 sowie die erfindungsgemäßen Polymere P1 bis P6 werden durch SUZUKI-Kupplung gemäß dem in der WO 2010/097155 beschriebenen Verfahren aus den im Teil A offenbarten Monomeren hergestellt.

Die auf diese Weise hergestellten Polymere V1 und V2 sowie P1 bis P6 enthalten die Struktureinheiten nach Abspaltung der Abgangsgruppen in den in der Tabelle 2 angegebenen prozentualen Anteilen (Prozentangaben = mol%). Bei den Polymeren, die aus Monomeren hergestellt werden, die Aldehydgruppen aufweisen, werden diese nach der Polymerisation durch WITTIG Reaktion gemäß dem in der WO 2010/097155 beschriebenen Verfahren in vernetzbare Vinylgruppen überführt. Die entsprechend in Tabelle 2 aufgeführten sowie im Teil C eingesetzten Polymere weisen somit vernetzbare Vinylgruppen anstelle der ursprünglich vorhandenen Aldehydgruppen auf.

Die Palladium- und Bromgehalte der Polymeren werden per ICP-MS bestimmt. Die ermittelten Werte liegen unter 10 ppm.

Die Molekulargewichte Mw sowie die Polydispersitäten D werden mittels Gelpermeationschromatographie (GPC) (Model: Agilent HPLC System Series 1100) ermittelt (Säule: PL-RapidH von Polymer Laboratories; Lösungsmittel: THF mit 0,12 Vol% o-Dichlorbenzol; Detektion: UV und Brechungsindex; Temperatur: 40°C). Kalibriert wird mit Polystyrolstandards.

Die Ergebnisse sind in Tabelle 2 zusammengefasst.

**Tabelle 2**

| Polymer | Triarylamin mit ortho-Substituent | | | | | | weitere Monomere | | | | | | Molekulargew. M_{W} (g/mol) | Polydisp. D |
|---|---|---|---|---|---|---|---|---|---|---|---|---|---|---|
| V1 | | | | | | | Mo2 | 50% | Mo3 | 50% | | | 438 000 | 3,3 |
| V2 | | | | | | | Mo2 | 40% | Mo1 | 10% | Mo3 | 50% | 417 000 | 3,1 |
| P1 | Mo4 | 50% | | | | | Mo3 | 50% | | | | | 339 000 | 3,1 |
| P2 | Mo4 | 40% | | | | | Mo3 | 50% | Mo1 | 10% | | | 328 000 | 2,9 |
| P3 | Mo4 | 50% | | | | | Mo6 | 50% | | | | | | |
| P4 | Mo4 | 40% | | | | | Mo6 | 50% | Mo1 | 10% | | | 123 000 | 3,3 |
| P5 | Mo4 | 40% | | | | | Mo3 | 50% | Mo5 | 10% | | | 300 000 | 2,7 |
| P6 | Mo4 | 40% | Mo7 | 50% | | | Mo1 | 10% | | | | | | |

### Teil C: Dotanten

Die Dotanten zur Herstellung der erfindungsgemäßen Zusammensetzungen sind bereits im Stand der Technik beschrieben, kommerziell erhältlich und sind in der nachfolgenden Tabelle zusammengefasst:

| Dotant | Struktur | CAS |
|---|---|---|
| D1 | 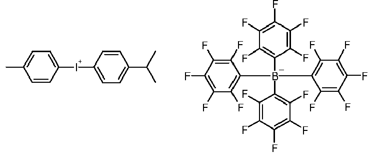 | 178233-72-2 |
| D2 | 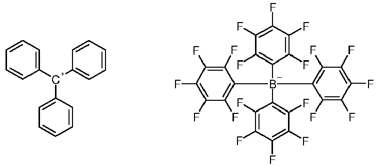 | 136040-19-2 |

### Teil D: Device-Beispiele

Die erfindungsgemäßen Zusammensetzungen aus Polymer und Salz können aus Lösung verarbeitet werden und führen gegenüber vakuumprozessierten OLEDs zu wesentlich einfacher herstellbaren OLEDs mit dennoch guten Eigenschaften.

Ob die vernetzbaren Varianten der erfindungsgemäßen Zusammensetzungen (enthaltend vernetzbare Polymere) nach Vernetzung eine vollständig unlösliche Schicht ergeben, wird analog zu WO 2010/097155 getestet.

In Tabelle D1 ist die verbliebene Schichtdicke der ursprünglich 20 nm nach dem in der WO 2010/097155 beschriebenen Waschvorgang aufgeführt. Verringert sich die Schichtdicke nicht, so ist die Zusammensetzung aus Polymer und Salz unlöslich und somit die Vernetzung ausreichend.

**Tabelle D1:**

| Kontrolle der Restschichtdicke von ursprünglich 20 nm nach Waschtest | | | |
|---|---|---|---|
| Polymer | Salz | Massen-Verhältnis Polymer: Salz | Restschichtdicke nach Waschtest [in nm] |
| | | | Vernetzung bei 220°C |
| V1 | D1 | 97 : 3 | 3,5 |
| V2 | D1 | 97 : 3 | 20 |
| P2 | D1 | 90 : 10 | 20 |
| P4 | D1 | 90 : 10 | 20 |
| P6 | D1 | 97 : 3 | 20 |

Wie Tabelle D1 zu entnehmen ist, vernetzt die Zusammensetzung mit Vergleichspolymer V1, das keine Vernetzungsgruppe trägt, bei 220°C fast gar nicht. Die Zusammensetzungen mit Vergleichspolymer V2 sowie den erfindungsgemäßen Polymere P2, P4 und P6 vernetzen dagegen bei 220°C vollständig.

Die Herstellung solcher lösungsbasierter OLEDs ist in der Literatur bereits vielfach beschrieben, z.B. in der WO 2004/037887 und der WO 2010/097155. Das Verfahren wird auf die im Folgenden beschriebenen Gegebenheiten (Schichtdickenvariation, Materialien) angepasst.

Die erfindungsgemäßen Polymere werden in drei verschiedenen Schichtabfolgen verwendet:
Aufbau A ist wie folgt:
   - Substrat,
   - ITO (50 nm),
   - Lochinjektionsschicht (HIL) (100 nm),
   - Kathode.
Aufbau B ist wie folgt:
   - Substrat,
   - ITO (50 nm),
   - HIL (20 nm),
   - Lochtransportschicht (HTL) (40 nm),
   - Emissionsschicht (EML) (30 nm),
   - Elektronentransportschicht (ETL) (20 nm),
   - Kathode.
Aufbau C ist wie folgt:
   - Substrat,
   - ITO (50 nm),
   - HIL (20 nm),
   - HTL (20 nm),
   - EML (60 nm),
   - Lochblockierschicht (HBL) (10 nm)
   - ETL (40 nm),
   - Kathode.

Als Substrat dienen Glasplättchen, die mit strukturiertem ITO (Indium-ZinnOxid) der Dicke 50 nm beschichtet sind. Auf diese beschichteten Glasplättchen werden die Lochinjektions-, Lochtransport- und die Emissionsschicht aufgebracht.

Als Lochinjektionsschicht werden die erfindungsgemäßen Zusammensetzungen aus Polymer und Salz sowie Vergleichsmischungen verwendet, jeweils in Toluol gelöst. Der typische Feststoffgehalt solcher Lösungen liegt bei ca. 5 bis 15 g/l, wenn Schichtdicken zwischen 20 nm und 100 nm mittels Spincoating erzielt werden sollen. Die Schichten werden in einer Inertgasatmosphäre, im vorliegenden Fall Argon, aufgeschleudert und 60 Minuten bei 180°C oder 220°C ausgeheizt.

Die Lochtransportschichten in Aufbau C werden aus Toluol prozessiert. Der typische Feststoffgehalt solcher Lösungen liegt bei ca. 5 g/l, wenn mittels Spincoating Schichtdicken von 20 nm erzielt werden soll. Die Schichten werden in einer Inertgasatmosphäre, im vorliegenden Fall Argon, aufgeschleudert und 60 Minuten bei 180°C oder 220°C ausgeheizt.

In Aufbau B wird die Lochtransportschicht durch thermische Verdampfung in einer Vakuumkammer gebildet.

Die im vorliegenden Fall verwendeten Materialien sind in Tabelle D2 gezeigt.

**Tabelle D2:**

| Strukturformel des in dem aus Vakuum prozessierten lochtransportierenden Materials | |
|---|---|
| 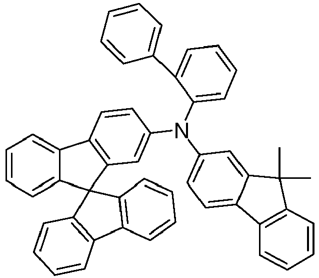 | |
| HT1 | |

Die Emissionsschicht setzt sich immer aus mindestens einem Matrixmaterial (Hostmaterial, Wirtsmaterial) und einem emittierenden Dotierstoff (Dotand, Emitter) zusammen. Weiterhin auftreten können Mischungen aus mehreren Matrixmaterialien sowie Co-Dotanden. Eine Angabe wie H1 (92%) : Dotand (8%) bedeutet hierbei, dass das Material H1 in einem Gewichtsanteil von 92% und der Dotand in einem Gewichtsanteil von 8% in der Emissionsschicht vorliegt. Die Mischung für die Emissionsschicht wird für Aufbau C in Toluol gelöst. Der typische Feststoffgehalt solcher Lösungen liegt bei ca. 18 g/l, wenn, wie hier, die für eine Device typische Schichtdicke von 60 nm mittels Spincoating erzielt werden soll. Die Schichten werden in einer Inertgasatmosphäre, im vorliegenden Fall Argon, aufgeschleudert und 10 Minuten bei 180°C ausgeheizt. In Aufbau B wird die Emissionsschicht durch thermische Verdampfung in einer Vakuumkammer gebildet. Dabei kann die Schicht aus mehr als einem Material bestehen, die einander durch Co-Verdampfung in einem bestimmten Volumenanteil beigemischt werden. Eine Angabe wie H3:Dotand (95%:5%) bedeutet hierbei, dass die Materialien H3 und Dotand in einem Volumenanteil von 95%:5% in der Schicht vorliegen.

Die im vorliegenden Fall verwendeten Materialien sind in Tabelle D3 gezeigt.

**Tabelle D3:**

| Strukturformeln der in der Emissionsschicht verwendeten Materialien | |
|---|---|
| 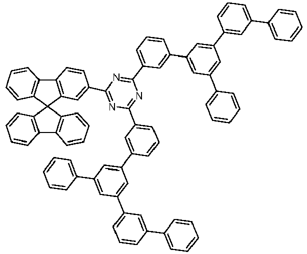 | 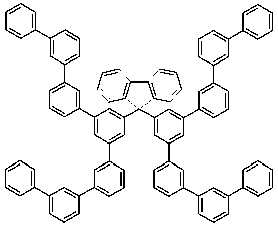 |
| M1 | M2 |
| 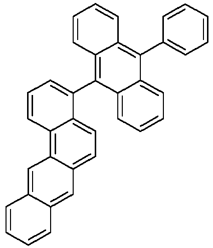 | |
| M3 | |
| 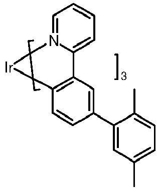 | 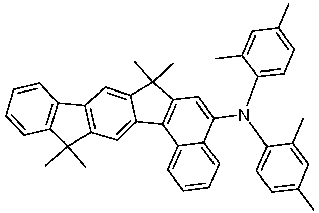 |
| TEG | SEB |

Die Materialien für die Lochblockierschicht und Elektronentransportschicht werden ebenfalls in einer Vakuumkammer thermisch aufgedampft und sind in Tabelle D4 gezeigt. Die Lochblockierschicht besteht aus ETM1. Die Elektronentransportschicht besteht aus den zwei Materialien ETM1 und ETM2, die einander durch Co-Verdampfung in einem Volumenanteil von jeweils 50% beigemischt werden.

**Tabelle D4:**

| Verwendete HBL- und ETL-Materialien | |
|---|---|
| 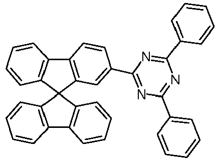 | 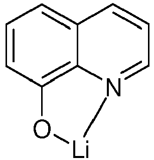 |
| ETM1 | ETM2 |

Die Kathode wird durch die thermische Verdampfung einer 100 nm dicken Aluminiumschicht gebildet.

Der genaue Aufbau der OLEDs ist Tabelle D5 zu entnehmen. In der Spalte HTL wird das verwendete Polymer aufgeführt, sowie die Temperatur, bei der die Schicht ausgeheizt und ggf. vernetzt wird.

**Tabelle D5:**

| Aufbau der OLEDs | | | | | | | | |
|---|---|---|---|---|---|---|---|---|
| Beispiel | Aufbau | HIL | | | | HTL | | EML |
| | | Polymer | Salz | Massen-verhältnis Polymer: Salz | T [°C] | Polymer | T [°C] | Zusammensetzung |
| D1 | B | V1 | D1 | 97:3 | 180 | - | - | M3 95%; SEB 5% |
| D2 | C | V2 | D1 | 97:3 | 180 | P2 | 180°C | M1 30%; M2 55%; TEG 15% |
| D3 | A | P1 | - | - | 180 | - | - | - |
| D4 | A | P1 | D1 | 97:3 | 180 | - | - | - |
| D5 | A | P3 | - | - | 180 | - | - | - |
| D6 | A | P3 | D1 | 97:3 | 180 | - | - | - |
| D7 | B | P3 | D1 | 97:3 | 180 | - | - | M3 95%; SEB 5% |
| D8 | B | P1 | D1 | 97:3 | 180 | - | - | M3 95%; SEB 5% |
| D9 | C | P2 | D1 | 97:3 | 180 | P2 | 180 | M1 30%; M2 55%; TEG 15% |
| D10 | C | P4 | D1 | 97:3 | 220 | P2 | 180 | M1 30%; M2 55%; TEG 15% |

Die OLEDs werden standardmäßig charakterisiert. Hierfür werden die Elektrolumineszenzspektren, Strom-Spannungs-Leuchtdichte-Kennlinien (IUL-Kennlinien) unter Annahme einer Lambert'schen Abstrahlcharakteristik sowie im Fall von Aufbau B und C die (Betriebs-)Lebensdauer bestimmt. Aus den IUL-Kennlinien werden Kennzahlen bestimmt wie die Betriebsspannung (in V) und die externe Quanteneffizienz (in %) bei einer bestimmten Helligkeit. LD80 @ 1000cd/m² ist die Lebensdauer, bis die OLED bei einer Starthelligkeit von 1000 cd/m² auf 80 % der Anfangsintensität, also auf 800 cd/m², abgefallen ist.

Die Eigenschaften der verschiedenen OLEDs sind in den Tabellen D6 a und b zusammengefasst. Die Beispiele D1 und D2 sind Vergleichsbeispiele, alle anderen Beispiele zeigen Eigenschaften von erfindungsgemäßen OLEDs.

### Tabellen D6 a-b:

Eigenschaften der OLEDs

**Tabelle D6 a**

| Beispiel | Spannung bei 1 mA/cm² |
|---|---|
| | [V] |
| D3 | 6 |
| D4 | 0,4 |
| D5 | 3 |
| D6 | 0,2 |

**Tabelle D6 b**

| Beispiel | Effizienz bei 1000 cd/m² | Spannung bei 1000 cd/m² | LD80 bei 1000 cd/m² |
|---|---|---|---|
| | % EQE | [V] | [h] |
| D1 | 8,2 | 4,3 | 95 |
| D2 | 16,6 | 4,8 | 240 |
| D7 | 8,0 | 4,4 | 285 |
| D8 | 8,3 | 4,2 | 320 |
| D9 | 16,7 | 4,7 | 255 |
| D10 | 16,5 | 4,3 | 278 |

Tabelle D6 a zeigt, dass die Spannungen von Bauteilen aus erfindungsgemäßen Zusammensetzungen (Polymer und Salz) signifikant niedriger sind als deren Pendants ohne Salz. Die erfindungsgemäßen Mischungen sind somit als Lochinjektionsmaterialien geeignet, welche die Betriebsspannung der OLED herabsetzen.

Tabelle D6 b zeigt, dass die Verwendung der erfindungsgemäßen Mischungen zu einer verbesserten Lebensdauer gegenüber dem Stand der Technik führt.

## Patentansprüche

1. Zusammensetzung umfassend mindestens ein Polymer und mindestens ein Salz, **dadurch gekennzeichnet, dass** das Polymer mindestens eine Struktureinheit der folgenden Formel (la) aufweist: 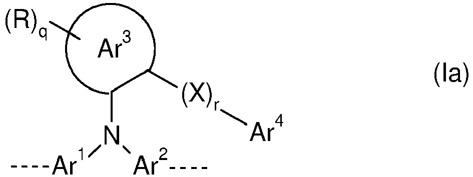 wobei
Ar¹, Ar² und Ar³ bei jedem Auftreten, jeweils gleich oder verschieden, ein mono- oder polycyclisches, aromatisches oder heteroaromatisches Ringsystem ist, das mit einem oder mehreren Resten R substituiert sein kann;
Ar⁴ ein mono- oder polycyclisches, aromatisches oder heteroaromatisches Ringsystem mit 5 bis 60 aromatischen Ringatomen ist, das mit einem oder mehreren Resten R substituiert sein kann;
R bei jedem Auftreten gleich oder verschieden H, D, F, Cl, Br, I, N(R¹)₂, CN, NO₂, Si(R¹)₃, B(OR¹)₂, C(=O)R¹, P(=O)(R¹)₂, S(=O)R¹, S(=O)₂R¹, OSO₂R¹, eine geradkettige Alkyl-, Alkoxy- oder Thioalkoxygruppe mit 1 bis 40 C-Atomen oder eine Alkenyl- oder Alkinylgruppe mit 2 bis 40 C-Atomen oder eine verzweigte oder cyclische Alkyl-, Alkoxy- oder Thioalkoxygruppe mit 3 bis 40 C-Atomen, die jeweils mit einem oder mehreren Resten R¹ substituiert sein kann, wobei eine oder mehrere nicht benachbarte CH₂-Gruppen durch R¹C=CR¹, C=C, Si(R¹)₂, C=O, C=S, C=NR¹, P(=O)(R¹), SO, SO₂, NR¹, O, S oder CONR¹ ersetzt sein können und wobei ein oder mehrere H-Atome durch D, F, Cl, Br, I oder CN ersetzt sein können, oder ein aromatisches oder heteroaromatisches Ringsystem mit 5 bis 60 aromatischen Ringatomen, das jeweils durch einen oder mehrere Reste R¹ substituiert sein kann, oder eine Aryloxy- oder Heteroaryloxygruppe mit 5 bis 60 aromatischen Ringatomen, die durch einen oder mehrere Reste R¹ substituiert sein kann, oder eine Aralkyl- oder Heteroaralkylgruppe mit 5 bis 60 aromatischen Ringatomen, die durch einen oder mehrere Reste R¹ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R¹ substituiert sein kann; ist; wobei zwei oder mehrere Reste R auch miteinander ein mono- oder polycyclisches, aliphatisches, aromatisches und/oder benzoannelliertes Ringsystem bilden können;
R¹ bei jedem Auftreten gleich oder verschieden H, D, F oder ein aliphatischer, aromatischer und/oder heteroaromatischer Kohlenwasserstoffrest mit 1 bis 20 C-Atomen ist, in dem auch ein oder mehrere H-Atome durch F ersetzt sein können; wobei zwei oder mehrere Substituenten R¹ auch miteinander ein mono- oder polycyclisches, aliphatisches oder aromatisches Ringsystem bilden können;
q 0, 1, 2, 3, 4, 5 oder 6 ist;
X CR₂, NR, SiR₂, O, S, C=O oder P=O, vorzugsweise CR₂, SiR₂, NR, O oder S ist;
r 0 oder 1 ist.
und
die gestrichelten Linien Bindungen zu benachbarten Struktureinheiten im Polymer darstellen;
das Salz mindestens ein Kation der folgenden Formeln (K1), (K2) und/oder (K3): 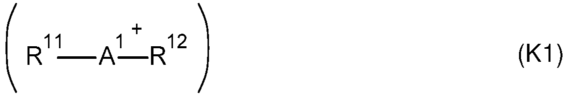 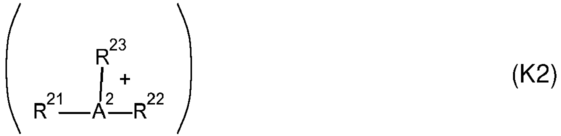 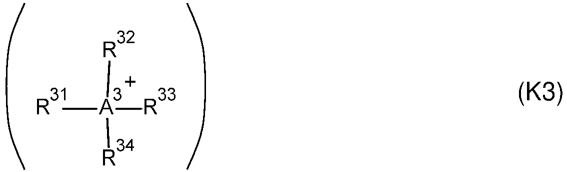
wobei der Rest A¹, ein Element der 17 Gruppe des Periodensystems der Elemente ist; der Rest A², ein Element der 16 Gruppe des Periodensystems der Elemente ist; und A³, ein Element der 15 Gruppe des Periodensystems der Elemente ist;
und die Reste R¹¹, R²¹, R³¹, einen beliebigen Rest bedeuten, vorzugsweise eine Kohlenstoffatom-haltige Gruppe darstellen, die über ein Kohlenstoffatom jeweils an den Rest A¹, A² oder A³ bindet; die Reste R¹², R²², R²³, R³², R³³ und R³⁴ jeweils eine Kohlenstoffatom-haltige Gruppe darstellen, die über ein Kohlenstoffatom jeweils an den Rest A¹, A² oder A³ bindet, wobei ein oder mehrere der Reste R¹¹ bis R³⁴ auch miteinander ein mono- oder polycyclisches, aliphatisches, heteroaliphatisches, heteroaromatisches oder aromatisches Ringsystem bilden können;
und mindestens ein Anion der folgenden Formel (A1) 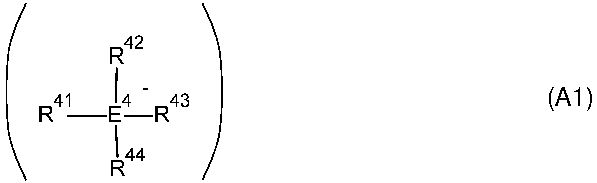
wobei der Rest E⁴ ein Element der 13 Gruppe des Periodensystems der Elemente bedeutet;
und die Reste R⁴¹, R⁴², R⁴³ und R⁴⁴ jeweils ein aromatisches oder heteroaromatisches Ringsystem mit 5 bis 60 aromatischen Ringatomen darstellen, das jeweils durch einen oder mehrere Reste R substituiert sein kann, wobei ein oder mehrere der Reste R⁴¹, R⁴², R⁴³ und R⁴⁴ auch miteinander ein mono- oder polycyclisches, aliphatisches, heteroaliphatisches, heteroaromatisches oder aromatisches Ringsystem bilden können;
umfasst.

2. Zusammensetzung nach Anspruch 1, **dadurch gekennzeichnet, dass** Ar³ in einer der beiden ortho-Positionen mit Ar⁴ substituiert ist, und Ar³ mit Ar⁴ zusätzlich noch in der zur substituierten ortho-Position benachbarten meta-Position verknüpft ist.

3. Zusammensetzung nach Anspruch 1 oder 2, **dadurch gekennzeichnet, dass** das Polymer mindestens eine Struktureinheit der Formel (la) umfasst, die ausgewählt ist aus der Struktureinheit der folgenden Formel (lb): 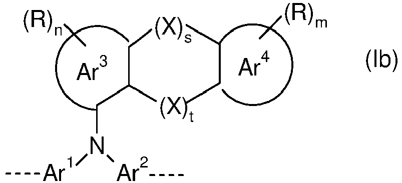
wobei Ar¹, Ar², Ar³, Ar⁴, R, und X die im Anspruch 1 angegebenen Bedeutungen annehmen können,
m = 0, 1, 2, 3 oder 4 ist, und
n = 0, 1, 2 oder 3 ist, und
s und t jeweils 0 oder 1 sind, wobei die Summe (s + t) = 1 oder 2, ist.

4. Zusammensetzung nach einem oder mehreren der Ansprüche 1 bis 3, **dadurch gekennzeichnet, dass** die mindestens eine Struktureinheit der Formel (la) ausgewählt ist aus Struktureinheiten der folgenden Formeln (II), (III) und (IV): 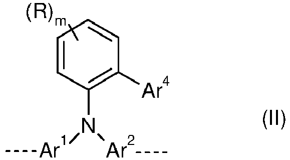 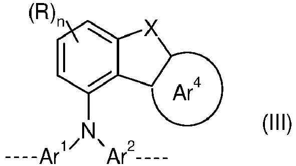 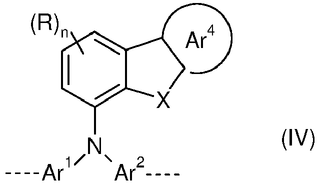 wobei Ar¹, Ar², Ar⁴, R, m, n und X die in den Ansprüchen 1 und 3 angegebenen Bedeutungen annehmen können.

5. Zusammensetzung nach einem oder mehreren der Ansprüche 1 bis 4, **dadurch gekennzeichnet, dass** das Polymer mindestens eine Struktureinheit der Formel (la) umfasst, die ausgewählt ist aus der Struktureinheit der folgenden Formel (VIIIa): 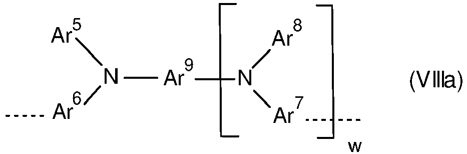 oder der Struktureinheit der folgenden Formel (Vlllb): 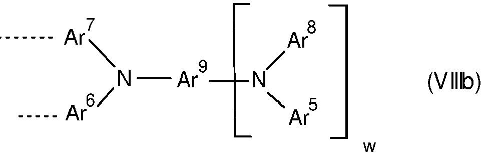 wobei w = 1, 2 oder 3 ist, Ar⁵ bis Ar⁹ bei jedem Auftreten, jeweils gleich oder verschieden, ein mono- oder polycyclisches, aromatisches oder heteroaromatisches Ringsystem ist, das mit einem oder mehreren Resten R substituiert sein kann, wobei R die in Anspruch 1 dargelegte Bedeutung annehmen kann; die gestrichelten Linien Bindungen zu benachbarten Struktureinheiten im Polymer darstellen.

6. Zusammensetzung nach Anspruch 5, **dadurch gekennzeichnet, dass** mindestens einer der Rest Ar⁵ und/oder Ar⁸ gemäß Formeln (VIIIa) und/oder (VIIIb) in mindestens einer, vorzugsweise in einer der beiden ortho-Positionen, bezogen auf die Position des in Formel (VIIIa) und/oder (VIIIb) dargestellten Stickstoffatoms, mit Ar⁴ substituiert ist, wobei Ar⁴ ein mono- oder polycyclisches, aromatisches oder heteroaromatisches Ringsystem mit 5 bis 60 aromatischen Ringatomen ist, das mit einem oder mehreren Resten R substituiert sein kann, wobei R die in Anspruch 1 dargelegte Bedeutung annehmen kann.

7. Zusammensetzung nach Anspruch 5 oder 6, **dadurch gekennzeichnet, dass** die mindestens eine Struktureinheit der Formel (VIIIa) ausgewählt ist aus den Struktureinheiten der folgenden Formeln (VIIIa-1a), (VIIIa-1 b), (VIIIa-1 c) und (VIIIa-1d): 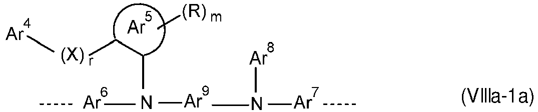 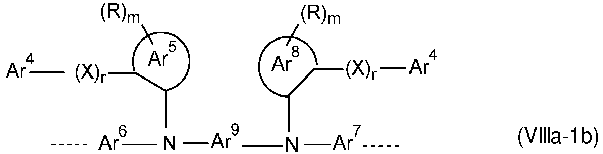 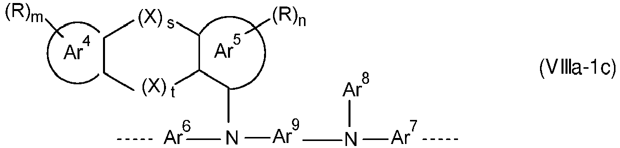 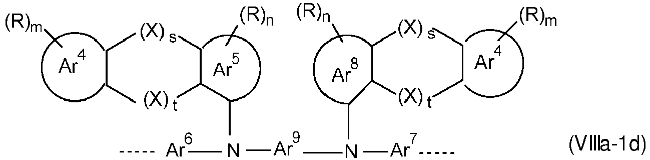 wobei Ar⁴, Ar⁵, Ar⁶, Ar⁷, Ar⁸, Ar⁹, X, m, n, r, s, t, R und die gestrichelten Linien die oben in den Ansprüchen 1, 3 und 5 angegebenen Bedeutungen annehmen können.

8. Zusammensetzung nach einem oder mehreren der Ansprüche 1 bis 7, **dadurch gekennzeichnet, dass** mindestens eine der Struktureinheiten der Formeln (la), (II), (III), (IV), (V), (VI), (VII), (VIIIa), (VIIIb), (IX), (X), (XI), (XII), (XIII), (XIV), (XV) und/oder (XVI) mindestens eine vernetzbare Gruppe Q aufweist.

9. Zusammensetzung nach einem oder mehreren der Ansprüche 1 bis 8, **dadurch gekennzeichnet, dass** die mono- oder polycyclischen, aromatischen oder heteroaromatischen Gruppen Ar³ in Formel (la), Ar⁴ in Anspruch 1, in Anspruch 7 und in Formeln (la) und/oder (Ib), Ar⁵ und Ar⁸ in Formeln (VIIIa) und/oder (Vlllb) ausgewählt sind aus:
| | | |
|---|---|---|
| 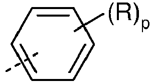 | 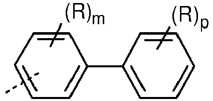 | 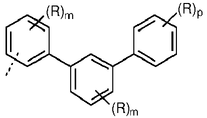 |
| E1 | E2 | E3 |
| 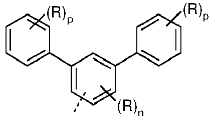 | 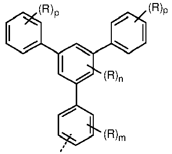 | 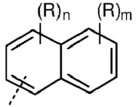 |
| E4 | E5 | E6 |
| 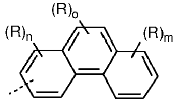 | 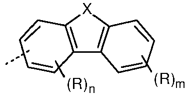 | 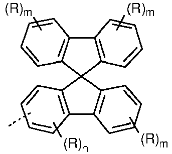 |
| E7 | E8 | E9 |
| 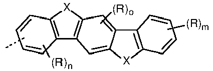 | 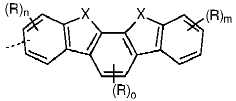 | 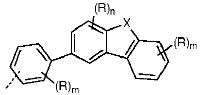 |
| E10 | E11 | E12 |
wobei
die Reste R in den Formeln E1 bis E12 die gleiche Bedeutung annehmen können, wie die Reste R in Bezug auf die Formel (la) in Anspruch 1,
X CR₂, NR, SiR₂, O, S, C=O oder P=O, vorzugsweise CR₂, SiR₂, NR, O oder S bedeuten kann, wobei auch hier R die gleiche Bedeutung annehmen kann, wie die Reste R in Bezug auf die Formel (la) in Anspruch 1,
die gestrichelten Linien Bindungen zu benachbarten Struktureinheiten im Polymer darstellen und
die verwendeten Indices die folgende Bedeutung haben:
m = 0, 1, 2, 3 oder 4;
n = 0, 1, 2 oder 3;
o = 0, 1 oder 2; und
p = 0, 1, 2, 3, 4 oder 5.

10. Zusammensetzung nach einem oder mehreren der Ansprüche 1 bis 9, **dadurch gekennzeichnet, dass** die mono- oder polycyclischen, aromatischen oder heteroaromatischen Gruppen Ar¹ und Ar² in Formel (la), Ar⁶, Ar⁷ und Ar⁹ in Formeln (VIIIa) und/oder (VIIIb) ausgewählt sind aus:
| | | |
|---|---|---|
| 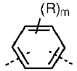 | 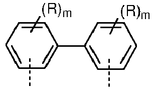 | 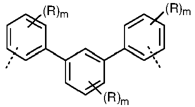 |
| M1 | M2 | M3 |
| 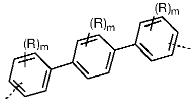 | 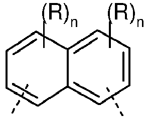 | 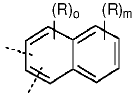 |
| M4 | M5 | M6 |
| 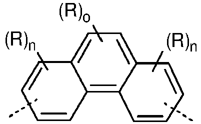 | 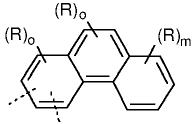 | 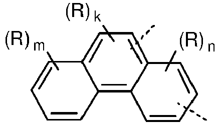 |
| M7 | M8 | M9 |
| 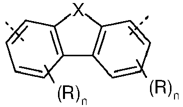 | 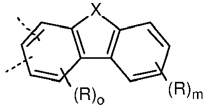 | 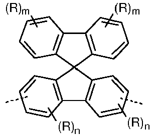 |
| M10 | M11 | M12 |
| 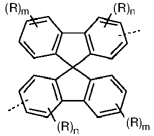 | 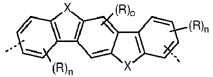 | 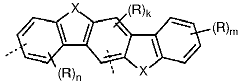 |
| M13 | M14 | M15 |
| 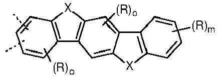 | 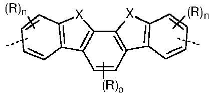 | 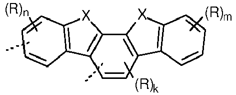 |
| M16 | M17 | M18 |
| 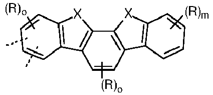 | 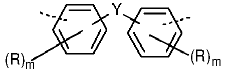 | |
| M19 | M20 | |
| 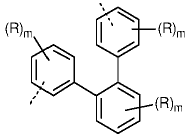 | 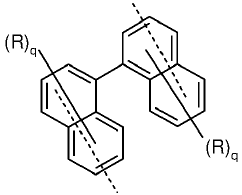 | 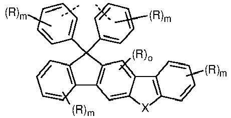 |
| M21 | M22 | M23 |
wobei
die Reste R in den Formeln M1 bis M23 die gleiche Bedeutung annehmen können, wie die Reste R in Bezug auf die Formel (la) in Anspruch 1,
X CR₂, NR, SiR₂, O, S, C=O oder P=O, vorzugsweise CR₂, SiR₂, NR, O oder S bedeuten kann, wobei auch hier R die gleiche Bedeutung annehmen kann, wie die Reste R in Bezug auf die Formel (la) in Anspruch 1,
Y CR₂, SiR₂, O, S oder eine geradkettige oder verzweigte Alkylgruppe mit 1 bis 20 C-Atomen oder eine Alkenyl- oder Alkinylgruppe mit 2 bis 20 C-Atomen sein kann, die jeweils mit einem oder mehreren Resten R¹ substituiert sein kann, und wobei eine oder mehrere nicht benachbarte CH₂-Gruppen, CH-Gruppen bzw. C-Atome der Alkyl-, Alkenyl- oder Alkinylgruppen durch Si(R¹)₂, C=O, C=S, C=NR¹, P(=O)(R¹), SO, SO₂, NR¹, O, S, CONR¹ oder ein aromatisches oder heteroaromatisches Ringsystem mit 5 bis 60 aromatischen Ringatomen, das jeweils durch einen oder mehrere Reste R¹ substituiert sein kann, oder eine Aryloxy- oder Heteroaryloxygruppe mit 5 bis 60 aromatischen Ringatomen, die durch einen oder mehrere Reste R¹ substituiert sein kann, oder eine Aralkyl- oder Heteroaralkylgruppe mit 5 bis 60 aromatischen Ringatomen, die durch einen oder mehrere Reste R¹ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste R¹ substituiert sein kann, ersetzt sein können; wobei auch hier die Reste R und R¹ die gleichen Bedeutungen annehmen können, wie die Reste R und R¹ in Formel (la),
die gestrichelten Linien Bindungen zu benachbarten Struktureinheiten im Polymer darstellen und
die verwendeten Indices die folgende Bedeutung haben:
k = 0 oder 1;
m = 0, 1, 2, 3 oder 4;
n = 0, 1, 2 oder 3;
o = 0, 1 oder 2; und
q = 0, 1, 2, 3, 4, 5 oder 6.

11. Zusammensetzung nach einem oder mehreren der Ansprüche 8 bis 10, **dadurch gekennzeichnet, dass** die vernetzbare Gruppe Q ausgewählt ist aus:
- endständigen oder cyclischen Alkenyl- bzw. endständigen Dienyl- und Alkinylgruppen,
- Alkenyloxy-, Dienyloxy- bzw. Alkinyloxygruppen,
- Acrylsäuregruppen,
- Oxetan- und Oxirangruppen,
- Silangruppen, und
- Cyclobutangruppen.

12. Zusammensetzung nach Anspruch 11, **dadurch gekennzeichnet, dass** die vernetzbare Gruppe Q ausgewählt ist aus:
| | |
|---|---|
| 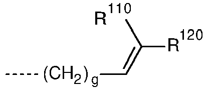 | 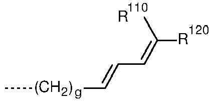 |
| Q1 | Q2 |
| 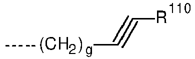 | 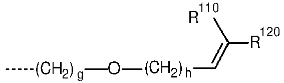 |
| Q3 | Q4 |
| 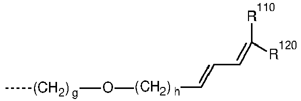 | 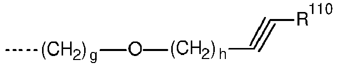 |
| Q5 | Q6 |
| 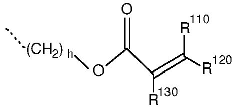 | 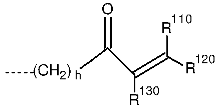 |
| Q7 | Q8 |
| 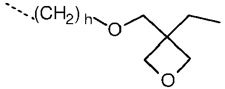 | 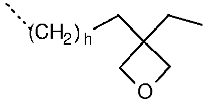 |
| Q9 | Q10 |
| 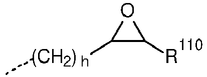 | 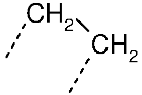 |
| Q11 | Q12 |
| 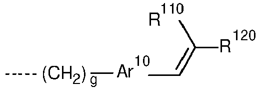 | 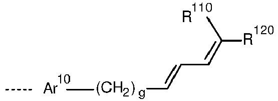 |
| Q13 | Q14 |
| 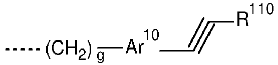 | 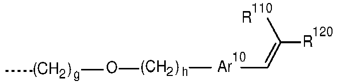 |
| Q15 | Q16 |
| 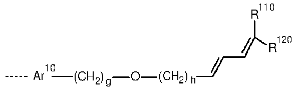 | 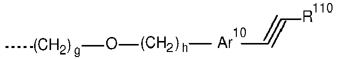 |
| Q17 | Q18 |
| 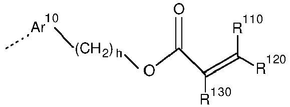 | 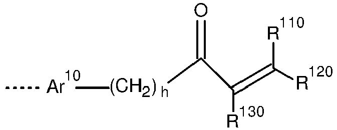 |
| Q19 | Q20 |
| 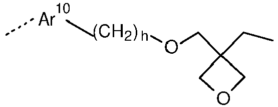 | 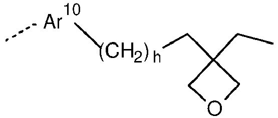 |
| Q21 | Q22 |
| 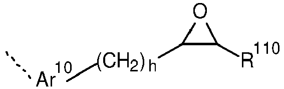 | 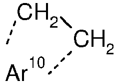 |
| Q23 | Q24 |
wobei
die Reste R¹¹⁰, R¹²⁰ und R¹³⁰ in den Formeln Q1 bis Q8, Q11, Q13 bis Q20 und Q23 bei jedem Auftreten, gleich oder verschieden, H, eine geradkettige oder verzweigte Alkylgruppe mit 1 bis 6 C-Atomen sind; die verwendeten Indices die folgende Bedeutung haben:
Ar¹⁰ in den Formeln Q13 bis Q 24 ein mono- oder polycyclisches,
aromatisches oder heteroaromatisches Ringsystem ist, das mit einem oder mehreren Resten R substituiert sein kann, wobei R die in Anspruch 1 angegebenen Bedeutungen annehmen kann;
g = 0 bis 8;
h = 1 bis 8; und
die gestrichelte Bindung in den Formeln Q1 bis Q11 und Q13 bis Q23 sowie die gestrichelten Bindungen in der Formeln Q12 und Q24 die Anknüpfung der vernetzbaren Gruppe an eines der mono- oder polycyclischen, aromatischen oder heteroaromatischen Ringsysteme Ar¹ bis Ar⁹ darstellen.

13. Zusammensetzung nach einem oder mehreren der Ansprüche 1 bis 12, **dadurch gekennzeichnet, dass** der Anteil an Struktureinheiten der Formeln (la), (Ib), (II), (III), (IV), (V), (VI), (VII), (VIIIa), (Vlllb), (IX), (X), (XI), (XII), (XIII), (XIV), (XV) und/oder (XVI) im Polymer im Bereich von 1 bis 100 mol% liegt, vorzugsweise im Bereich von 25 bis 100 mol%, besonders bevorzugt im Bereich von 50 bis 95 mol%, bezogen auf 100 mol% aller copolymerisierten Monomere, die im Polymer als Struktureinheiten enthalten sind.

14. Zusammensetzung nach einem oder mehreren der Ansprüche 1 bis 13, **dadurch gekennzeichnet, dass** das Polymer neben Struktureinheiten der Formeln (la), (Ib), (II), (III), (IV), (V), (VI), (VII), (VIIIa), (Vlllb), (IX), (X), (XI), (XII), (XIII), (XIV), (XV) und/oder (XVI) mindestens eine weitere Struktureinheit der folgenden Formel (XIX) enthält, die von den Struktureinheiten der Formeln (la), (Ib), (II), (III), (IV), (V), (VI), (VII), (VIIIa), (Vlllb), (IX), (X), (XI), (XII), (XIII), (XIV), (XV) und/oder (XVI) verschieden ist:
----- Ar¹¹----- (XIX)
wobei Ar¹¹ ein mono- oder polycyclisches, aromatisches oder heteroaromatisches Ringsystem ist, das mit einem oder mehreren Resten R substituiert sein kann, wobei R die in Anspruch 1 angegebenen Bedeutungen annehmen kann.

15. Zusammensetzung nach einem oder mehreren der Ansprüche 1 bis 14, **dadurch gekennzeichnet, dass** die Reste R¹², R²², R²³, R³², R³³ und R³⁴ in den Formeln (K1, (K2) und/oder (K3) jeweils bei jedem Auftreten gleich oder verschieden unabhängig voneinander ein mono- oder polycyclisches, aromatisches oder heteroaromatisches Ringsystem mit 5 bis 60 aromatischen Ringatomen bedeuten, die mit einem Rest R substituiert sein können, wobei R die in Anspruch 1 angegebenen Bedeutungen annehmen kann.

16. Zusammensetzung nach einem oder mehreren der Ansprüche 1 bis 15, **dadurch gekennzeichnet, dass** in den Formeln (K1, (K2) und/oder (K3) die Reste R¹¹, R²¹ und/oder R³¹ eine geradkettige Alkyl-, Alkoxy-oder Thioalkoxygruppe mit 1 bis 40 C-Atomen oder eine Alkenyl- oder Alkinylgruppe mit 2 bis 40 C-Atomen oder eine verzweigte oder cyclische Alkyl-, Alkoxy- oder Thioalkoxygruppe mit 3 bis 40 C-Atomen, die jeweils mit einem oder mehreren Resten R¹ substituiert sein kann, wobei eine oder mehrere nicht benachbarte CH₂-Gruppen durch R¹C=CR¹, C=C, Si(R¹)₂, C=O, C=S, C=NR¹, P(=O)(R¹), SO, SO₂, NR¹, O, S oder CONR¹ ersetzt sein können und wobei ein oder mehrere H-Atome durch D, F, Cl, Br, I oder CN ersetzt sein können, oder ein aromatisches oder heteroaromatisches Ringsystem mit 5 bis 60 aromatischen Ringatomen, das jeweils durch einen oder mehrere Reste R¹ substituiert sein kann, oder eine Aryloxy- oder Heteroaryloxygruppe mit 5 bis 60 aromatischen Ringatomen, die durch einen oder mehrere Reste R¹ substituiert sein kann, oder eine Aralkyl- oder Heteroaralkylgruppe mit 5 bis 60 aromatischen Ringatomen, die durch einen oder mehrere Reste R¹ substituiert sein kann, oder eine Diarylaminogruppe, Diheteroarylaminogruppe oder Arylheteroarylaminogruppe mit 10 bis 40 aromatischen Ringatomen darstellen, welche durch einen oder mehrere Reste R¹ substituiert sein kann; ist; wobei zwei oder mehrere Reste R auch miteinander ein mono- oder polycyclisches, aliphatisches, aromatisches und/oder benzoannelliertes Ringsystem bilden können.

17. Zusammensetzung nach einem oder mehreren der Ansprüche 1 bis 16, **dadurch gekennzeichnet, dass** mindestens einer der Reste R⁴¹, R⁴², R⁴³ und R⁴⁴ in Formel (A1) mindestens ein Halogenatom, vorzugsweise mindestens ein Chlor- und/oder Fluoratom, besonders bevorzugt mindestens ein Fluoratom als Substituent aufweist.

18. Zusammensetzung nach einem oder mehreren der Ansprüche 1 bis 17, **dadurch gekennzeichnet, dass** der Rest A¹ in Formel (K1) ein Bromatom oder ein lodatom ist, der Rest A² in Formel (K2) ein Selenatom oder ein Schwefelatom ist und der Rest A³ in Formel (K3) ein Antimonatom, ein Arsenatom oder ein Phosphoratom ist.

19. Zusammensetzung nach einem oder mehreren der Ansprüche 1 bis 18, **dadurch gekennzeichnet, dass** der Rest E⁴ in Formel (A1) ein Boratom ist.

20. Lösungen oder Formulierungen umfassend mindestens eine Zusammensetzung nach einem oder mehreren der Ansprüche 1 bis 19 in einem oder mehreren Lösungsmitteln.

21. Elektronische oder optoelektronische Bauteile, vorzugsweise organische Elektrolumineszenzvorrichtungen (OLED), organische lichtemittierende elektrochemische Zellen (OLEC), organische Feld-Effekt-Transistoren (OFET), organische integrierte Schaltungen (O-IC), organische Dünnfilmtransistoren (TFT), organische Solarzellen (O-SC), organische Laserdioden (O-Laser), organische photovoltaische (OPV) Elemente oder Vorrichtungen und organische Photorezeptoren (OPC), besonders bevorzugt organische Elektrolumineszenzvorrichtungen, mit einer oder mehreren aktiven Schichten, wobei mindestens eine dieser aktiven Schichten eine oder mehrere Zusammensetzungen nach einem oder mehreren der Ansprüche 1 bis 19 enthält.

22. Elektronische oder optoelektronische Bauteile nach Anspruch 21, **dadurch gekennzeichnet, dass** die aktive Schicht umfassend eine oder mehrere Zusammensetzungen nach einem oder mehreren der Ansprüche 1 bis 19 vernetzt ist.

## Claims

1. Composition comprising at least one polymer and at least one salt, **characterised in that** the polymer contains at least one structural unit of the following formula (la): 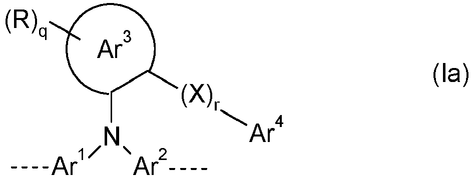 where
Ar¹, Ar² and Ar³ are on each occurrence, in each case identically or differently, a mono- or polycyclic, aromatic or heteroaromatic ring system, which may be substituted by one or more radicals R;
Ar⁴ is a mono- or polycyclic, aromatic or heteroaromatic ring system having 5 to 60 aromatic ring atoms, which may be substituted by one or more radicals R,
R is on each occurrence, identically or differently, H, D, F, Cl, Br, I, N(R¹)₂, CN, NO₂, Si(R¹)₃, B(OR¹)₂, C(=O)R¹, P(=O)(R¹)₂, S(=O)R¹, S(=O)₂R¹, OSO₂R¹, a straight-chain alkyl, alkoxy or thioalkoxy group having 1 to 40 C atoms or an alkenyl or alkynyl group having 2 to 40 C atoms or a branched or cyclic alkyl, alkoxy or thioalkoxy group having 3 to 40 C atoms, which may in each case be substituted by one or more radicals R¹, where one or more non-adjacent CH₂ groups may be replaced by R¹C=CR¹, C=C, Si(R¹)₂, C=O, C=S, C=NR¹, P(=O)(R¹), SO, SO₂, NR¹, O, S or CONR¹ and where one or more H atoms may be replaced by D, F, Cl, Br, I or CN, or an aromatic or heteroaromatic ring system having 5 to 60 aromatic ring atoms, which may in each case be substituted by one or more radicals R¹, or an aryloxy or heteroaryloxy group having 5 to 60 aromatic ring atoms, which may be substituted by one or more radicals R¹, or an aralkyl or heteroaralkyl group having 5 to 60 aromatic ring atoms, which may be substituted by one or more radicals R¹, or a diarylamino group, diheteroarylamino group or arylheteroarylamino group having 10 to 40 aromatic ring atoms, which may be substituted by one or more radicals R¹; where two or more radicals R may also form a mono- or polycyclic, aliphatic, aromatic and/or benzo-fused ring system with one another;
R¹ is on each occurrence, identically or differently, H, D, F or an aliphatic, aromatic and/or heteroaromatic hydrocarbon radical having 1 to 20 C atoms, in which, in addition, one or more H atoms may be replaced by F; where two or more substituents R¹ may also form a mono- or polycyclic, aliphatic or aromatic ring system with one another;
q is 0, 1, 2, 3, 4, 5 or 6;
X is CR₂, NR, SiR₂, O, S, C=O or P=O, preferably CR₂, SiR₂, NR, O or S;
r is 0 or 1;
and
the dashed lines represent bonds to adjacent structural units in the polymer;
the salt contains at least one cation of the following formulae (K1), (K2) and/or (K3): 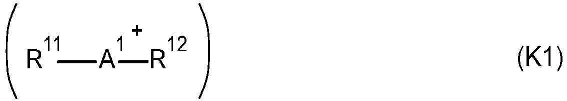 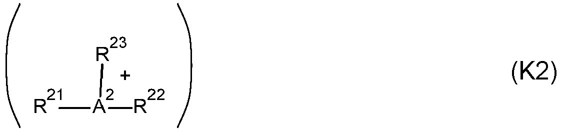 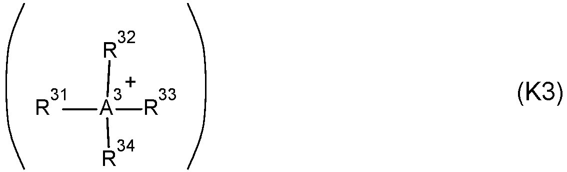
where the radical A¹ is an element from group 17 of the Periodic Table of the Elements, the radical A² is an element from group 16 of the Periodic Table of the Elements; and A³ is an element from group 15 of the Periodic Table of the Elements;
and the radicals R¹¹, R²¹, R³¹ denote any desired radical, preferably represent a carbon atom-containing group which is in each case bonded to the radical A¹, A² or A³ via a carbon atom;
the radicals R¹², R²², R²³, R³², R³³ and R³⁴ in each case represent a carbon atom-containing group which is in each case bonded to the radical A¹, A² or A³ via a carbon atom, where one or more of the radicals R¹¹ to R³⁴ may also form a mono- or polycyclic, aliphatic, heteroaliphatic, heteroaromatic or aromatic ring system with one another;
and at least one anion of the following formula (A1) 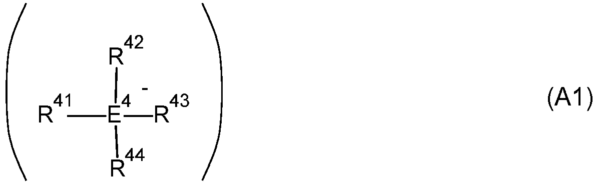
where the radical E⁴ denotes an element from group 13 of the Periodic Table of the Elements;
and the radicals R⁴¹, R⁴², R⁴³ and R⁴⁴ in each case represent an aromatic or heteroaromatic ring system having 5 to 60 aromatic ring atoms, which may in each case be substituted by one or more radicals R, where one or more of the radicals R⁴¹, R⁴², R⁴³ and R⁴⁴ may also form a mono- or polycyclic, aliphatic, heteroaliphatic, heteroaromatic or aromatic ring system with one another.

2. Composition according to Claim 1, **characterised in that** Ar³ is substituted by Ar⁴ in one of the two ortho positions, and Ar³ is additionally also linked to Ar⁴ in the meta position adjacent to the substituted ortho position.

3. Composition according to Claim 1 or 2, **characterised in that** the polymer contains at least one structural unit of the formula (Ia) that is selected from the structural unit of the following formula (Ib): 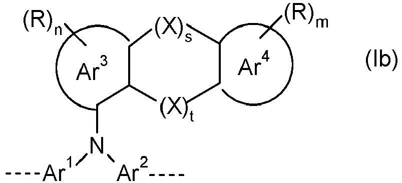
where Ar¹, Ar², Ar³, Ar⁴, R and X can adopt the meanings indicated in Claim 1,
m = 0, 1, 2, 3 or 4, and
n = 0, 1, 2 or 3, and
s and t are in each case 0 or 1, where the sum (s + t) = 1 or 2.

4. Composition according to one or more of Claims 1 to 3, **characterised in that** the at least one structural unit of the formula (Ia) is selected from structural units of the following formulae (II), (III) and (IV): 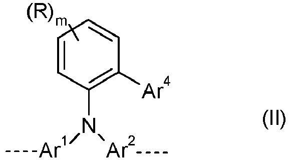 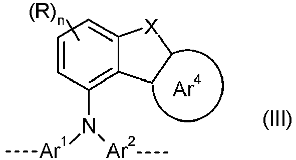 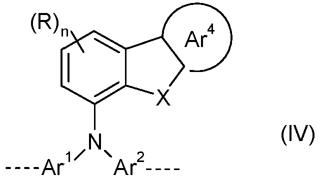 where Ar¹, Ar², Ar⁴, R, m, n and X can adopt the meanings indicated in Claims 1 and 3.

5. Composition according to one or more of Claims 1 to 4, **characterised in that** the polymer contains at least one structural unit of the formula (Ia) that is selected from the structural unit of the following formula (VIIIa): 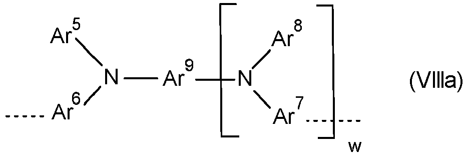 or the structural unit of the following formula (VIIIb): 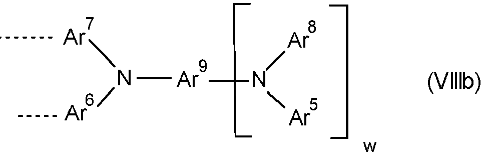 where w = 1, 2 or 3, Ar⁵ to Ar⁹ are on each occurrence, in each case identically or differently, a mono- or polycyclic, aromatic or heteroaromatic ring system, which may be substituted by one or more radicals R, where R can adopt the meaning described in Claim 1; the dashed lines represent bonds to adjacent structural units in the polymer.

6. Composition according to Claim 5, **characterised in that** at least one of the radicals Ar⁵ and/or Ar⁸ in formulae (Villa) and/or (Vlllb) is substituted by Ar⁴ in at least one, preferably in one, of the two ortho positions relative to the position of the nitrogen atom depicted in formula (VIIIa) and/or (VIIIb), where Ar⁴ is a mono- or polycyclic, aromatic or heteroaromatic ring system having 5 to 60 aromatic ring atoms, which may be substituted by one or more radicals R, where R can adopt the meaning described in Claim 1.

7. Composition according to Claim 5 or 6, **characterised in that** the at least one structural unit of the formula (Villa) is selected from the structural units of the following formulae (VIIIa-1a), (VIIIa-1b), (VIIIa-1c) and (VIIIa-1d): 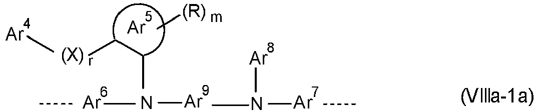 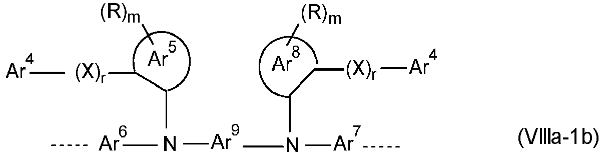 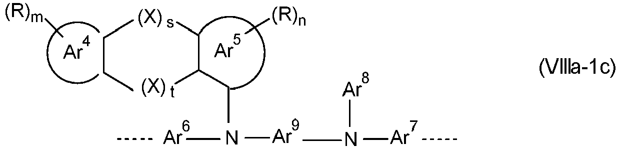 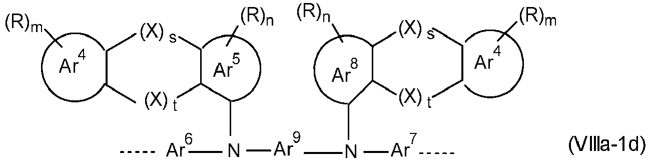 where Ar⁴, Ar⁵, Ar⁶, Ar⁷, Ar⁸, Ar⁹, X, m, n, r, s, t, R and the dashed lines can adopt the meanings indicated above in Claims 1, 3 and 5.

8. Composition according to one or more of Claims 1 to 7, **characterised in that** at least one of the structural units of the formulae (Ia), (II), (III), (IV), (V), (VI), (VII), (Villa), (Vlllb), (IX), (X), (XI), (XII), (XIII), (XIV), (XV) and/or (XVI) contains at least one crosslinkable group Q.

9. Composition according to one or more of Claims 1 to 8, **characterised in that** the mono- or polycyclic, aromatic or heteroaromatic groups Ar³ in formula (Ia), Ar⁴ in Claim 1, in Claim 7 and in formulae (Ia) and/or (Ib), Ar⁵ and Ar⁸ in formulae (Villa) and/or (Vlllb) are selected from:
| | | |
|---|---|---|
| 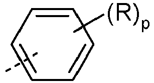 | 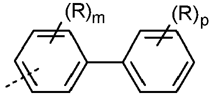 | 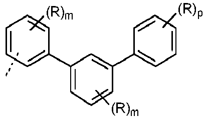 |
| E1 | E2 | E3 |
| 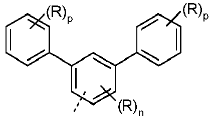 | 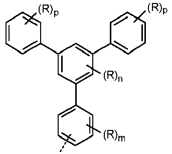 | 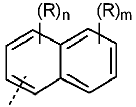 |
| E4 | E5 | E6 |
| 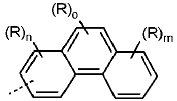 | 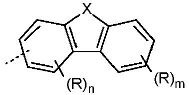 | 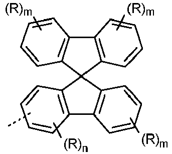 |
| E7 | E8 | E9 |
| 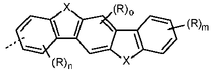 | 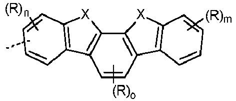 | 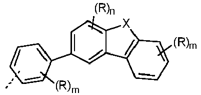 |
| E10 | E11 | E12 |
where
the radicals R in the formulae E1 to E12 can adopt the same meaning as the radicals R in relation to the formula (Ia) in Claim 1,
X can denote CR₂, NR, SiR₂, O, S, C=O or P=O, preferably CR₂, SiR₂, NR, O or S, where here too R can adopt the same meaning as the radicals R in relation to the formula (Ia) in Claim 1,
the dashed lines represent bonds to adjacent structural units in the polymer and
the indices used have the following meaning:
m = 0, 1, 2, 3 or 4;
n = 0, 1, 2 or 3;
o = 0, 1 or 2; and
p = 0, 1, 2, 3, 4 or 5.

10. Composition according to one or more of Claims 1 to 9, **characterised in that** the mono- or polycyclic, aromatic or heteroaromatic groups Ar¹ and Ar² in formula (Ia), Ar⁶, Ar⁷ and Ar⁹ in formulae (Villa) and/or (VIIIb) are selected from:
| | | |
|---|---|---|
| 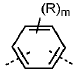 | 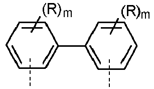 | 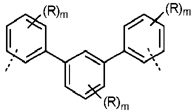 |
| M1 | M2 | M3 |
| 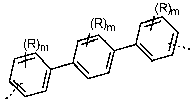 | 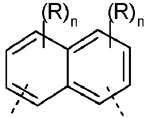 | 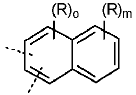 |
| M4 | M5 | M6 |
| 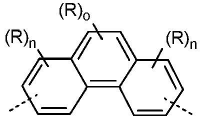 | 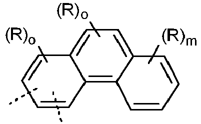 | 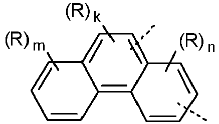 |
| M7 | M8 | M9 |
| 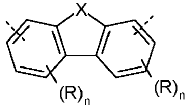 | 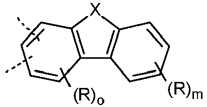 | 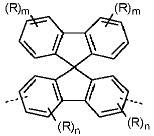 |
| M10 | M11 | M12 |
| 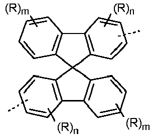 | 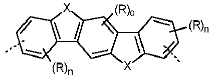 | 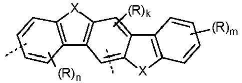 |
| M13 | M14 | M15 |
| 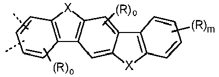 | 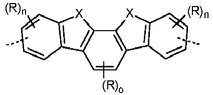 | 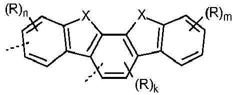 |
| M16 | M17 | M18 |
| 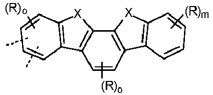 | 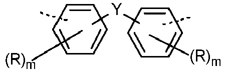 | |
| M19 | M20 | |
| 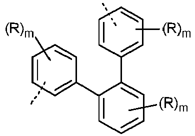 | 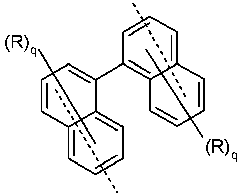 | 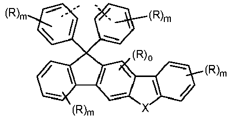 |
| M21 | M22 | M23 |
where
the radicals R in the formulae M1 to M23 can adopt the same meaning as the radicals R in relation to the formula (Ia) in Claim 1,
X can denote CR₂, NR, SiR₂, O, S, C=O or P=O, preferably CR₂, SiR₂, NR, O or S, where here too R can adopt the same meaning as the radicals R in relation to the formula (Ia) in Claim 1,
Y can be CR₂, SiR₂, O, S or a straight-chain or branched alkyl group having 1 to 20 C atoms or an alkenyl or alkynyl group having 2 to 20 C atoms, which may in each case be substituted by one or more radicals R¹, and where one or more non-adjacent CH₂ groups, CH groups or C atoms of the alkyl, alkenyl or alkynyl groups may be replaced by Si(R¹)₂, C=O, C=S, C=NR¹, P(=O)(R¹), SO, SO₂, NR¹, O, S, CONR¹ or an aromatic or heteroaromatic ring system having 5 to 60 aromatic ring atoms, which may in each case be substituted by one or more radicals R¹, or an aryloxy or
heteroaryloxy group having 5 to 60 aromatic ring atoms, which may be substituted by one or more radicals R¹, or an aralkyl or
heteroaralkyl group having 5 to 60 aromatic ring atoms, which may be substituted by one or more radicals R¹, or a diarylamino group,
diheteroarylamino group or arylheteroarylamino group having 10 to 40 aromatic ring atoms, which may be substituted by one or more radicals R¹; where here too the radicals R and R¹ can adopt the same meanings as the radicals R and R¹ in formula (Ia),
the dashed lines represent bonds to adjacent structural units in the polymer and
the indices used have the following meaning:
k = 0 or 1;
m = 0, 1, 2, 3 or 4;
n = 0, 1, 2 or 3;
o = 0, 1 or 2; and
q = 0, 1, 2, 3, 4, 5 or 6.

11. Composition according to one or more of Claims 8 to 10, **characterised in that** the crosslinkable group Q is selected from:
- terminal or cyclic alkenyl groups or terminal dienyl and alkynyl groups,
- alkenyloxy, dienyloxy or alkynyloxy groups,
- acrylic acid groups,
- oxetane and oxirane groups,
- silane groups, and
- cyclobutane groups.

12. Composition according to Claim 11, **characterised in that** the crosslinkable group Q is selected from:
| | |
|---|---|
| 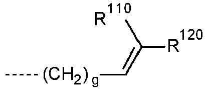 | 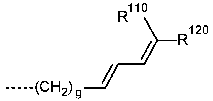 |
| Q1 | Q2 |
| 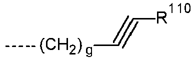 | 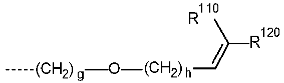 |
| Q3 | Q4 |
| 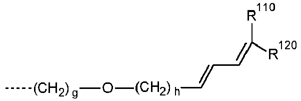 | 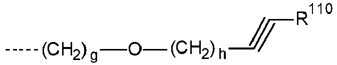 |
| Q5 | Q6 |
| 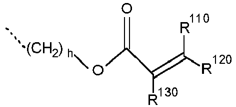 | 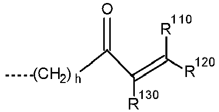 |
| Q7 | Q8 |
| 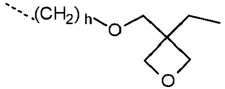 | 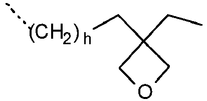 |
| Q9 | Q10 |
| 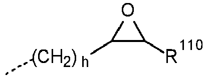 | 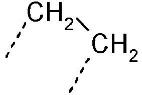 |
| Q11 | Q12 |
| 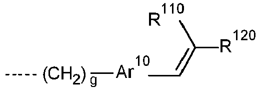 | 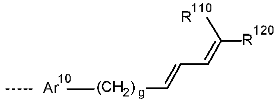 |
| Q13 | Q14 |
| 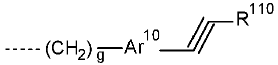 | 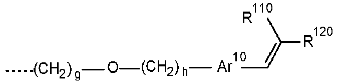 |
| Q15 | Q16 |
| 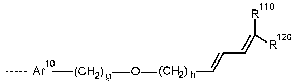 | 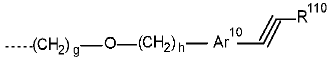 |
| Q17 | Q18 |
| 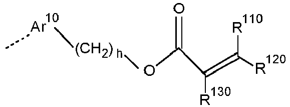 | 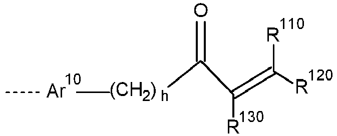 |
| Q19 | Q20 |
| 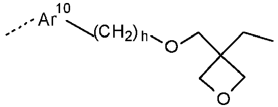 | 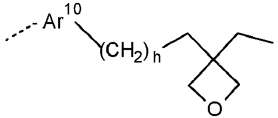 |
| Q21 | Q22 |
| 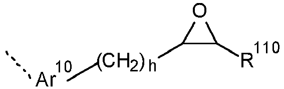 | 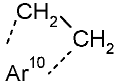 |
| Q23 | Q24 |
where
the radicals R¹¹⁰, R¹²⁰ and R¹³⁰ in the formulae Q1 to Q8, Q11, Q13 to Q20 and Q23 are on each occurrence, identically or differently,
H or a straight-chain or branched alkyl group having 1 to 6 C atoms;
the indices used have the following meaning:
Ar¹⁰ in the formulae Q13 to Q24 is a mono- or polycyclic, aromatic or heteroaromatic ring system, which may be substituted by one or more radicals R, where R can adopt the meanings indicated in Claim 1;
g = 0 to 8;
h = 1 to 8; and
the dashed bond in the formulae Q1 to Q11 and Q13 to Q23 and
the dashed bonds in the formulae Q12 and Q24 represent the linking of the crosslinkable group to one of the mono- or polycyclic,
aromatic or heteroaromatic ring systems Ar¹ to Ar⁹.

13. Composition according to one or more of Claims 1 to 12, **characterised in that** the proportion of structural units of the formulae (Ia), (Ib), (II), (III), (IV), (V), (VI), (VII), (VIIIa), (VIIIb), (IX), (X), (XI), (XII), (XIII), (XIV), (XV) and/or (XVI) in the polymer is in the range from 1 to 100 mol%, preferably in the range from 25 to 100 mol%, particularly preferably in the range from 50 to 95 mol%, based on 100 mol% of all copolymerised monomers present as structural units in the polymer.

14. Composition according to one or more of Claims 1 to 13, **characterised in that**, besides structural units of the formulae la), (Ib), (II), (III), (IV), (V), (VI), (VII), (VIIIa), (VIIIb), (IX), (X), (XI), (XII), (XIII), (XIV), (XV) and/or (XVI), the polymer contains at least one further structural unit of the following formula (XIX) that is different from the structural units of the formulae (Ia), (Ib), (II), (III), (IV), (V), (VI), (VII), (Villa), (Vlllb), (IX), (X), (XI), (XII), (XIII), (XIV), (XV) and/or (XVI):
----- Ar¹¹----- (XIX)
where Ar¹¹ is a mono- or polycyclic, aromatic or heteroaromatic ring system, which may be substituted by one or more radicals R,
where R can adopt the meanings indicated in Claim 1.

15. Composition according to one or more of Claims 1 to 14, **characterised in that** the radicals R¹², R²² , R²³ , R³² , R³³ and R³⁴ in the formulae (K1), (K2) and/or (K3) in each case, identically or differently on each occurrence, independently of one another, denote a mono- or polycyclic, aromatic or heteroaromatic ring system having 5 to 60 aromatic ring atoms, which may be substituted by a radical R, where R can adopt the meanings indicated in Claim 1.

16. Composition according to one or more of Claims 1 to 15, **characterised in that**, in the formulae (K1), (K2) and/or (K3), the radicals R¹¹, R²¹ and/or R³¹ represent a straight-chain alkyl, alkoxy or thioalkoxy group having 1 to 40 C atoms or an alkenyl or alkynyl group having 2 to 40 C atoms or a branched or cyclic alkyl, alkoxy or thioalkoxy group having 3 to 40 C atoms, which may in each case be substituted by one or more radicals R¹, where one or more non-adjacent CH₂ groups may be replaced by R¹C=CR¹, C=C, Si(R¹)₂, C=O, C=S, C=NR¹, P(=O)(R¹), SO, SO₂, NR¹, O, S or CONR¹ and where one or more H atoms may be replaced by D, F, Cl, Br, I or CN, or an aromatic or heteroaromatic ring system having 5 to 60 aromatic ring atoms, which may in each case be substituted by one or more radicals R¹, or an aryloxy or heteroaryloxy group having 5 to 60 aromatic ring atoms, which may be substituted by one or more radicals R¹, or an aralkyl or heteroaralkyl group having 5 to 60 aromatic ring atoms, which may be substituted by one or more radicals R¹, or a diarylamino group, diheteroarylamino group or arylheteroarylamino group having 10 to 40 aromatic ring atoms, which may be substituted by one or more radicals R¹; where two or more radicals R may also form a mono- or polycyclic, aliphatic, aromatic and/or benzo-fused ring system with one another.

17. Composition according to one or more of Claims 1 to 16, **characterised in that** at least one of the radicals R⁴¹, R⁴², R⁴³ and R⁴⁴ in formula (A1) contains at least one halogen atom, preferably at least one chlorine and/or fluorine atom, particularly preferably at least one fluorine atom, as substituent.

18. Composition according to one or more of Claims 1 to 17, **characterised in that** the radical A¹ in formula (K1) is a bromine atom or an iodine atom, the radical A² in formula (K2) is a selenium atom or a sulfur atom and the radical A³ in formula (K3) is an antimony atom, an arsenic atom or a phosphorus atom.

19. Composition according to one or more of Claims 1 to 18, **characterised in that** the radical E⁴ in formula (A1) is a boron atom.

20. Solutions or formulations comprising at least one composition according to one or more of Claims 1 to 19 in one or more solvents.

21. Electronic or opto-electronic components, preferably organic electroluminescent devices (OLEDs), organic light-emitting electrochemical cells (OLECs), organic field-effect transistors (OFETs), organic integrated circuits (O-ICs), organic thin-film transistors (TFTs), organic solar cells (O-SCs), organic laser diodes (O-lasers), organic photovoltaic (OPV) elements or devices and organic photoreceptors (OPCs), particularly preferably organic electroluminescent devices, having one or more active layers, where at least one of these active layers comprises one or more compositions according to one or more of Claims 1 to 19.

22. Electronic or opto-electronic components according to Claim 21, **characterised in that** the active layer comprising one or more compositions according to one or more of Claims 1 to 19 has been crosslinked.

## Revendications

1. Composition comprenant au moins un polymère et au moins un sel, **caractérisée en ce que** le polymère contient au moins un motif structural de formule (la) suivante : 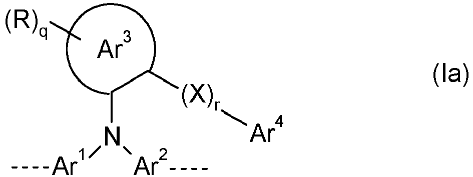 dans laquelle
Ar¹, Ar² et Ar³ sont à chaque occurrence, dans chaque cas de manière identique ou différente, un noyau mono- ou polycyclique, aromatique ou hétéroaromatique, pouvant être substitué par un ou plusieurs radicaux R ;
Ar⁴ est un noyau mono- ou polycyclique, aromatique ou hétéroaromatique ayant de 5 à 60 atomes de cycle aromatique, pouvant être substitué par un ou plusieurs radicaux R,
R est à chaque occurrence, de manière identique ou différente, H, D, F, Cl, Br, I, N(R¹)₂, CN, NO₂, Si(R¹)₃, B(OR¹)₂, C(=O)R¹, P(=O)(R¹)₂, S(=O)R¹, S(=O)₂R¹, OSO₂R¹, un groupement alkyle, alcoxy ou thioalcoxy à chaîne linéaire ayant de 1 à 40 atomes de C ou un groupement alcényle ou alcynyle ayant de 2 à 40 atomes de C ou un groupement alkyle, alcoxy ou thioalcoxy ramifié ou cyclique ayant de 3 à 40 atomes de C, pouvant dans chaque cas être substitué par un ou plusieurs radicaux R¹, où un ou plusieurs groupements CH₂ non adjacents peuvent être remplacés par R¹C=CR¹, C=C, Si(R¹)₂, C=O, C=S, C=NR¹, P(=O)(R¹), SO, SO₂, NR¹, O, S ou CONR¹ et où un ou plusieurs atomes de H peuvent être remplacés par D, F, Cl, Br, I ou CN, ou un noyau aromatique ou hétéroaromatique ayant de 5 à 60 atomes de cycle aromatique, pouvant dans chaque cas être substitué par un ou plusieurs radicaux R¹, ou un groupement aryloxy ou hétéroaryloxy ayant de 5 à 60 atomes de cycle aromatique, pouvant être substitué par un
R¹ ou plusieurs radicaux R¹, ou un groupement aralkyle ou hétéroaralkyle ayant de 5 à 60 atomes de cycle aromatique, pouvant être substitué par un ou plusieurs radicaux R¹, ou un groupement diarylamino, un groupement dihétéroarylamino ou un groupement arylhétéroarylamino ayant de 10 à 40 atomes de cycle aromatique, pouvant être substitué par un ou plusieurs radicaux R¹ ; où deux, ou plus, radicaux R peuvent également former un noyau mono- ou polycyclique, aliphatique, aromatique et/ou benzocondensé les uns avec les autres ; est à chaque occurrence, de manière identique ou différente, H, D, F ou un radical hydrocarboné aliphatique, aromatique et/ou hétéroaromatique ayant de 1 à 20 atomes de C, dans lequel, en outre, un ou plusieurs atomes de H peuvent être remplacés par F ; où deux, ou plus, substituants R¹ peuvent également former un noyau mono- ou polycyclique, aliphatique ou aromatique les uns avec les autres ;
q vaut 0, 1, 2, 3, 4, 5 ou 6 ;
X est CR₂, NR, SiR₂, O, S, C=O ou P=O, préférablement CR₂, SiR₂, NR, O ou S ;
r vaut 0 ou 1 ;
et
les lignes en pointillés représentent des liaisons à des motifs structuraux adjacents dans le polymère ;
le sel contient au moins un cation de formules (K1), (K2) et/ou (K3) suivantes : 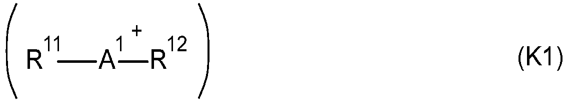 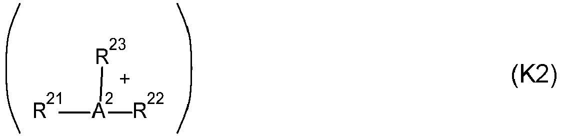 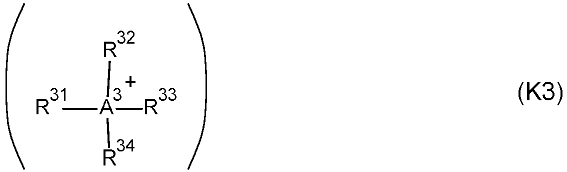
où le radical A¹ est un élément issu du groupe 17 du Tableau Périodique des Eléments, le radical A² est un élément issu du groupe 16 du Tableau Périodique des Eléments ; et A³ est un élément issu du groupe 15 du Tableau Périodique des Eléments ;
et les radicaux R¹¹, R²¹, R³¹ désignent un radical souhaité quelconque, préférablement représentent un groupement contenant des atomes de carbone qui est dans chaque cas lié au radical A¹, A² ou A³ via un atome de carbone ;
les radicaux R¹², R²², R²³, R³², R³³ et R³⁴ dans chaque cas représentent un groupement contenant des atomes de carbone qui est dans chaque cas lié au radical A¹, A² ou A³ via un atome de carbone, où un ou plusieurs parmi les radicaux R¹¹ à R³⁴ peuvent également former un noyau mono- ou polycyclique, aliphatique, hétéroaliphatique, hétéroaromatique ou aromatique les uns avec les autres ;
et au moins un anion de formule (A1) suivante 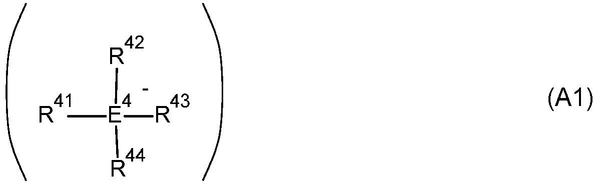
où le radical E⁴ désigne un élément issu du groupe 13 du Tableau Périodique des Eléments ;
et les radicaux R⁴¹, R⁴², R⁴³ et R⁴⁴ dans chaque cas représentent un noyau aromatique ou hétéroaromatique ayant de 5 à 60 atomes de cycle aromatique, pouvant dans chaque cas être substitué par un ou plusieurs radicaux R, où un ou plusieurs parmi les radicaux R⁴¹, R⁴², R⁴³ et R⁴⁴ peuvent également former un noyau mono- ou polycyclique, aliphatique, hétéroaliphatique, hétéroaromatique ou aromatique les uns avec les autres.

2. Composition selon la revendication 1, **caractérisée en ce que** Ar³ est substitué par Ar⁴ dans l'une des deux positions ortho, et Ar³ est de plus également lié à Ar⁴ en position méta adjacente à la position ortho substituée.

3. Composition selon la revendication 1 ou 2, **caractérisée en ce que** le polymère contient au moins un motif structural de formule (la) qui est choisi parmi le motif structural de formule (Ib) suivante : 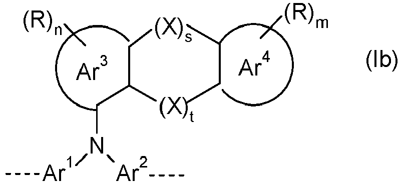
dans laquelle Ar¹, Ar², Ar³, Ar⁴, R et X peuvent adopter les significations indiquées selon la revendication 1,
m = 0, 1, 2, 3 ou 4, et
n = 0, 1, 2 ou 3, et
s et t valent dans chaque cas 0 ou 1, où la somme (s + t) = 1 ou 2.

4. Composition selon l'une ou plusieurs parmi les revendications 1 à 3, **caractérisée en ce que** le au moins un motif structural de formule (la) est choisi parmi les motifs structuraux de formules (II), (III) et (IV) suivantes : 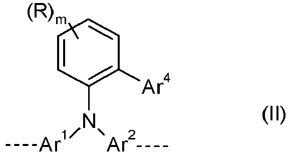 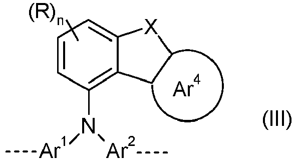 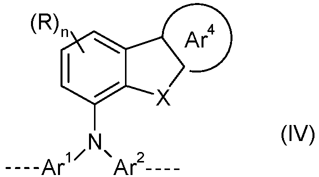 dans lesquelles Ar¹, Ar², Ar⁴, R, m, n et X peuvent adopter les significations indiquées selon les revendications 1 et 3.

5. Composition selon l'une ou plusieurs parmi les revendications 1 à 4, **caractérisée en ce que** le polymère contient au moins un motif structural de formule (la) qui est choisi parmi le motif structural de formule (VIIIa) suivante : 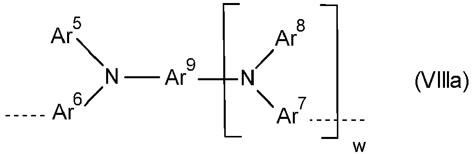 ou le motif structural de formule (VIIIb) suivante : 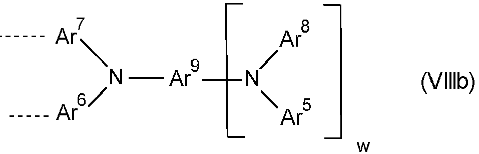 dans lesquelles w = 1, 2 ou 3, Ar⁵ à Ar⁹ sont à chaque occurrence, dans chaque cas de manière identique ou différente, un noyau mono- ou polycyclique, aromatique ou hétéroaromatique, pouvant être substitué par un ou plusieurs radicaux R, où R peut adopter la signification décrite selon la revendication 1 ; les lignes en pointillés représentent des liaisons à des motifs structuraux adjacents dans le polymère.

6. Composition selon la revendication 5, **caractérisée en ce qu'**au moins l'un parmi les radicaux Ar⁵ et/ou Ar⁸ dans les formules (VIIIa) et/ou (VIIIb) est substitué par Ar⁴ dans au moins une, préférablement dans une, parmi les deux positions ortho par rapport à la position de l'atome d'azote illustrée dans la formule (VIIIa) et/ou (VIIIb), dans laquelle Ar⁴ est un noyau mono- ou polycyclique, aromatique ou hétéroaromatique ayant de 5 à 60 atomes de cycle aromatique, pouvant être substitué par un ou plusieurs radicaux R, où R peut adopter la signification décrite selon la revendication 1.

7. Composition selon la revendication 5 ou 6, **caractérisée en ce que** le au moins un motif structural de formule (VIIIa) est choisi parmi les motifs structuraux de formules (VIIIa-1a), (VIIIa-1b), (VIIIa-1c) et (VIIIa-1d) suivantes : 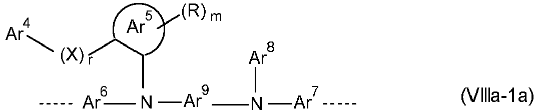 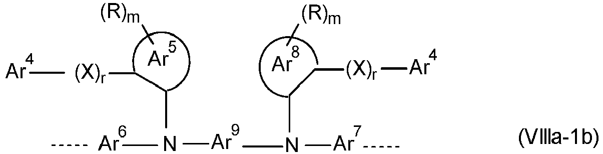 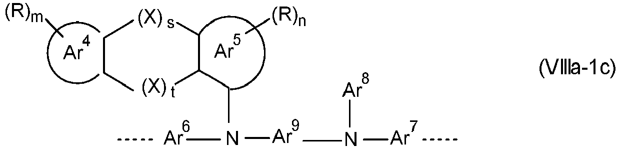 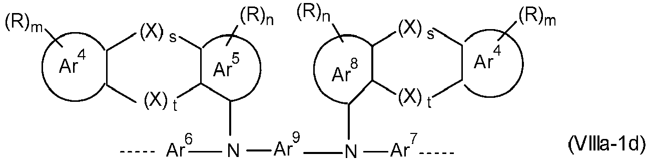 dans lesquelles Ar⁴, Ar⁵, Ar⁶, Ar⁷, Ar⁸, Ar⁹, X, m, n, r, s, t, R et les lignes en pointillés peuvent adopter les significations indiquées ci-dessus selon les revendications 1, 3 et 5.

8. Composition selon l'une ou plusieurs parmi les revendications 1 à 7, **caractérisée en ce qu'**au moins l'un des motifs structuraux de formules (Ia), (II), (III), (IV), (V), (VI), (VII), (VIIIa), (VIIIb), (IX), (X), (XI), (XII), (XIII), (XIV), (XV) et/ou (XVI) contient au moins un groupement réticulable Q.

9. Composition selon l'une ou plusieurs parmi les revendications 1 à 8, **caractérisée en ce que** les groupements mono- ou polycycliques, aromatiques ou hétéroaromatiques Ar³ dans la formule (la), Ar⁴ selon la revendication 1, selon la revendication 7 et dans les formules (la) et/ou (Ib), Ar⁵ et Ar⁸ dans les formules (VIIIa) et/ou (VIIIb) sont choisis parmi :
| | | |
|---|---|---|
| 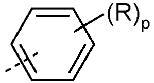 | 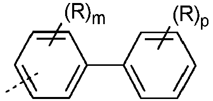 | 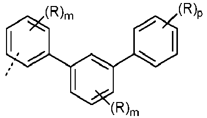 |
| E1 | E2 | E3 |
| 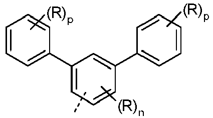 | 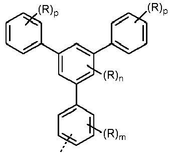 | 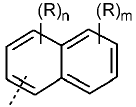 |
| E4 | E5 | E6 |
| 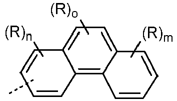 | 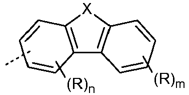 | 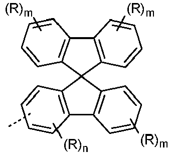 |
| E7 | E8 | E9 |
| 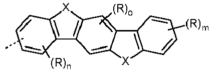 | 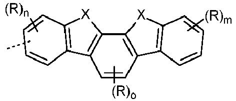 | 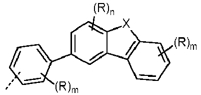 |
| E10 | E11 | E12 |
dans lesquelles
les radicaux R dans les formules E1 à E12 peuvent adopter la même signification que les radicaux R par rapport à la formule (la) selon la revendication 1,
X peut désigner CR₂, NR, SiR₂, O, S, C=O ou P=O, préférablement CR₂, SiR₂, NR, O ou S, où ici aussi R peut adopter la même signification que les radicaux R par rapport à la formule (la) selon la revendication 1,
les lignes en pointillés représentent des liaisons à des motifs structuraux adjacents dans le polymère et
les indices utilisés revêtent la signification suivante :
m = 0, 1, 2, 3 ou 4 ;
n = 0, 1, 2 ou 3 ;
o = 0, 1 ou 2 ; et
p = 0, 1, 2, 3, 4 ou 5.

10. Composition selon l'une ou plusieurs parmi les revendications 1 à 9, **caractérisée en ce que** les groupements mono- ou polycycliques, aromatiques ou hétéroaromatiques Ar¹ et Ar² dans la formule (la), Ar⁶, Ar⁷ et Ar⁹ dans les formules (VIIIa) et/ou (VIIIb) sont choisis parmi :
| | | |
|---|---|---|
| 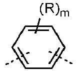 | 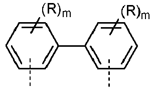 | 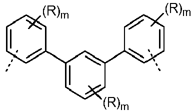 |
| M1 | M2 | M3 |
| 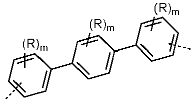 | 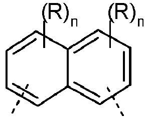 | 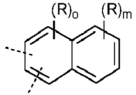 |
| M4 | M5 | M6 |
| 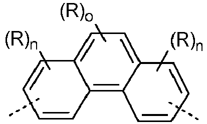 | 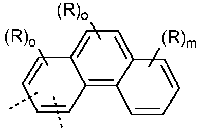 | 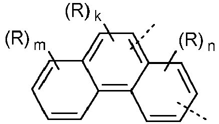 |
| M7 | M8 | M9 |
| 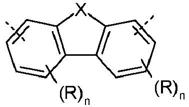 | 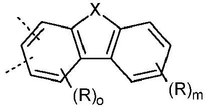 | 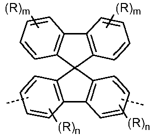 |
| M10 | M11 | M12 |
| 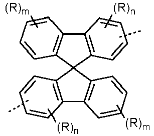 | 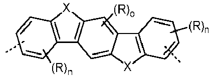 | 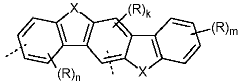 |
| M13 | M14 | M15 |
| 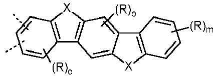 | 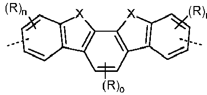 | 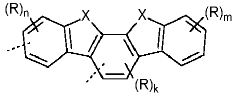 |
| M16 | M17 | M18 |
| 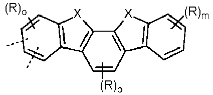 | 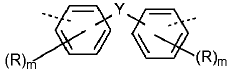 | |
| M19 | M20 | |
| 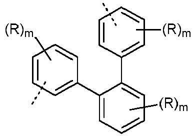 | 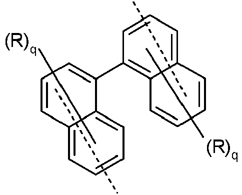 | 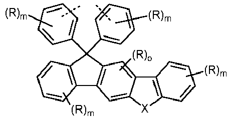 |
| M21 | M22 | M23 |
dans lesquelles
les radicaux R dans les formules M1 à M23 peuvent adopter la même signification que les radicaux R par rapport à la formule (la) selon la revendication 1,
X peut désigner CR₂, NR, SiR₂, O, S, C=O ou P=O, préférablement CR₂, SiR₂, NR, O ou S, où ici aussi R peut adopter la même signification que les radicaux R par rapport à la formule (la) selon la revendication 1,
Y peut être CR₂, SiR₂, O, S ou un groupement alkyle à chaîne linéaire ou ramifiée ayant de 1 à 20 atomes de C ou un groupement alcényle ou alcynyle ayant de 2 à 20 atomes de C, pouvant dans chaque cas être substitué par un ou plusieurs radicaux R¹, et où un ou plusieurs groupements CH₂, groupements CH ou atomes de C non adjacents des groupements alkyle, alcényle ou alcynyle peuvent être remplacés par Si(R¹)₂, C=O, C=S, C=NR¹, P(=O)(R¹), SO, SO₂, NR¹, O, S, CONR¹ ou un noyau aromatique ou hétéroaromatique ayant de 5 à 60 atomes de cycle aromatique, pouvant dans chaque cas être substitué par un ou plusieurs radicaux R¹, ou un groupement aryloxy ou hétéroaryloxy ayant de 5 à 60 atomes de cycle aromatique, pouvant être substitué par un ou plusieurs radicaux R¹, ou un groupement aralkyle ou hétéroaralkyle ayant de 5 à 60 atomes de cycle aromatique, pouvant être substitué par un ou plusieurs radicaux R¹, ou un groupement diarylamino, un groupement dihétéroarylamino ou un groupement arylhétéroarylamino ayant de 10 à 40 atomes de cycle aromatique, pouvant être substitué par un ou plusieurs radicaux R¹ ; où ici aussi les radicaux R et R¹ peuvent adopter les mêmes significations que les radicaux R et R¹ dans la formule (la),
les lignes en pointillés représentent des liaisons à des motifs structuraux adjacents dans le polymère et
les indices utilisés revêtent la signification suivante :
k = 0 ou 1 ;
m = 0, 1, 2, 3 ou 4 ;
n = 0, 1, 2 ou 3 ;
o = 0, 1 ou 2 ; et
q = 0, 1, 2, 3, 4, 5 ou 6.

11. Composition selon l'une ou plusieurs parmi les revendications 8 à 10, **caractérisée en ce que** le groupement réticulable Q est choisi parmi :
- des groupements alcényle terminaux ou cycliques ou des groupements diényle et alcynyle terminaux,
- des groupements alcényloxy, diényloxy ou alcynyloxy,
- des groupements acide acrylique,
- des groupements oxétane et oxirane,
- des groupements silane, et
- des groupements cyclobutane.

12. Composition selon la revendication 11, **caractérisée en ce que** le groupement réticulable Q est choisi parmi :
| | |
|---|---|
| 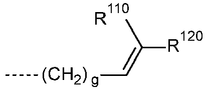 | 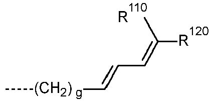 |
| Q1 | Q2 |
| 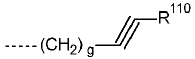 | 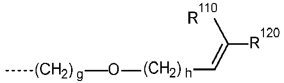 |
| Q3 | Q4 |
| 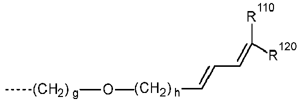 | 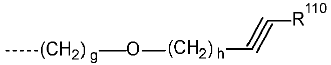 |
| Q5 | Q6 |
| 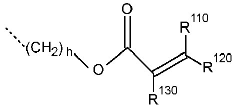 | 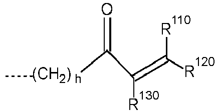 |
| Q7 | Q8 |
| 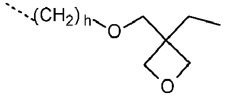 | 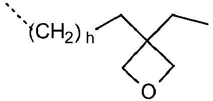 |
| Q9 | Q10 |
| 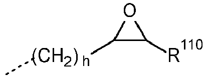 | 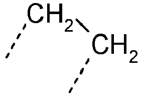 |
| Q11 | Q12 |
| 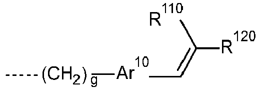 | 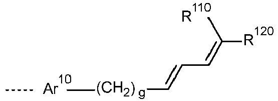 |
| Q13 | Q14 |
| 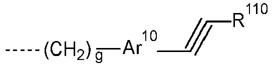 | 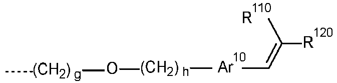 |
| Q15 | Q16 |
| 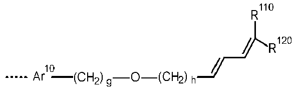 | 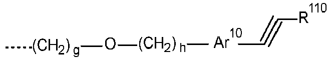 |
| Q17 | Q18 |
| 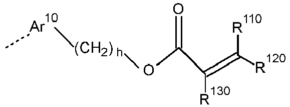 | 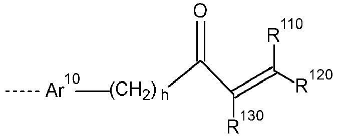 |
| Q19 | Q20 |
| 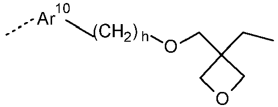 | 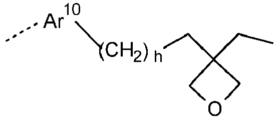 |
| Q21 | Q22 |
| 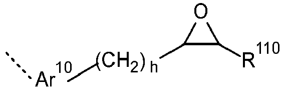 | 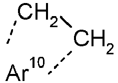 |
| Q23 | Q24 |
dans lequel
les radicaux R¹¹⁰, R¹²⁰ et R¹³⁰ dans les formules Q1 à Q8, Q11, Q13 à Q20 et Q23 sont à chaque occurrence, de manière identique ou différente, H ou un groupement alkyle à chaîne linéaire ou ramifiée ayant de 1 à 6 atomes de C ;
les indices utilisés revêtent la signification suivante :
Ar¹⁰ dans les formules Q13 à Q24 est un noyau mono- ou polycyclique, aromatique ou hétéroaromatique, pouvant être substitué par un ou plusieurs radicaux R, où R peut adopter les significations indiquées selon la revendication 1 ;
g = 0 à 8 ;
h = 1 à 8 ; et
la liaison en pointillés dans les formules Q1 à Q11 et Q13 à Q23 et les liaisons en pointillés dans les formules Q12 et Q24 représentent la liaison du groupement réticulable à l'un parmi les noyaux mono- ou
polycycliques, aromatiques ou hétéroaromatiques Ar¹ à Ar⁹.

13. Composition selon l'une ou plusieurs parmi les revendications 1 à 12, **caractérisée en ce que** la proportion de motifs structuraux de formules (Ia), (Ib), (II), (III), (IV), (V), (VI), (VII), (VIIIa), (VIIIb), (IX), (X), (XI), (XII), (XIII), (XIV), (XV) et/ou (XVI) dans le polymère se trouve dans la plage allant de 1 à 100% molaire, préférablement dans la plage allant de 25 à 100% molaire, particulièrement préférablement dans la plage allant de 50 à 95% molaire, sur la base de 100% molaire de tous les monomères copolymérisés présents comme motifs structuraux dans le polymère.

14. Composition selon l'une ou plusieurs parmi les revendications 1 à 13, **caractérisée en ce que**, outre les motifs structuraux de formules (la), (Ib), (II), (III), (IV), (V), (VI), (VII), (VIIIa), (VIIIb), (IX), (X), (XI), (XII), (XIII), (XIV), (XV) et/ou (XVI), le polymère contient au moins un autre motif structural de formule (XIX) suivante qui est différent des motifs structuraux de formules (Ia), (Ib), (II), (III), (IV), (V), (VI), (VII), (VIIIa), (VIIIb), (IX), (X), (XI), (XII), (XIII), (XIV), (XV) et/ou (XVI) :
----- Ar¹¹----- (XIX)
dans lesquelles Ar¹¹ est un noyau mono- ou polycyclique, aromatique ou hétéroaromatique, pouvant être substitué par un ou plusieurs radicaux R, où R peut adopter les significations indiquées selon la revendication 1.

15. Composition selon l'une ou plusieurs parmi les revendications 1 à 14, **caractérisée en ce que** les radicaux R¹², R²², R²³, R³², R³³ et R³⁴ dans les formules (K1), (K2) et/ou (K3) dans chaque cas, de manière identique ou différente à chaque occurrence, indépendamment les uns des autres, désignent un noyau mono- ou polycyclique, aromatique ou hétéroaromatique ayant de 5 à 60 atomes de cycle aromatique, pouvant être substitué par un radical R, où R peut adopter les significations indiquées selon la revendication 1.

16. Composition selon l'une ou plusieurs parmi les revendications 1 à 15, **caractérisée en ce que**, dans les formules (K1), (K2) et/ou (K3), les radicaux R¹¹, R²¹ et/ou R³¹ représentent un groupement alkyle, alcoxy ou thioalcoxy à chaîne linéaire ayant de 1 à 40 atomes de C ou un groupement alcényle ou alcynyle ayant de 2 à 40 atomes de C ou un groupement alkyle, alcoxy ou thioalcoxy ramifié ou cyclique ayant de 3 à 40 atomes de C, pouvant dans chaque cas être substitué par un ou plusieurs radicaux R¹, où un ou plusieurs groupements CH₂ non adjacents peuvent être remplacés par R¹C=CR¹, C=C, Si(R¹)₂, C=O, C=S, C=NR¹, P(=O)(R¹), SO, SO₂, NR¹, O, S ou CONR¹ et où un ou plusieurs atomes de H peuvent être remplacés par D, F, Cl, Br, I ou CN, ou un noyau aromatique ou hétéroaromatique ayant de 5 à 60 atomes de cycle aromatique, pouvant dans chaque cas être substitué par un ou plusieurs radicaux R¹, ou un groupement aryloxy ou hétéroaryloxy ayant de 5 à 60 atomes de cycle aromatique, pouvant être substitué par un ou plusieurs radicaux R¹, ou un groupement aralkyle ou hétéroaralkyle ayant de 5 à 60 atomes de cycle aromatique, pouvant être substitué par un ou plusieurs radicaux R¹, ou un groupement diarylamino, un groupement dihétéroarylamino ou un groupement arylhétéroarylamino ayant de 10 à 40 atomes de cycle aromatique, pouvant être substitué par un ou plusieurs radicaux R¹ ; où deux, ou plus, radicaux R peuvent également former un noyau mono- ou polycyclique, aliphatique, aromatique et/ou benzocondensé les uns avec les autres.

17. Composition selon l'une ou plusieurs parmi les revendications 1 à 16, **caractérisée en ce qu'**au moins l'un parmi les radicaux R⁴¹, R⁴², R⁴³ et R⁴⁴ dans la formule (A1) contient au moins un atome d'halogène, préférablement au moins un atome de chlore et/ou de fluor, particulièrement préférablement au moins un atome de fluor, comme substituant.

18. Composition selon l'une ou plusieurs parmi les revendications 1 à 17, **caractérisée en ce que** le radical A¹ dans la formule (K1) est un atome de brome ou un atome d'iode, le radical A² dans la formule (K2) est un atome de sélénium ou un atome de soufre et le radical A³ dans la formule (K3) est un atome d'antimoine, un atome d'arsenic ou un atome de phosphore.

19. Composition selon l'une ou plusieurs parmi les revendications 1 à 18, **caractérisée en ce que** le radical E⁴ dans la formule (A1) est un atome de bore.

20. Solutions ou formulations comprenant au moins une composition selon l'une ou plusieurs parmi les revendications 1 à 19 dans un ou plusieurs solvants.

21. Composants électroniques ou opto-électroniques, préférablement des diodes électroluminescentes organiques (OLED), des cellules électrochimiques organiques émettant de la lumière (OLEC), des transistors organiques à effet de champ (OFET), des circuits intégrés organiques (O-IC), des transistors organiques à couche mince (TFT), des cellules solaires organiques (O-SC), des diodes laser organiques (O-lasers), des éléments ou dispositifs photovoltaïques organiques (OPV) et des photorécepteurs organiques (OPC), particulièrement préférablement des diodes électroluminescentes organiques, ayant une ou plusieurs couches actives, où au moins l'une de ces couches actives comprend une ou plusieurs compositions selon l'une ou plusieurs parmi les revendications 1 à 19.

22. Composants électroniques ou opto-électroniques selon la revendication 21, **caractérisés en ce que** la couche active comprenant une ou plusieurs compositions selon l'une ou plusieurs parmi les revendications 1 à 19 a été réticulée.
